# EUROPEAN PATENT SPECIFICATION

(11) **EP 4 471 776 B1**
(45) Date of publication and mention of the grant of the patent: **22.07.2026**
(21) Application number: 24171952.5
(22) Date of filing: 23.04.2024
(51) Int. Cl.: G11C 8/14, G11C 11/405, H10B 12/00

(54) **MEMORY CELL CIRCUIT, MEMORY CELL ARRAY STRUCTURE AND MANUFACTURING METHOD THEREOF**
SPEICHERZELLENSCHALTUNG, SPEICHERZELLENARRAYSTRUKTUR UND HERSTELLUNGSVERFAHREN DAFÜR
CIRCUIT DE CELLULE DE MÉMOIRE, STRUCTURE DE RÉSEAU DE CELLULES DE MÉMOIRE ET PROCÉDÉ DE FABRICATION ASSOCIÉ

(30) Priority: 30.05.2023 US 202363469552 P; 28.07.2023 US 202363529369 P; 16.04.2024 US 202418636270
(43) Date of publication of application: 04.12.2024
(73) Proprietor: MACRONIX INTERNATIONAL CO., LTD., Hsinchu (TW)
(72) Inventor: WEI-CHEN, Chen, 338 Taoyuan City (TW); HANG-TING, Lue, 302 Zhubei City, Hsinchu County (TW)
(74) Representative: Kurig, Thomas

(56) References cited:
- US-A1- 2007 263 466
- US-A1- 2009 022 001
- US-A1- 2019 067 206
- US-A1- 2019 123 188
- US-A1- 2020 017 839
- US-A1- 2020 185 385
- US-A1- 2020 279 601
- US-A1- 2020 328 223
- US-A1- 2021 407 581
- US-A1- 2023 062 083
- CHEN WEI-CHEN ET AL: "A 3D Stackable DRAM: Capacitor-less Three-Wordline Gate-Controlled Thyristor (GCT) RAM with >40 [mu] A Current Sensing Window, >1010 Endurance, and 3-second Retention at Room Temperature", 2022 INTERNATIONAL ELECTRON DEVICES MEETING (IEDM), IEEE, 3 December 2022 (2022-12-03), XP034280751, DOI: 10.1109/IEDM45625.2022.10019464

## Description

### Background

### Technical Field

The disclosure relates to a memory cell circuit, a memory cell array structure, and a manufacturing method thereof, and in particular relates to a memory cell circuit, a memory cell array structure, and a manufacturing method thereof of a dynamic random access memory.

### Description of Related Art

In a conventional technical field, a dynamic random access memory cell circuit is often implemented by using a one transistor-one capacitor (1T1C) architecture. In such a memory cell circuit structure, when the transistor is turned off and enters the data storage period, the so-called gate induced drain leakage (GIDL) is often generated due to the band-to-band tunneling effect in the overlapping region between the gate and the drain in the transistor. This leakage current causes leakage of the stored charge in the capacitor, resulting in the loss of stored data and reducing the data retention of the memory device.
US 2021/407581 A1 discloses methods, systems, and devices for a memory device with multiplexed digit lines. A memory cell of the memory device includes a storage component and a selection component that includes two transistors. A first transistor is coupled with a word line and a second transistor may be coupled with a select line to selectively couple the memory cell with a digit line. The selection component, in conjunction with a digit line multiplexing component, supports a sense component common to a set of digit lines. The digit line of the set is coupled with the sense component during a read operation, while the remaining digit lines of the set are isolated from the sense component.
US 2019/123188 A1 discloses a 3D semiconductor device including: a first level including a single crystal layer, a plurality of first transistors and at least one metal layer, where the at least one metal layer overlays the single crystal layer and includes interconnects between the first transistors forming control circuits; a second level overlaying the at least one metal layer, the second level including a plurality of second transistors; a third level overlaying the second level, the third level including a plurality of third transistors; and polysilicon pillars, where the second level includes a plurality of first memory cells, the first memory cells each including at least one of the second transistors, where the third level includes a plurality of second memory cells, the second memory cells each including at least one of the third transistors, where at least one of the second memory cells is at least partially atop of the control circuits.
US 2007/263466 A1 discloses a random access semiconductor memory device and the technique of employing a memory cell that is formed including a transistor with a storage node.

### Summary

The present invention is defined in the appended claims. The following disclosure serves a better understanding of the present invention. A memory cell circuit, a memory cell array structure, and a manufacturing method thereof, which may effectively reduce the gate induced drain leakage (GIDL) that may be generated during the data retention period, are provided in the disclosure.

The memory cell circuit of the disclosure includes a first transistor, a second transistor, and a capacitor. The first transistor has a first end electrically coupled to a bit line, and a gate of the first transistor is electrically coupled to a primary word line. The second transistor has a first end electrically coupled to a second end of the first transistor, and a gate of the second transistor is electrically coupled to an auxiliary word line. A first end of the capacitor is electrically coupled to a second end of the second transistor and a second end of the capacitor receives a reference voltage.

The memory cell array structure of the disclosure includes multiple channel pillars, multiple first conductive structures, at least one second conductive structure, and multiple capacitors. The channel pillars are arranged in an array to form multiple channel pillar rows and multiple channel pillar columns. The first conductive structures are respectively electrically coupled to the channel pillar rows or the channel pillar columns, and each of the first conductive structures surrounds a first portion of a channel pillar in each of the channel pillar rows or each of the channel pillar columns. Each of the first conductive structures forms a common gate of multiple first transistors in each of the channel pillar rows or each of the channel pillar columns. The second conductive structures are respectively electrically coupled to the channel pillar rows or the channel pillar columns, and each of the second conductive structure surrounds a second portion of a channel pillar in each of the channel pillar rows or each of the channel pillar columns. Each of the second conductive structures forms a common gate of multiple second transistors in each of the channel pillar rows or each of the channel pillar columns. There is a spacing distance between the first portion and the second portion. The capacitors are respectively electrically coupled to ends of channel pillars adjacent to the at least one second conductive structure.

The manufacturing method of the memory cell array structure of the disclosure includes the following operation. Multiple channels are formed on a wafer, wherein the wafer has multiple silicon layers and multiple silicon germanium layers stacked alternately. A gate region of the wafer is masked, the silicon germanium layers in a source region and a drain region of the wafer are removed, to respectively form multiple source structures and multiple drain structures. The source region and the drain region of the wafer are masked, and the gate region is divided into a first division and a second division. Multiple first conductive structures and at least one second conductive structure are respectively formed in the first division and the second division, wherein each of the first conductive structures is a first common gate of multiple first transistors, and each of the second conductive structure is a second common gate of multiple second transistors.

Based on the above, a second transistor is further disposed between the first transistor and the capacitor through the memory cell circuit of the dynamic random access memory cell of the disclosure. During the data retention period, in the memory cell circuit of the present invention, by applying a higher bias to the second transistor than the first transistor, the possible gate-induced drain leakage current may be effectively reduced, effectively improving data retention.

### BRIEF DESCRIPTION OF THE DRAWINGS

FIG. 1 is a schematic diagram of a memory cell circuit of an embodiment of the disclosure.
FIG. 2 is a schematic diagram of a gate induced drain leakage state of a memory cell circuit of an embodiment of the disclosure.
FIG. 3A and FIG. 3B are structural schematic diagrams of memory cell circuits of embodiments of the disclosure.
FIG. 4A is a three-dimensional diagram of a memory cell array structure of an embodiment of the disclosure.
FIG. 4B is a schematic diagram of an equivalent circuit of the embodiment shown in FIG. 4A.
FIG. 5A is a three-dimensional diagram of a memory cell array structure of another embodiment of the disclosure.
FIG. 5B is an equivalent circuit diagram of the embodiment shown in FIG. 5A.
FIG. 6A is a three-dimensional diagram of a memory cell array structure of another embodiment of the disclosure.
FIG. 6B is an equivalent circuit diagram of the embodiment shown in FIG. 6A.
FIG. 7 is a three-dimensional diagram of a memory cell array structure of another embodiment of the disclosure.
FIG. 8A is a three-dimensional diagram of a memory cell array structure of another embodiment of the disclosure.
FIG. 8B and FIG. 8C respectively are top views of partial structures of different implementations of the memory cell array structure of the embodiment of FIG. 8A.
FIG. 9 is a flowchart of a manufacturing method of a memory cell array of an embodiment of the disclosure.
FIG. 10A to FIG. 10O are schematic diagrams of the process flow of the memory cell array of the embodiment of the disclosure.
FIG. 11A to FIG. 11C are schematic diagrams of the process flow of the circuit structure of the memory cell array of the embodiment of the disclosure.
FIG. 12A to FIG. 12C show the implementation details of the formation method of the capacitor of the memory cell array of the embodiment of the disclosure.
FIG. 13A is a side view of channel pillars in the memory cell array structure of an embodiment of the disclosure.
FIG. 13B is a side view of channel pillars and conductive structures in the memory cell array structure of an embodiment of the disclosure.
FIG. 14A is a three-dimensional diagram of a memory cell array structure of another embodiment of the disclosure.
FIG. 14B is a top view of the memory cell array structure in the embodiment of FIG. 14A.
FIG. 15A is a three-dimensional diagram of a memory cell array structure of another embodiment of the disclosure.
FIG. 15B is a top view of the memory cell array structure in the embodiment of FIG. 15A.
FIG. 16 is a three-dimensional diagram of another implementation of a memory cell array structure of an embodiment of the disclosure.
FIG. 17, FIG. 18, and FIG. 19A respectively are three-dimensional diagrams of other implementations of a memory cell array structure of an embodiment of the disclosure.
FIG. 19B is a top view of the memory cell array structure in the embodiment of FIG. 19A.
FIG. 20 and FIG. 21 respectively are three-dimensional diagrams of a memory cell array structure of another embodiment of the disclosure.
FIG. 22 is a top view of a memory cell array structure of another embodiment of the disclosure.
FIG. 23A to FIG. 23C are top views of implementations of multiple memory cell array structures of the embodiment of the disclosure.
FIG. 24A to FIG. 24C are top views of implementations of multiple memory cell array structures of the embodiment of the disclosure.
FIG. 25 is a schematic diagram of a three-dimensional structure of a memory device of an embodiment of the disclosure.
FIG. 26A is a three-dimensional diagram of a memory cell array structure of another embodiment of the disclosure.
FIG. 26B is a top view of the memory cell array structure of FIG. 26A.
FIG. 27 to FIG. 33, and FIG. 34A respectively are schematic diagrams of a memory cell array structure of multiple embodiments of the disclosure.
FIG. 34B is a top view of the memory cell array structure of FIG. 34A.
FIG. 34C is a view of another implementation of the memory cell array structure of FIG. 34A.
FIG. 35 is a schematic diagram of a memory device of another embodiment of the disclosure.
FIG. 36A to FIG. 36C are top views of a memory cell array structure of multiple embodiments of the disclosure.
FIG. 37, FIG. 38A, and FIG. 38B respectively are top views of a memory device of multiple embodiments of the disclosure.
FIG. 39 is a schematic diagram of the layout structure of a memory device of another embodiment of the disclosure.
FIG. 40A is a three-dimensional diagram of a memory cell array structure of another embodiment of the disclosure.
FIG. 40B is a top view of the memory cell array structure in the embodiment of FIG. 40A of the disclosure.
FIG. 41A is a three-dimensional diagram of a memory cell array structure of another embodiment of the disclosure.
FIG. 41B is a top view of the memory cell array structure in the embodiment of FIG. 41A of the disclosure.
FIG. 42 is a three-dimensional diagram of a memory cell array structure of another embodiment of the disclosure.
FIG. 43 is a cross view of a memory cell array structure of another embodiment of the disclosure.
FIG. 44, FIG. 45, and FIG. 46A respectively are three-dimensional diagrams of a memory cell array structure of multiple embodiments of the disclosure.
FIG. 46B is a top view of the memory cell array structure in the embodiment of FIG. 46A.
FIG. 47 is a top view of a memory cell array structure of another embodiment of the disclosure.
FIG. 48A is a schematic diagram of a memory chip of an embodiment of the disclosure.
FIG. 48B is a partially enlarged schematic diagram of the region Z1 of the memory chip of FIG. 48A.

### DETAILED DESCRIPTION OF DISCLOSED EMBODIMENTS

The term "electrically couple" and variations thereof throughout the specification (including the claims) of this application are used broadly and encompass direct and indirect electrical connection. The term "electrically coupled" includes the joining of two members directly or indirectly to one another through conductive materials (e.g., metal or cupper traces), and also encompasses electrically connected and coupling between two members electrically interact for signal flow via indirect connections, such as capacitive coupling to one another through a dielectric layer and inductive coupling.

For instance, if the disclosure describes a first apparatus being electrically coupled to a second apparatus, then it should be interpreted that the first apparatus can be directly electrically connected to the second apparatus, or the first apparatus can be indirectly electrically connected to the second apparatus through other devices.

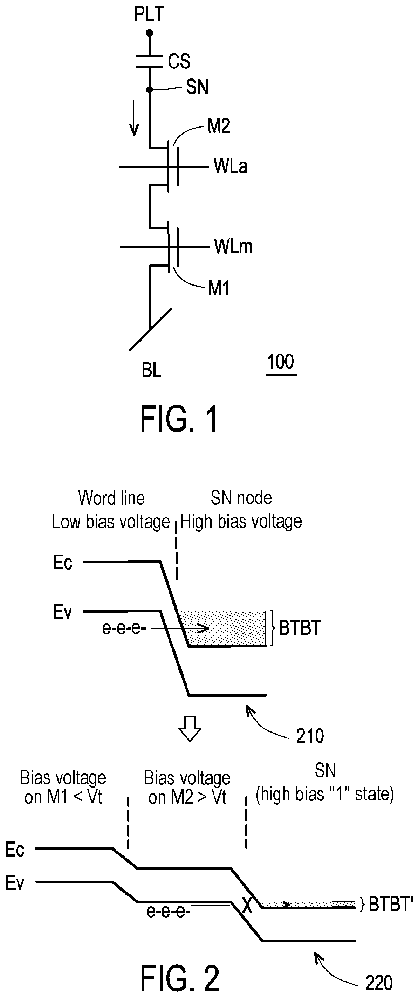

Referring to FIG. 1, FIG. 1 is a schematic diagram of a memory cell circuit of an embodiment of the disclosure. The memory cell circuit 100 includes transistors M1 and M2, and a capacitor CS. The memory cell circuit 100 is a dynamic random access memory cell. The transistor M1 is the primary transistor. The transistor M1 has a first end electrically coupled to the bit line BL. The gate of the transistor M1 is electrically coupled to the primary word line WLm. The transistor M2 serves as an auxiliary transistor. The transistor M2 has a first end electrically coupled to the second end of the transistor M1, and a gate of the transistor M2 is electrically coupled to the auxiliary word line WLa. The second end of the transistor M2 is electrically coupled to the node SN, in which the node SN is electrically coupled to the first end of the capacitor CS, and the second end of the capacitor CS is electrically coupled to the common electrode plate PLT. The common electrode plate PLT may receive a reference voltage.

In this embodiment, the transistor M1 is electrically coupled in series between the transistor M2 and the bit line BL, and the transistor M2 is positioned in electrical series between the transistor M1 and the capacitor CS. Furthermore, the gate of the transistor M1 is located near the bit line BL and is distant from the capacitor CS. The gate of the transistor M2 is situated near the capacitor CS and distant from the bit line BL.

The transistors M1 and M2 may respectively receive a bias voltage through the primary word line WLm and the auxiliary word line WLa. During the normal access operation, the transistors M1 and M2 may be respectively turned on according to the received bias voltage, and the data may be written into the capacitor CS through the bit line BL or the data may be read from the capacitor CS to the bit line BL. During the data retention period, the transistor M1 may be turned off according to a bias voltage (e.g., a negative voltage) received through the word line WLm. The transistor M2 may receive the bias voltage received by the word line WLa (which may be higher than the bias voltage received by the word line WLm, and may be a positive voltage). In this way, the gate induced drain leakage phenomenon that may occur on the node SN during the data retention period may be effectively reduced.

Referring to FIG. 2 at the same time, FIG. 2 is a schematic diagram of a gate induced drain leakage state of a memory cell circuit of an embodiment of the disclosure. In FIG. 2, state 210 represents an energy band state diagram in which no auxiliary transistor is provided in the memory cell circuit. State 220 represents the energy band state diagram of memory cell circuit 100. In state 210, when the word line of the transistor is subjected to a low bias voltage (e.g., a negative voltage), based on the fact that node SN is subjected to a relatively high bias voltage, in the transition process of the gate and node SN in the transistor, a band-to-band tunneling current BTBT is generated between the valence band Ev and the conduction band Ec. The charge in the capacitor may leak out through the band-to-band tunneling current BTBT, generating a leakage current. The band-to-band tunneling current BTBT may be generated when an electrical field stresses between a gate and a silicon subtract of a transistor.

In state 220, the node SN is electrically coupled to transistor M2 that serves as an auxiliary transistor. Under the condition that the main word line of the main transistor (the transistor M1) is subjected to a relatively low bias voltage which may be lower than a threshold voltage Vt, the auxiliary word line of the auxiliary transistor (the transistor M2) is subjected to a relatively high bias voltage which may be larger than the threshold voltage Vt, and the node SN is also subjected to a high bias voltage, in the transition process of the gate and node SN in the auxiliary transistor, the energy overlap between the valence band Ev of M2 and the conduction band Ec of SN can be made shorter. Hence, the available width of the band-to-band tunneling current BTBT generated by this energy overlap may be effectively reduced. In this way, the gate induced drain leakage current may be effectively reduced.

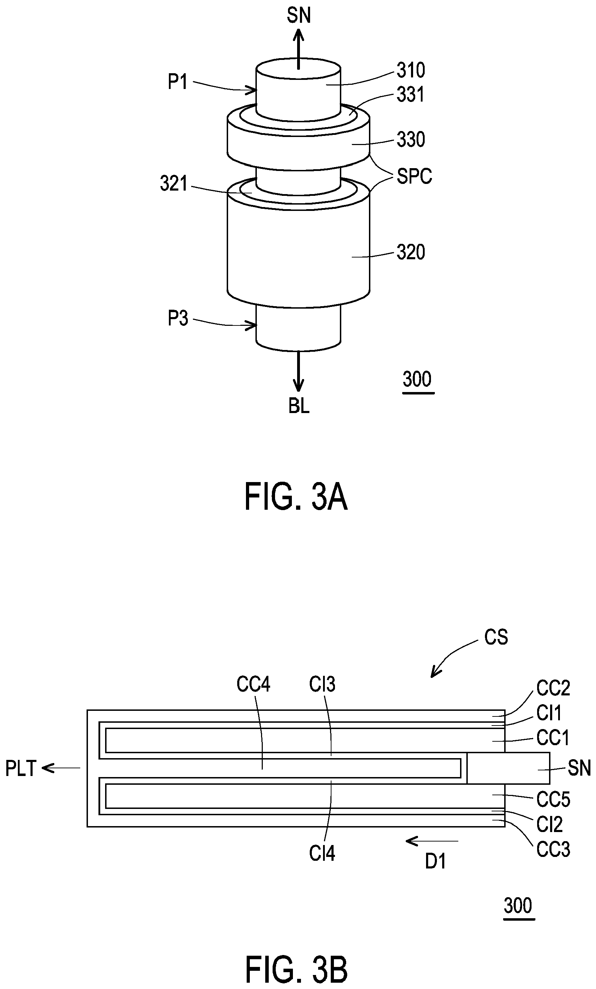

Referring to FIG. 3A and FIG. 3B, FIG. 3A and FIG. 3B are structural schematic diagrams of memory cell circuits of embodiments of the disclosure. FIG. 3A is a three-dimensional diagram of the structure of the first transistor and the second transistor, and FIG. 3B is a cross-sectional diagram of the capacitor. In FIG. 3A, the memory cell circuit structure 300 includes a channel pillar 310 and conductive structures 320 and 330. The conductive structure 320 surrounds a first portion of the channel pillar 310 and forms the gate of the first transistor (primary transistor). A gate oxide layer 321 is sandwiched between the conductive structure 320 and the channel pillar 310. The conductive structure 330 wraps around a second portion of the channel pillar 310 and forms the gate of the second transistor (auxiliary transistor). A gate oxide layer 331 is sandwiched between the conductive structure 330 and the channel pillar 310.

In this embodiment, there is a spacing SPC between the conductive structure 320 and the conductive structure 330. The conductive structure 320 is configured to electrically couple to the primary word line, and the conductive structure 330 is configured to electrically couple to the auxiliary word line. On the other hand, on the channel pillar 310, an end portion (drain) adjacent to the conductive structure 330 may be electrically coupled to the node SN, in which the node SN is also electrically coupled to the capacitor. In addition, on the channel pillar 310, an end portion (source) adjacent to the conductive structure 320 may be electrically coupled to the bit line BL. The phrase "adjacent" is used to describe the two objects are near, next to or closed to each other, but not necessary touching with each other. The two adjacent objects can be physically coupled together, or stay apart from a distance without intervening similar objects. In FIG.3A as example, the end portion (drain) adjacent to the conductive structure 330 and the end portion (source) adjacent to the conductive structure 320, which means that the end portion (drain), compared to the end portion (source), is closer to the conductive structure 310. In here, in the other words, the end portion electrically coupled to the node SN is located near the conductive structure 330 and distant from to the conductive structure 320, and the end portion electrically coupled to the line BL is located near the conductive structure 320 and distant from the conductive structure 330.

In this embodiment, the material of the channel pillar 310 may be silicon, GaAs, SiC or other suitable semiconductor materials for establishing channel, and the conductive structures 320 and 330 may be any conductive structures in the semiconductor manufacturing process, and there is no specific limitation.

The conductive structures 320 and 330 may regionally divide the channel pillar 310 into two regions P1 and P3. The region P1, the conductive structure 330 may form a gate of the transistor M2 as shown in FIG. 1. The conductive structure 320 may form a gate of the transistor M1 as shown in FIG. 1. In this embodiment, each of the regions P1 and P3 may be doped as drain or source. The regions P1 and P3 may have same conductive type. In this embodiment, the gate-controlled channel can be undoped, or be doped with an opposite type of dopants to the pillar ends for threshold voltage adjustment.

In other embodiments, the entirety of the channel pillar 310 may be a uniformly doped region, which can be either N-type or P-type. Such a configuration is commonly referred to as a junction-less device. For example, in this embodiment, during a manufacturing process, the channel pillar 310 can be obtained by performing an etching operation on an epitaxy-grown Si and bulk Si wafer, wherein the epitaxy-grown Si or the bulk Si wafer may have N conductive type or P conductive type. Hence, the entire channel pillar 310 may be a uniformly doped region with N-type or P-type.

It should be noted here, any method to dope two end portions or the entirety of the channel pillar 310 may be used in present disclosure, and there is no special limitation here.

In FIG. 3B, the memory cell circuit structure 300 further includes a columnar capacitor CS. The capacitor CS includes multiple conductive films CC1 to CC5 and multiple dielectric layers CI1 to CI4. The conductive films CC1 and CC5 are in contact with the node SN to form a first electrode of the capacitor CS and extend toward the direction D1. The conductive film CC4 is disposed between conductive films CC1 and CC5. The conductive films CC2 and CC3 are respectively disposed on the outer side of the conductive films CC1 and CC5. The conductive films CC2, CC4 and CC3 are electrically coupled to each other at end portions far away from the node SN, and are electrically coupled to the common electrode plate PLT to form a second electrode of the capacitor CS.

In addition, a dielectric layer CI1 is formed between the conductive films CC2 and CC1; the dielectric layer CI2 is formed between the conductive films CC3 and CC5; the dielectric layer CI3 is formed between the conductive films CC4 and CC1; the dielectric layer CI4 is formed between the conductive films CC4 and CC5. In this embodiment, the conductive films CC1 and CC5 are internal conductive films, and the conductive films CC2, CC3 and CC4 are external conductive films. In here, the conductive films CC2, CC1, CC4, CC5 and CC3 are disposed in interleaved.

In this embodiment, the cross-section of the capacitive column forming the capacitor CS may be circular, rectangular, or polygonal, without specific limitation.

FIG. 3A and FIG. 3B illustrate a dual gate DRAM cell, comprising a semiconductor pillar electrically in series between a bit line terminal configured for connection to a bit line and a capacitor. A first gate surrounds the pillar proximal to the capacitor and a second gate surrounds the pillar proximal to the bit line terminal. A gate dielectric is disposed between the first gate and the pillar, and a gate dielectric is disposed between the second gate and the pillar. The pillar can be arranged in one example vertically (orthogonally relative to a substrate) and in another example, horizontally (parallel to a substrate). The first gate can be integral with, or otherwise electrically coupled to, a first word line conductor, and the second gate can be integral with, or otherwise electrically coupled to, a second word line conductor. An integrated circuit including the dual gate DRAM cell includes word line biasing circuits configured to apply a first gate bias to the first word line and a second gate bias to the second word line. The first and second gate bias are set voltage levels as described herein that inhibit current leakage from the capacitor when cell is not selected for access in operation of the memory. In one biasing arrangement to de-select the cell, the first gate bias is set at a level higher than the second gate bias. Generally, the first gate bias is set to inhibit current leakage due to band-to-band tunneling in the pillar when the second gate bias is set to turn off current in the pillar in order to de-select the cell.

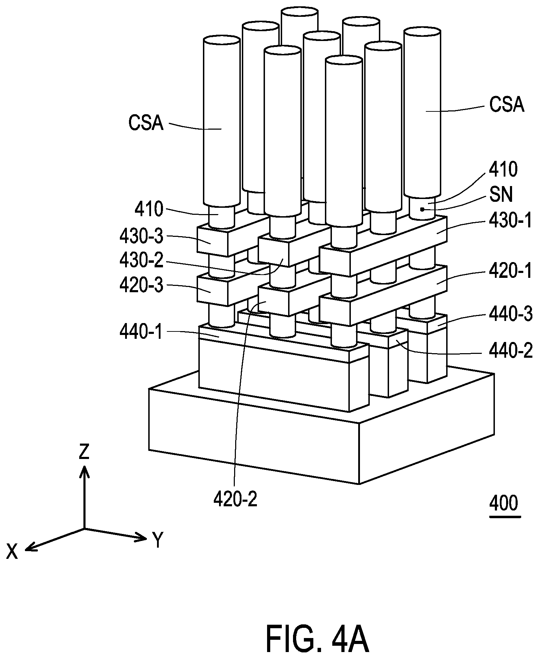

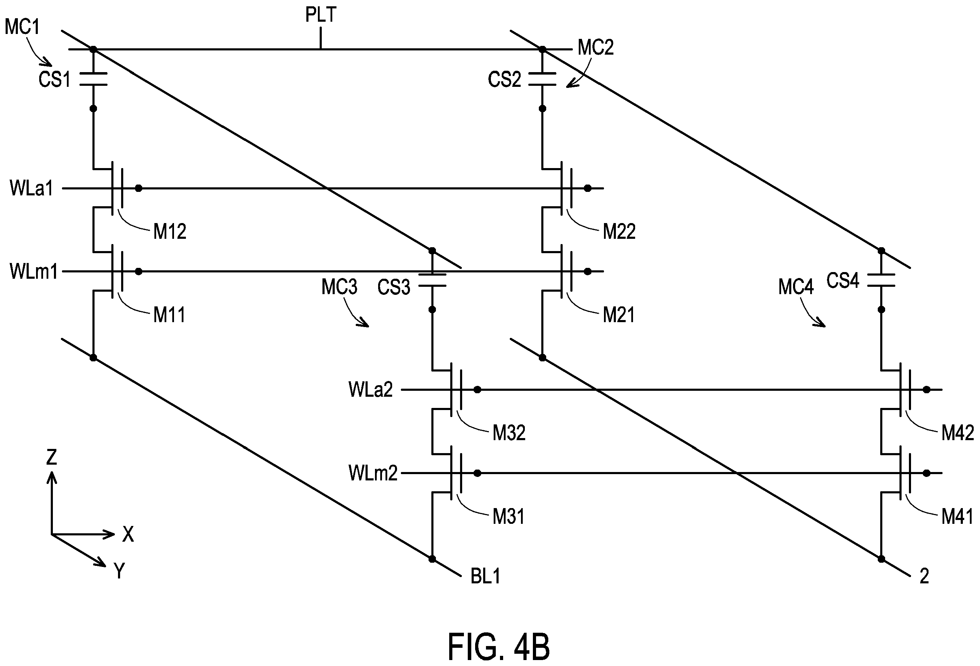

Referring to FIG. 4A and FIG. 4B, FIG. 4A is a three-dimensional diagram of a memory cell array structure of an embodiment of the disclosure. FIG. 4B is a schematic diagram of an equivalent circuit of the embodiment shown in FIG. 4A. The memory cell array structure 400 includes multiple channel pillars 410, multiple first conductive structures 420-1 to 420-3, multiple second conductive structures 430-1 to 430-3, multiple third conductive structures 440-1 to 440-3, and multiple capacitors CSA. The channel pillars 410 are arranged in an array. Each of the channel pillars 410 extends along the Z-axis direction. This embodiment takes a 3 by 3 array as an example. The channel pillars 410 may form 3 channel pillar columns and 3 channel pillar rows. Here, the X-axis direction is the row direction, and the Y-axis direction is the column direction as an example. The first conductive structures 420-1 to 420-3 respectively surround the first portion of each of the channel pillars 410 of three channel pillar rows. The first conductive structures 420-1 to 420-3 are configured to form common gates of multiple first transistors (primary transistors) in the corresponding channel pillar rows. The second conductive structures 430-1 to 430-3 respectively surround the second portion of each of the channel pillars 410 of the channel pillar rows, and form common gates of multiple second transistors (auxiliary transistors) in corresponding channel pillar rows. Corresponding to the same channel pillar 410, the first conductive structures 420-1 to 420-3 respectively are vertically arranged with the second conductive structures 430-1 to 430-3 along the Z-axis direction. The second conductive structures 430-1 to 430-3 may be respectively disposed above the first conductive structures 420-1 to 420-3.

The first conductive structures 420-1 to 420-3 may be respectively electrically coupled to multiple primary word lines, and the second conductive structures 430-1 to 430-3 may be respectively electrically coupled to multiple auxiliary word lines. In this embodiment, the first conductive structures 420-1 to 420-3 and the second conductive structures 430-1 to 430-3 all extend along the same direction (X-axis direction).

In addition, multiple capacitors CSA are respectively disposed above the channel pillars 410, in which each capacitor CSA and each channel pillar 410 are electrically coupled to the node SN. Top end portions of the capacitors CSA may be commonly electrically coupled to a common electrode plate (not shown). Wherein, the capacitor CSA may be a columnar structure.

In this embodiment, each of the third conductive structures 440-1 to 440-3 extends along the Y-axis direction, and is respectively electrically coupled to multiple channel pillar columns formed by the channel pillars 410. The third conductive structures 440-1 to 440-3 are configured to respectively electrically couple to multiple bit lines. The extension directions of the third conductive structures 440-1 to 440-3 are different from the extension directions of the first conductive structures 420-1 to 420-3, for example, they are orthogonal to each other, or there is an angle between each other and the angle is not limited to 90 degrees.

In FIG. 4B, taking a 2 by 2 array as an example, the memory cell array structure may include memory cell circuits MC1 to MC4. The memory cell circuits MC1 and MC2 are arranged on the same first row; the memory cell circuits MC3 and MC4 are arranged on the same second row; the memory cell circuits MC1 and MC3 are arranged on the same first column; the memory cell circuits MC2 and MC4 are arranged on the same second column. The memory cell circuit MC1 includes the transistors M11 and M12, and the capacitor CS1; the memory cell circuit MC2 includes the transistors M21 and M22, and the capacitor CS2; the memory cell circuit MC3 includes the transistors M31 and M32, and the capacitor CS3; the memory cell circuit MC4 includes the transistors M41 and M42, and the capacitor CS4.

Taking the memory cell circuit MC1 as an example, the capacitor CS1, and the transistors M12 and M11 are sequentially arranged between the common electrode plate PLT and the bit line BL1. A gate of the transistor M11 (primary transistor) is electrically coupled to the main word line WLm1, and a gate of the transistor M12 (auxiliary transistor) is electrically coupled to the auxiliary word line WLal.

Incidentally, since the auxiliary word lines WLal and WLa2, and the primary word lines WLm1 and WLm2 all extend along the X-axis direction, the adjacently arranged primary transistors M11 and M21 may be electrically coupled to the same primary word line WLm1; the adjacently arranged auxiliary transistors M12 and M22 may be electrically coupled to the same auxiliary word line WLal; the adjacently arranged primary transistors M31 and M41 may be electrically coupled to the same primary word line WLm2; the adjacently arranged auxiliary transistors M32 and M42 may be electrically coupled to the same auxiliary word line WLa2. Since the bit lines BL1 and BL2 extend along the Y-axis direction, the memory cell circuits MC1 and MC3 are electrically coupled to the same bit line BL1, and the memory cell circuits MC2 and MC4 are electrically coupled to the same bit line BL2.

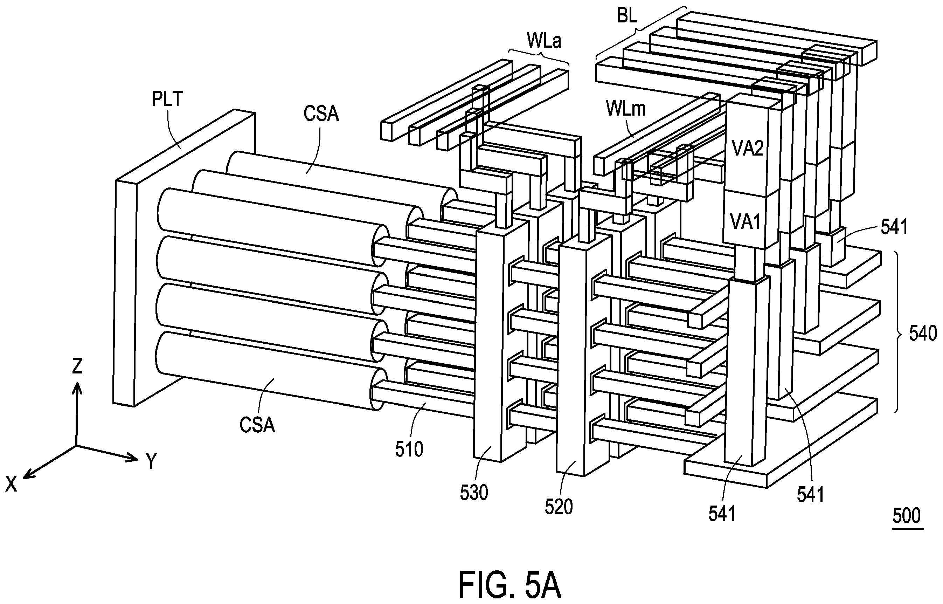

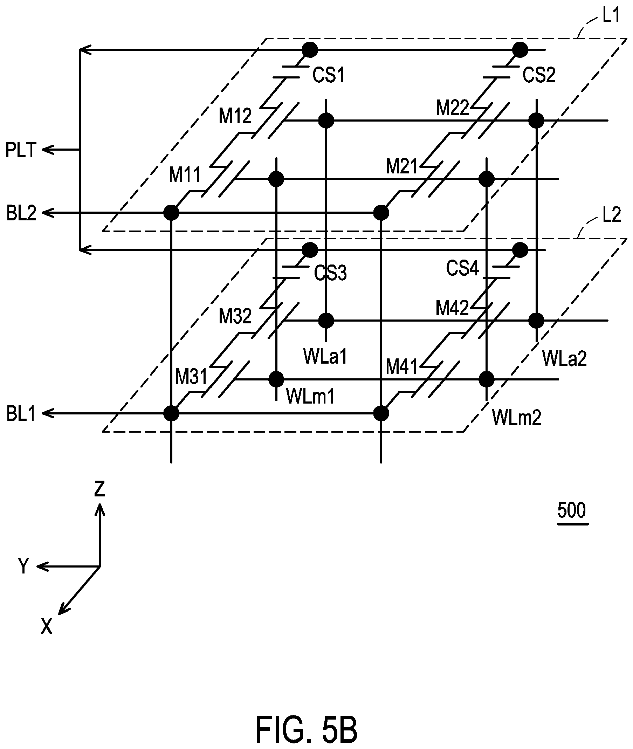

Referring to FIG. 5A and FIG. 5B, FIG. 5A is a three-dimensional diagram of a memory cell array structure of another embodiment of the disclosure. FIG. 5B is an equivalent circuit diagram of the embodiment shown in FIG. 5A. The memory cell array structure 500 includes multiple channel pillars 510, multiple first conductive structures 520, multiple second conductive structures 530, multiple third conductive structures 540, and multiple capacitors CSA. In this embodiment, the channel pillars 510 extend along the Y-axis direction, and for example, form a 3 by 4 array. Taking the X-axis direction as the row direction and the Z-axis direction as the column direction as an example, the memory cell array structure 500 may have 3 channel pillar columns and 4 channel pillar rows. Each of the first conductive structures 520 may surround the same first portion of the channel pillars 510 of the channel pillar columns. Each of the second conductive structures 530 may surround the same second portion of the channel pillars 510 of the channel pillar columns. Each first conductive structure 520 may form a common gate of multiple primary transistors of the surrounded channel pillars 510. Each second conductive structure 530 may form a common gate of multiple auxiliary transistors of the surrounded channel pillars 510. The first conductive structures 520 may be respectively electrically coupled to the primary word lines WLm. Alternatively, in other embodiments of the disclosure, the first conductive structures 520 may be commonly electrically coupled to the same primary word line. In addition, the second conductive structures 530 may be respectively electrically coupled to the auxiliary word lines WLa, or in other embodiments of the disclosure, the second conductive structures 530 may be commonly electrically coupled to the same auxiliary word line. In this embodiment, each of the first conductive structures 520 extends along the Z-axis, and separate from each other along the X-axis. Similarly, each of the second conductive structures 530 extends along the Z-axis, and separate from each other along the X-axis.

In addition, in the channel pillar 510, the end portions adjacent to the first conductive structure 520 may be respectively electrically coupled to the third conductive structure 540. In this embodiment, the third conductive structure 540 may extend along the X-axis direction. Through multiple conductive plugs 541 extending along the Z-axis, the third conductive structure 540 may be respectively electrically coupled to the bit lines BL through the conductive vias VA1 and VA2 along the Z-axis direction. It should be noted that in this embodiment, the third conductive structure 540 may form a stepped structure, or called staircase.

In this embodiment, the primary word line WLm and the auxiliary word line WLa may be disposed in the first metal layer with the same height, and the bit line BL may be disposed in another second metal layer. The height of the second metal layer may be higher than the height of the first metal layer.

Multiple capacitors CSA may be formed in the channel pillar 510 adjacent to the end portion of the second conductive structure 530. The other end portion of the capacitor CSA may be commonly electrically coupled to the common electrode plate PLT.

In FIG. 5B, taking a 2 by 2 memory cell array as an example, the memory cell array structure 500 may be divided into a first layer structure L1 and a second layer structure L2. The first layer structure L1 may have a first memory cell circuit formed of the transistors M11 and M12 and the capacitor CS1, and a second memory cell circuit formed of the transistors M21 and M22 and the capacitor CS2. The second layer structure L2 may have a third memory cell circuit formed of the transistors M31 and M32 and the capacitor CS3, and a fourth memory cell circuit formed of the transistors M41 and M42 and the capacitor CS4.

In FIG. 5B, in the first layer structure L1, the transistors M11 and M12 and the capacitor CS1 are disposed along the Y-axis direction to form a memory cell circuit. The transistors M21 and M22 and the capacitor CS2 are also disposed along the Y-axis direction to form another memory cell circuit. The bit line BL2 is electrically coupled with the transistors M11 and M21 along the Y-axis direction. Moreover, the primary word lines WLm1 and WLm2 are respectively electrically coupled to the conductors disposed along the Z-axis and are respectively electrically coupled to the gates of the transistors M11 and M21, in which the transistors M11 and M21 serve as the primary transistors. The auxiliary word lines WLal and WLa2 are respectively electrically coupled to the conductors disposed along the Z-axis and are respectively electrically coupled to the gates of the transistors M12 and M22, in which the transistors M12 and M22 serve as the auxiliary transistors.

In the second layer structure L2, the transistors M31 and M32 and the capacitor CS3 are disposed along the X-axis direction to form a memory cell circuit. The transistors M41 and M42 and the capacitor CS4 are also disposed along the X-axis direction to form another memory cell circuit. The bit line BL1 is electrically coupled with the transistors M31 and M41 along the Y-axis direction. Moreover, the primary word lines WLm1 and WLm2 are respectively electrically coupled to the gates of the transistors M31 and M41, in which the transistors M31 and M41 serve as the primary transistors. The auxiliary word lines WLa1 and WLa2 are respectively electrically coupled to the gates of the transistors M32 and M42, in which the transistors M32 and M42 serve as the auxiliary transistors.

Incidentally, the capacitors CS1 to CS4 are also commonly electrically coupled to the common electrode plate PLT. The common electrode plate PLT may span across the first layer structure L1 and the second layer structure L2.

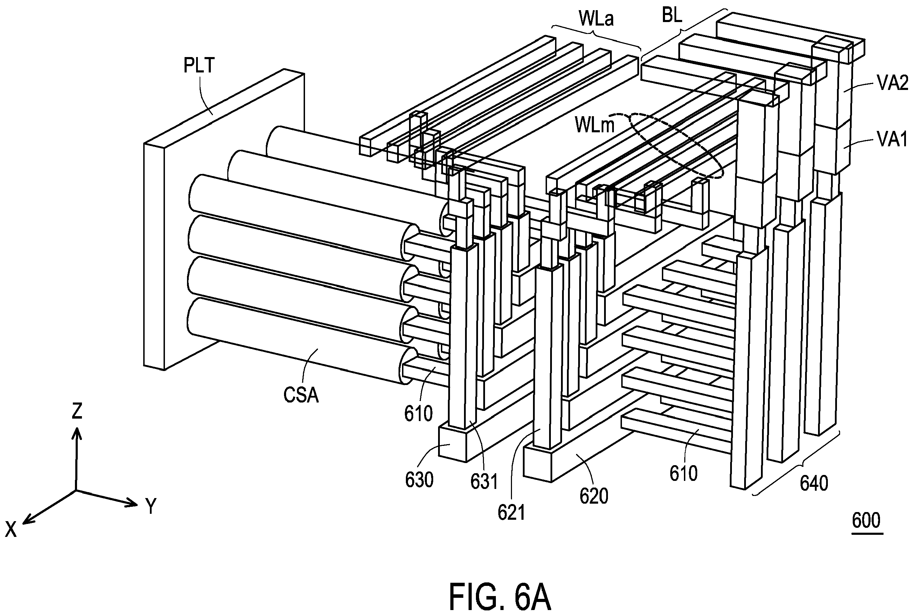

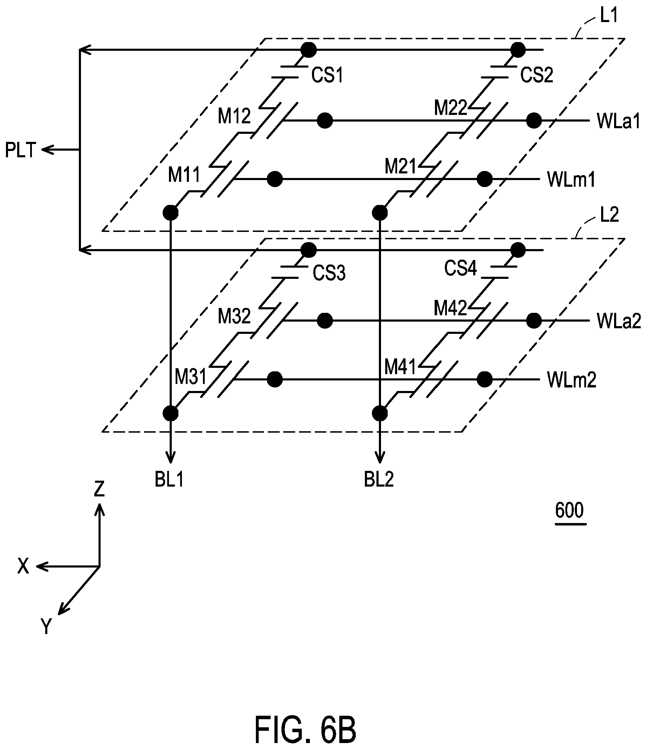

Referring to FIG. 6A and FIG. 6B, FIG. 6A is a three-dimensional diagram of a memory cell array structure of another embodiment of the disclosure. FIG. 6B is an equivalent circuit diagram of the embodiment shown in FIG. 6A. The memory cell array structure 600 includes multiple channel pillars 610, multiple first conductive structures 620, multiple second conductive structures 630, multiple third conductive structures 640, and multiple capacitors CSA. In this embodiment, the channel pillars 610 extend along the Y-axis direction, and for example, form a 3 by 4 array. Here, the X-axis direction is also the row direction, and the Z-axis direction is the column direction as an example.

The memory cell array structure 600 in FIG. 6A has a similar structure to the memory cell array structure 500 in FIG. 5A. Unlike the memory cell array structure 500, in the memory cell array structure 600, each first conductive structure 620 and each second conductive structure 630 extend along the X-axis direction. Multiple first conductive structures 620 are disposed up and down along the Z-axis direction, and respectively surround a first portion of the channel pillar rows; multiple second conductive structures 630 are also disposed up and down along the Z-axis direction, and respectively surround a second portion of the channel pillar rows. Each third conductive structure 640 extends along the Z-axis direction, and is respectively electrically coupled to an end portion of each corresponding channel pillar column which is adjacent to the first conductive structure 620. The third conductive structures 640 are separately arranged along the X-axis direction.

It is noted here that in the embodiment of the disclosure, the first conductive structure 620 forms a stepped structure, or called staircase, and the second conductive structure 630 forms another stepped structure, or called staircase. The first conductive structures 620 are respectively electrically coupled to multiple conductive plugs 621 through the stepped surface, and are respectively electrically coupled to multiple primary word lines WLm through the conductive plugs 621 and multiple conductive vias. The second conductive structures 630 are respectively electrically coupled to multiple conductive plugs 631 through the stepped surface, and are respectively electrically coupled to multiple auxiliary word lines WLa through the conductive plugs 631 and multiple conductive vias.

In addition, each third conductive structure 640 is electrically coupled to each bit line BL along the Z-axis direction through the conductive vias VA1 and VA2. The bit lines BL may be disposed in parallel along the X-axis direction, and each bit line BL may extend along the Y-axis direction. The third conductive structure 640 may be a bit line conductive plug. Each of the third conductive structures 640 may have substantially the same size, which may provide uniform bit line capacitance and improve the performance of the data sensing operation. The third conductive structures 640 are separately arranged along the X-axis direction and electrically coupled to the corresponding conductive vias VA1 and VA2. The bit lines BL are disposed at the second metal layer and higher than the primary word lines WLm and the auxiliary word lines WLa, which are disposed at the first metal layer. In the other embodiments, the bit lines BL can be disposed at the first metal layer, and the primary word lines WLm and the auxiliary word lines WLa are disposed at the second metal layer which is higher than the first metal layer.

In FIG. 6B, also taking a 2 by 2 memory cell array as an example, the memory cell array structure 600 may be divided into a first layer structure L1 and a second layer structure L2. The first layer structure L1 may have a first memory cell circuit formed of the transistors M11 and M12 and the capacitor CS1, and a second memory cell circuit formed of the transistors M21 and M22 and the capacitor CS2. The second layer structure L2 may have a third memory cell circuit formed of the transistors M31 and M32 and the capacitor CS3, and a fourth memory cell circuit formed of the transistors M41 and M42 and the capacitor CS4.

The equivalent circuit of the memory cell array structure 600 is substantially the same as the equivalent circuit of the memory cell array structure 500. The difference is that, in the memory cell array structure 600, the conductors electrically coupled to the bit lines BL1 and BL2 are extending along the Z-axis direction. The bit line BL1 is electrically coupled to the transistors M11 and M31, and the bit line BL2 is electrically coupled to the transistors M21 and M41. In addition, the gates of the transistors M11 and M21 are commonly electrically coupled to the primary word line WLm1 extending along the X-axis direction; the gates of the transistors M12 and M22 are commonly electrically coupled to the auxiliary word line WLa1 extending along the X-axis direction; the gates of the transistors M31 and M41 are commonly electrically coupled to the primary word line WLm2 extending along the X-axis direction; the gates of the transistors M32 and M42 are commonly electrically coupled to the auxiliary word line WLa2 extending along the X-axis direction.

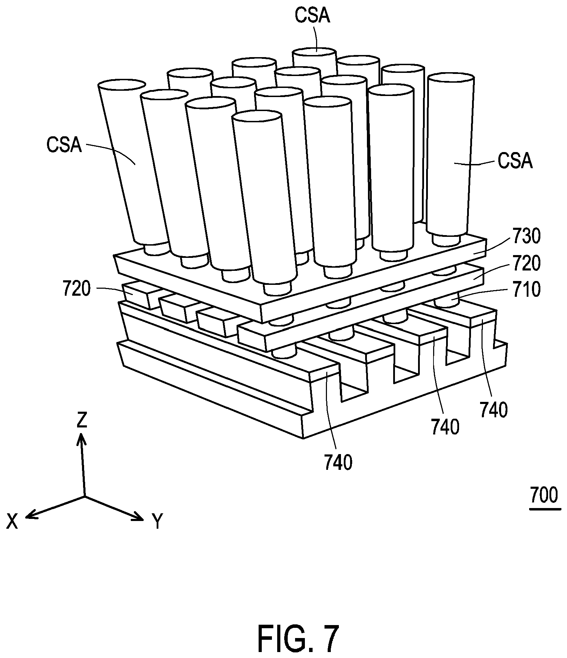

Referring to FIG. 7, FIG. 7 is a three-dimensional diagram of a memory cell array structure of another embodiment of the disclosure. The memory cell array structure 700 includes multiple channel pillars 710, multiple first conductive structures 720, one second conductive structure 730, multiple third conductive structures 740, and multiple capacitors CSA. In this embodiment, the channel pillars 710 extend along the Y-axis direction, and for example, form a 4 by 4 array. Taking the X-axis direction as the row direction and the Y-axis direction as the column direction as an example, the memory cell array structure 700 may have 4 channel pillar columns and 4 channel pillar rows. The number of the first conductive structures 720 may be four, and they respectively surround the first portion of the four channel pillars 710 of each of the channel pillar rows. Each of the first conductive structures 720 extends along the X-axis direction. It is worth mentioning that in this embodiment, there is only one second conductive structure 730, which is electrically coupled to and surrounds the second portion of all the channel pillars 710.

The first conductive structures 720 are respectively electrically coupled to multiple primary word lines.

In the embodiment of the disclosure, by using a second conductive structure 730 to electrically couple all the channel pillars 710, the gates of the auxiliary transistors in all the memory cell circuits may be commonly electrically coupled to the same auxiliary word line. The complexity of circuit layout of the memory cell array structure 700 may be effectively reduced. In this embodiment, the size of the second conductive structure 730 is larger than each of the first conductive structures 720. The number of the channel pillars 710 surrounded by the second conductive structure 730 is more than the number of the channel pillars 710 surrounded by each of the first conductive structure 720. In other embodiments, the second conductive structure 730 can be divided into smaller segments, and each segment of the second conductive structure 730 can surround the different groups of the channel pillars 710. But the number of the channel pillars 710 surrounded by each segment of second conductive structure 730 is still more than the number of the channel pillars 710 surrounded by each of the first conductive structure 720.

Incidentally, the third conductive structures 740 are respectively electrically coupled to end portions of multiple channel pillar columns adjacent to the first conductive structures 720. Each of the third conductive structures 740 may extend along the Y-axis direction.

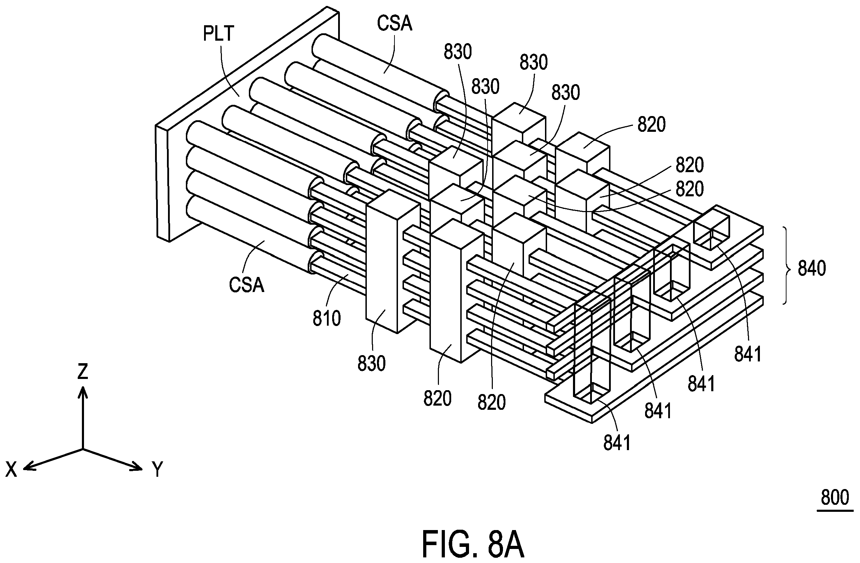

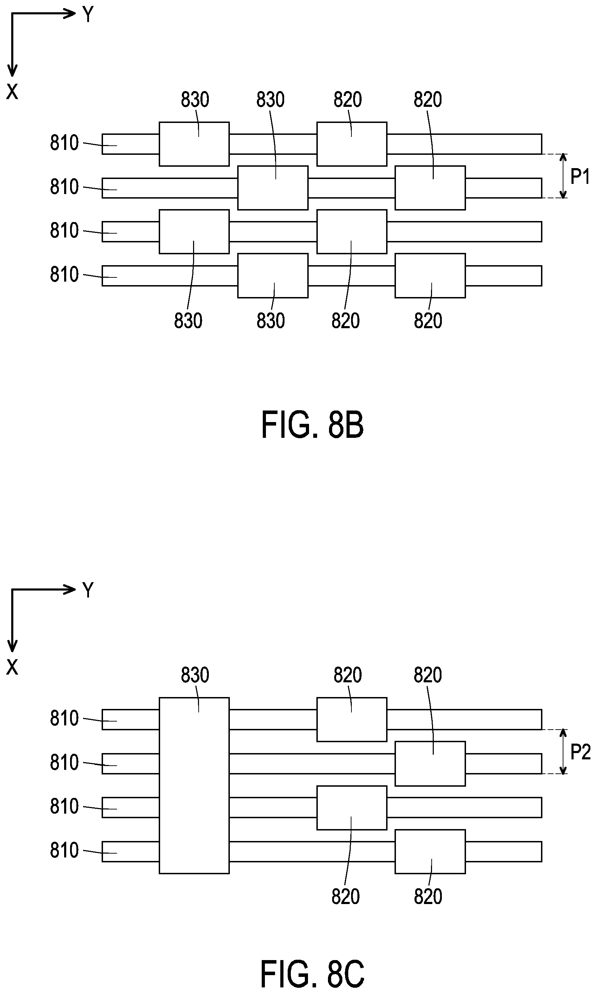

Referring to FIG. 8A to FIG. 8C, FIG. 8A is a three-dimensional diagram of a memory cell array structure of another embodiment of the disclosure. FIG. 8B and FIG. 8C respectively are top views of partial structures of different implementations of the memory cell array structure of the embodiment of FIG. 8A. In FIG. 8A, the memory cell array structure 800 includes multiple channel pillars 810, multiple first conductive structures 820, multiple second conductive structures 830, multiple third conductive structures 840, and multiple capacitors CSA. In this embodiment, the channel pillars 810 extend along the Y-axis direction, and for example, form a 5 by 4 array. The channel pillars 810 are respectively electrically coupled to multiple capacitors CSA, in which each capacitor CSA extends in the same direction as each channel pillar 810. The capacitors CSA are also commonly electrically coupled to the common electrode plate PLT. The third conductive structures 840 are electrically coupled to bit lines through multiple conductive plugs 841.

Here, the X-axis direction is the row direction, and the Z-axis direction is the column direction as an example. The channel pillars 810 of this embodiment may form 5 channel pillar columns and 4 channel pillar rows. Five first conductive structures 820 are respectively electrically coupled to and surround a first portion of five channel pillar columns, and five second conductive structures 830 are respectively electrically coupled to and surround a second portion of five channel pillar columns. It should be noted that in this embodiment, the disposed positions of two adjacent first conductive structures 820 are staggered from each other, and the disposed positions of two adjacent second conductive structures 830 are also staggered from each other, as shown in FIG. 8B. In FIG. 8B, from a top view angle, on a reference plane (X-Y plane), by staggering the disposed positions of two adjacent first conductive structures 820 and by staggering the disposed positions of two adjacent second conductive structures 830, the spacing distance P1 between adjacent two channel pillars 810 may be effectively reduced, and the circuit layout density may be increased. In other words, the first conductive structures 820 are divided in two groups, the first conductive structures 820 in the first group are separately arranged along the X-axis direction, and the first conductive structures 820 in the second group are also separately arranged along the X-axis direction, but further have an offset along the Y-axis direction from the first conductive structures 820 in the first group. The second conductive structures 830 are arranged in similar manner with the first conductive structures 820.

In FIG. 8C, the number of the second conductive structure 830 may be one, which surrounds all the channel pillars 810 at the same time to form a common gate of multiple auxiliary transistors. In this embodiment, a spacing distance P2 between adjacent two channel pillars 810 may also be effectively reduced to increase the circuit layout density.

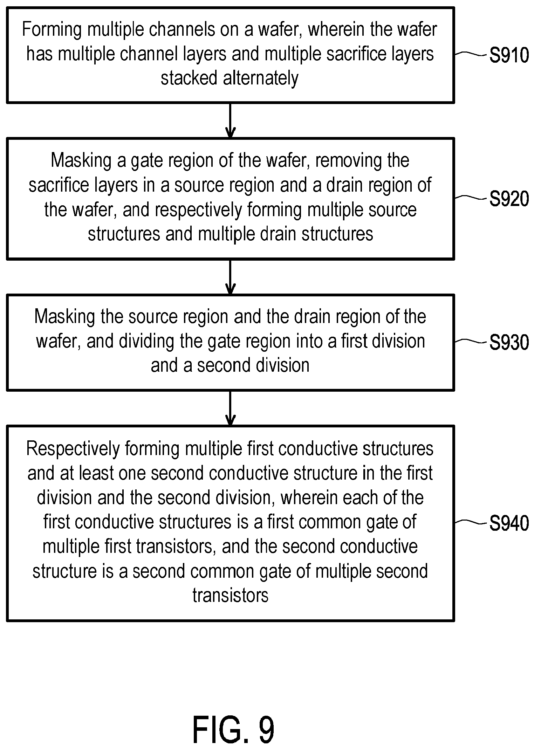

Referring to FIG. 9, FIG. 9 is a flowchart of a manufacturing method of a memory cell array of an embodiment of the disclosure. In step S910, multiple channels are formed on a wafer, in which the wafer has multiple channel layers and multiple sacrifice layers stacked alternately, and the channel layers are silicon layers and the sacrifice layers are silicon germanium layers in present embodiment. The number of channels may be determined according to the number of memory cells in the memory cell array. Then, in step S920, a gate region of the wafer is masked, the sacrifice layers in a source region and a drain region in the wafer are removed, to respectively form multiple source structures and multiple drain structures. By removing the sacrifice layer in the source region and the drain region, multiple channel pillars in the source region and the drain region may be formed. The portion of each channel pillar located in the source region may be configured to form each source structure, and the portion of each channel pillar located in the drain region may be configured to form each drain structure.

In step S930, the source region and the drain region of the wafer are masked, and the gate region is divided into a first division and a second division. Moreover, by removing the sacrifice layer in the first division and the second division, multiple channel pillars may be respectively formed in the first division and the second division. Next, in step S940, multiple first conductive structures and one or more second conductive structures are respectively formed in the first division and the second division, so that the first conductive structures may surround a first portion of the channel pillar, and the second conductive structures may surround a second portion of the channel pillar. Each of the first conductive structures forms a first common gate of multiple first transistors, and each of the second conductive structures forms a second common gate of multiple second transistors.

In an embodiment of the disclosure, the manufacturing method of the memory cell array further includes forming multiple third conductive structures, and respectively electrically coupling the third conductive structures to the source structures. Each of the third conductive structures is electrically coupled to a source structure column or a source structure row arranged on the same straight line. The third conductive structures are configured to respectively electrically coupled to multiple bit lines.

The manufacturing method of the memory cell array further includes forming multiple capacitors. The capacitors are respectively electrically coupled to the channel pillars, and border the end portions of the second gate structure.

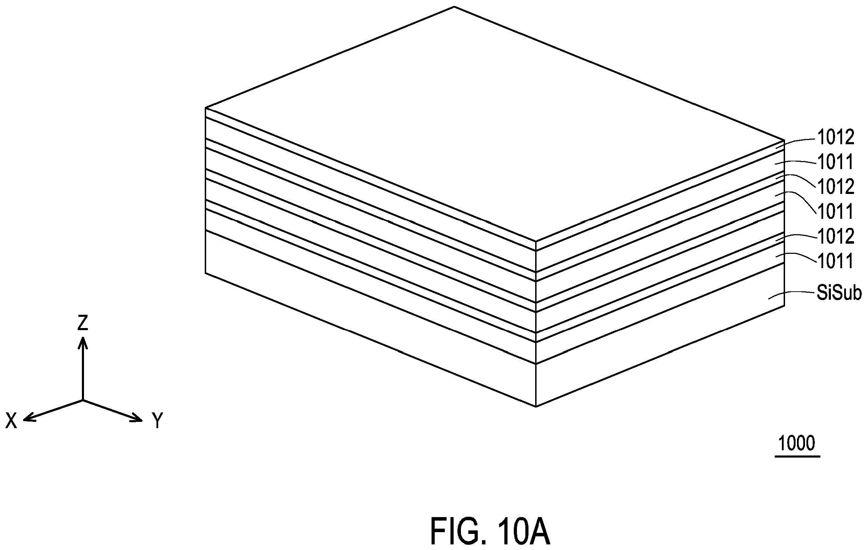

For details about the manufacturing method of the memory cell array, reference may be made to FIG. 10A to FIG. 10O. FIG. 10A to FIG. 10O are schematic diagrams of the process flow of the memory cell array of the embodiment of the disclosure. In FIG. 10A, a wafer 1000 is obtained through epitaxy. The wafer 1000 has a silicon substrate SiSub. The silicon substrate SiSub has multiple alternately stacked silicon layers 1012 and silicon germanium layers 1011.

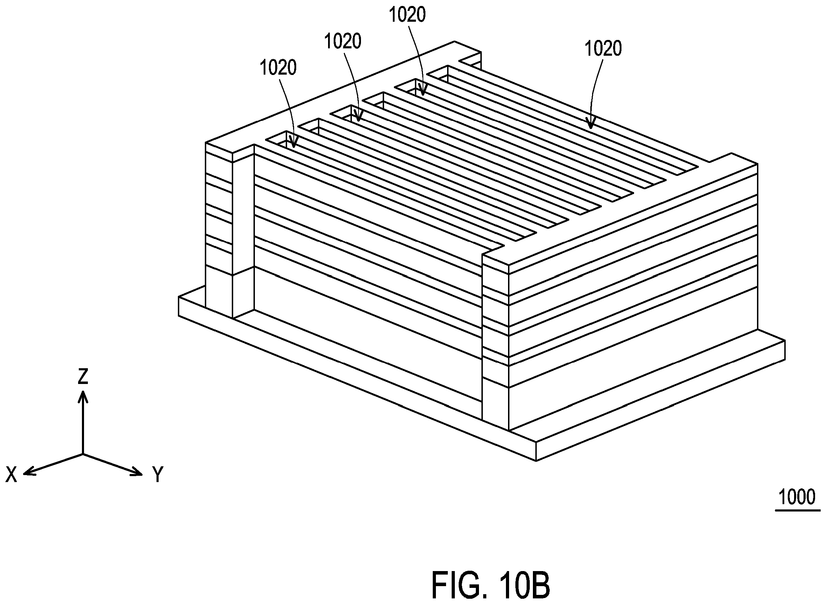

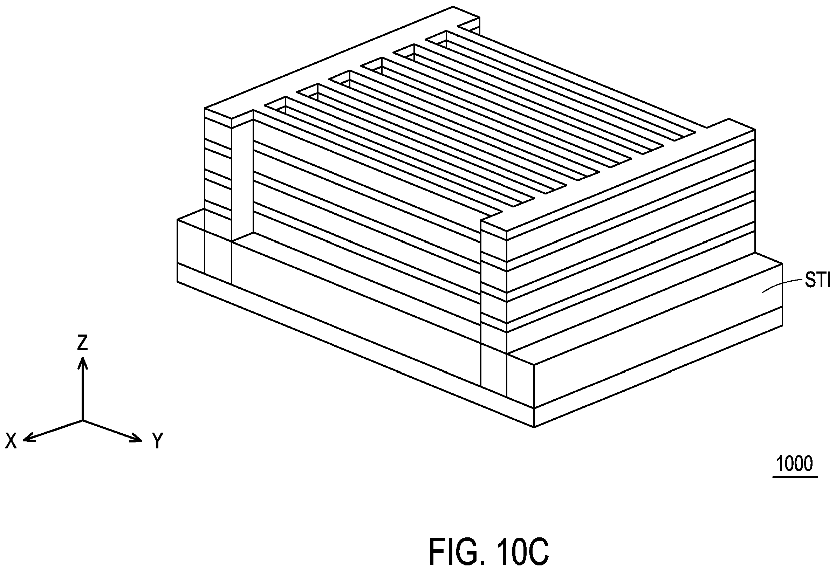

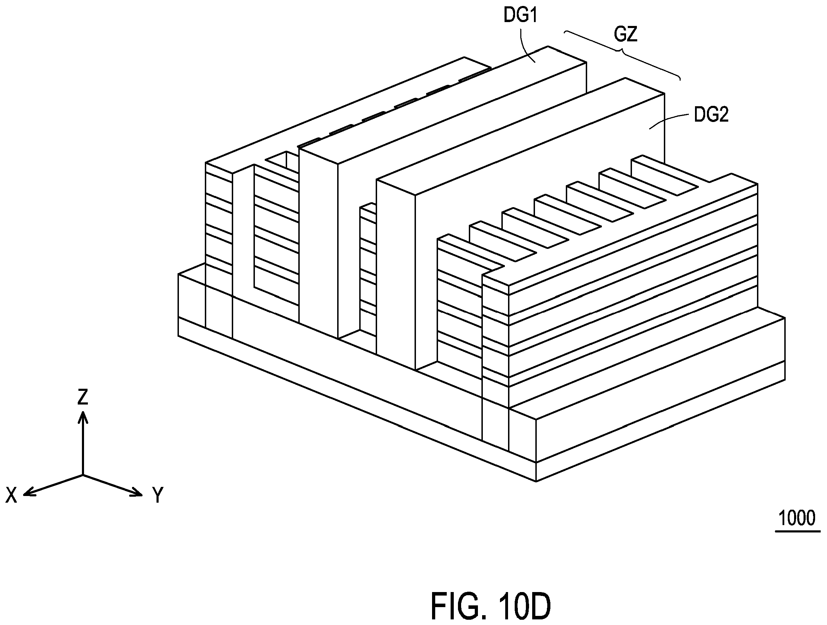

In FIG. 10B, a channel etching operation is performed on the wafer 1000, and multiple channels 1020 are generated in the wafer 1000. In FIG. 10C, a shallow trench isolation (STI) insulating layer STI is formed on the wafer 1000. Next, in FIG. 10D, a gate region GZ is defined in the wafer 1000, and dummy gate structures DG1 and DG2 are formed in the gate region GZ.

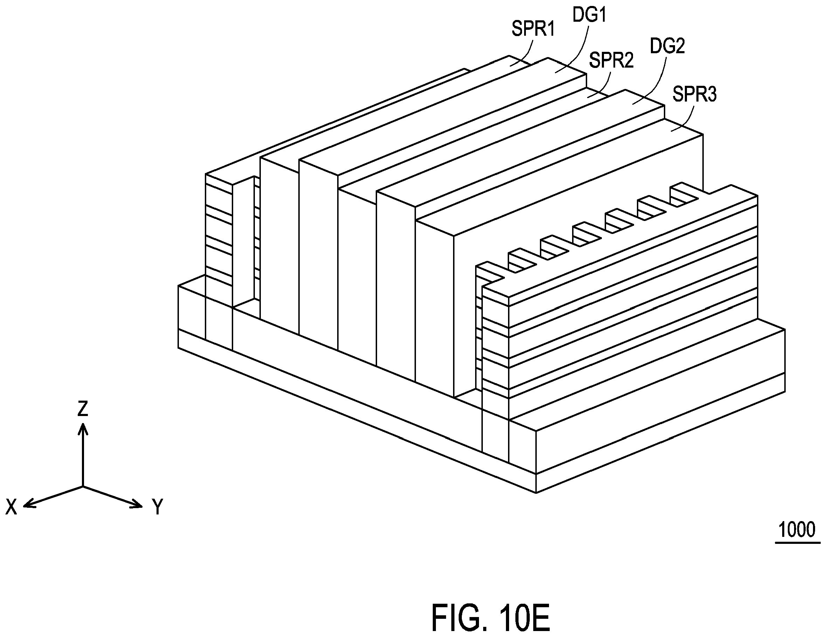

In FIG. 10E, spacer structures SPR2, SPR1, and SPR3 may be respectively formed between the dummy gate structures DG1 and DG2, on the outer side of the dummy gate structure DG1, and on the outer side of the dummy gate structure DG2. The spacer structures SPR2, SPR1, and SPR3 may be dielectric structures.

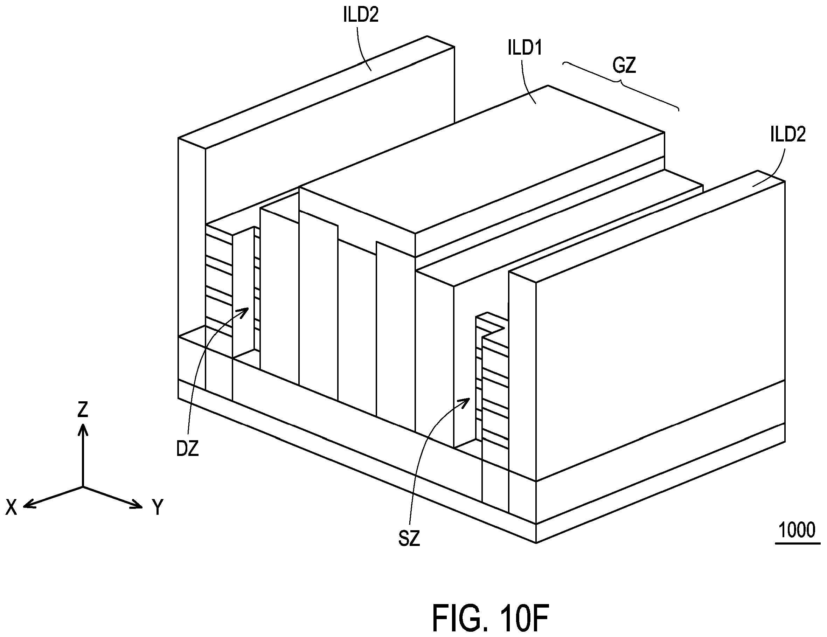

In FIG. 10F, a dielectric layer ILD1 covers the gate region GZ in the wafer 1000 to mask the gate region GZ. In addition, a dielectric layer ILD2 covers two sides of the wafer 1000 and exposes the source region SZ and the drain region DZ in the wafer.

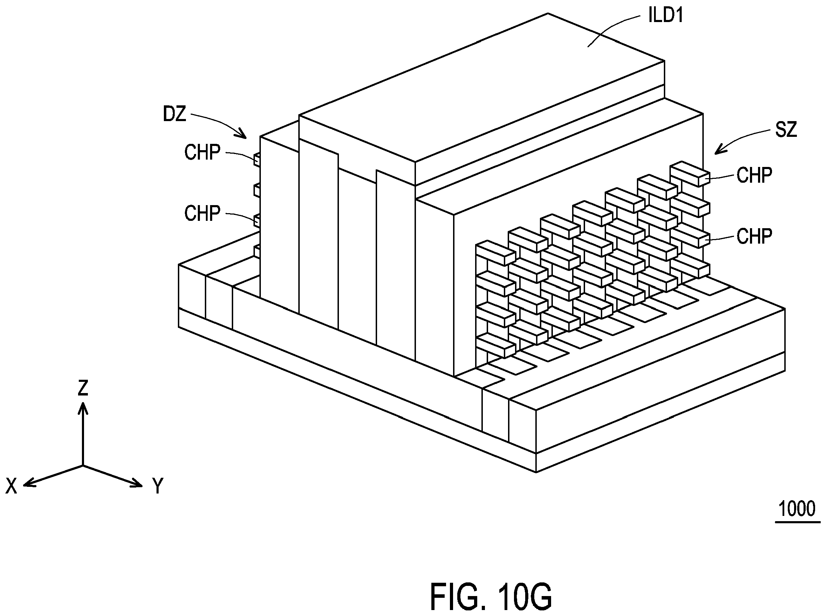

In FIG. 10G, an etching operation may be performed on the wafer 1000 to remove the silicon germanium layer in the source region SZ and the drain region DZ of the wafer 1000 to form multiple channel pillars CHP. Further, the source structure and the drain structure may be formed by making the channel pillar CHP a heavily doped region through plasma doping.

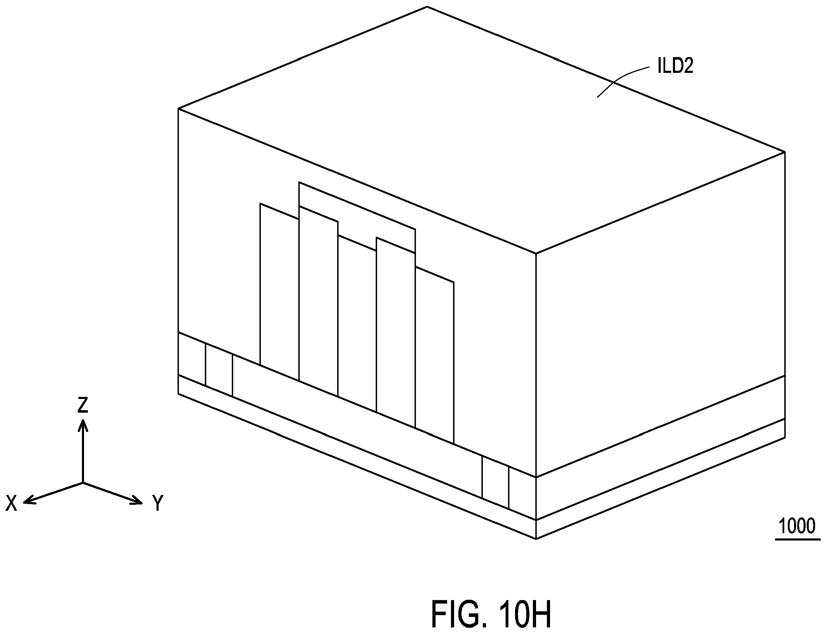

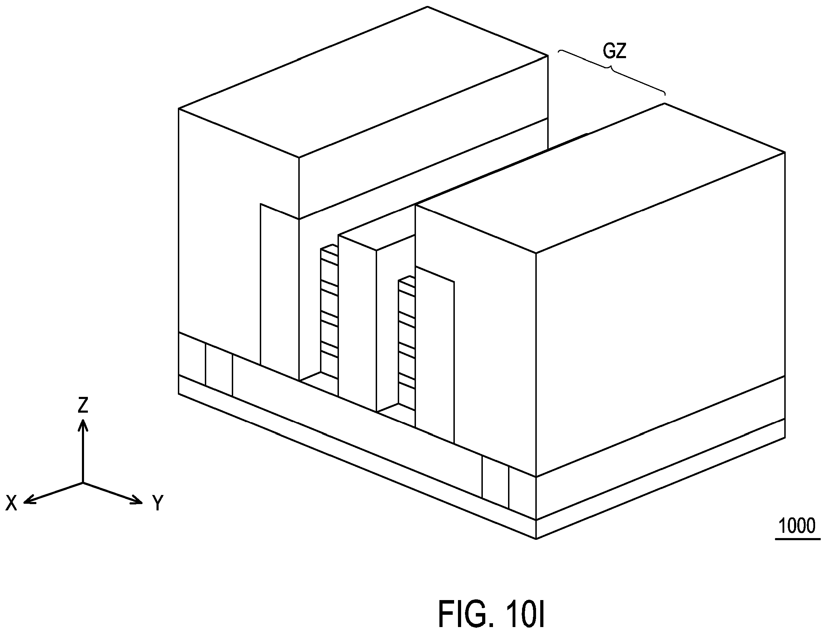

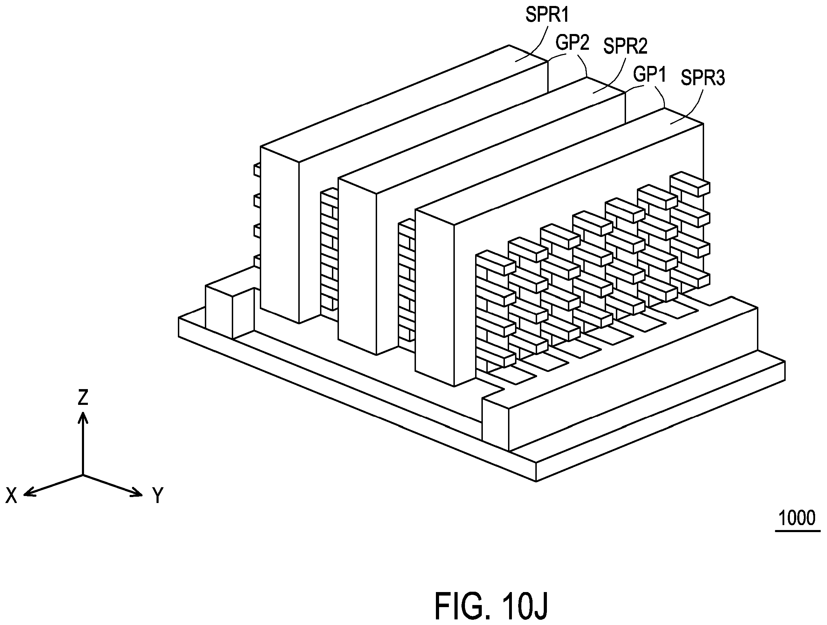

In FIG. 10H, a dielectric layer ILD2 is provided which covers the source region and drain region of the wafer 1000. In FIG. 10I, the dielectric layer ILD1 covering the gate region GZ of the wafer 1000 is removed, and the dummy gate structure in the gate region GZ is removed. In FIG. 10J, the first portion GP1 and the second portion GP2 in the gate region may be defined through the spacing effect of the spacer structures SPR2, SPR1, and SPR3. Moreover, multiple channel pillars in the first portion GP1 and the second portion GP2 may be formed by removing the silicon germanium layer in the first portion GP1 and the second portion GP2, in which each channel pillar may be a nanowire or a nanosheet. It is worth mentioning that, for observation convenience, the dielectric layer ILD2 that originally masks the wafer 1000 is not drawn in FIG. 10J.

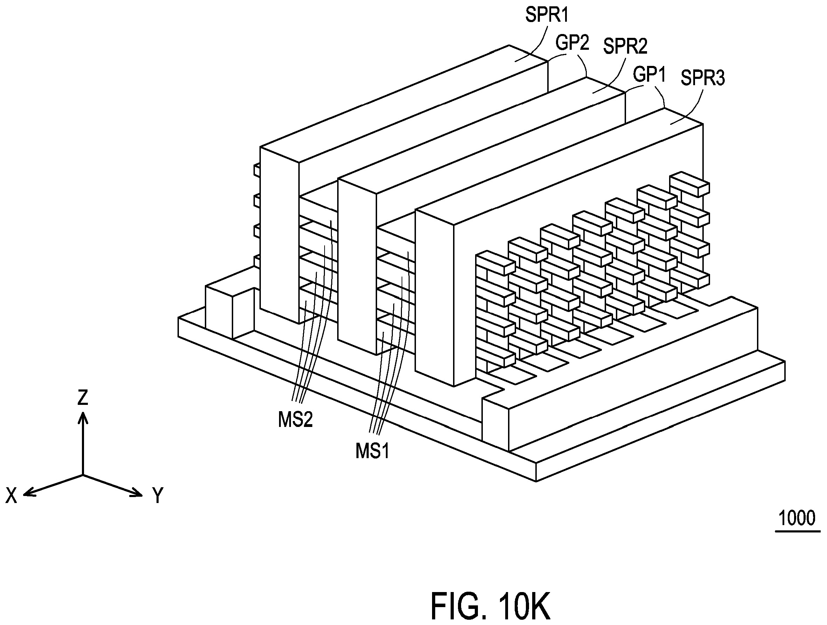

In FIG. 10K, a gate oxide layer may be formed on multiple channel pillars in the first portion GP1 and the second portion GP2 of the wafer 1000. Next, multiple conductive structures MS1 and MS2 are formed on the gate oxide layer, the conductive structures MS1 are separated from each other, and the conductive structures MS2 are separated from each other by processing means known to those skilled in the art. The conductive structures MS1 surround the channel pillars in the first portion GP1 of the wafer 1000, and the conductive structures MS2 surround the channel pillars in the second portion GP2 of the wafer 1000. The conductive structures MS1 are configured to form a common gate of multiple primary transistors, and the conductive structures MS2 are configured to form a common gate of multiple auxiliary transistors. In this embodiment, the conductive structures MS1 may be vertically arranged up and down along the Z-axis direction, and there is a spacing distance between two adjacent conductive structures MS1, thereby they are not in contact with each other. The conductive structures MS2 may be vertically arranged up and down along the Z-axis direction, and there may be a spacing distance between two adjacent conductive structures MS2, and may not be in contact with each other. In other embodiments of the disclosure, the conductive structures MS2 may also be electrically coupled to each other to form a single conductive structure.

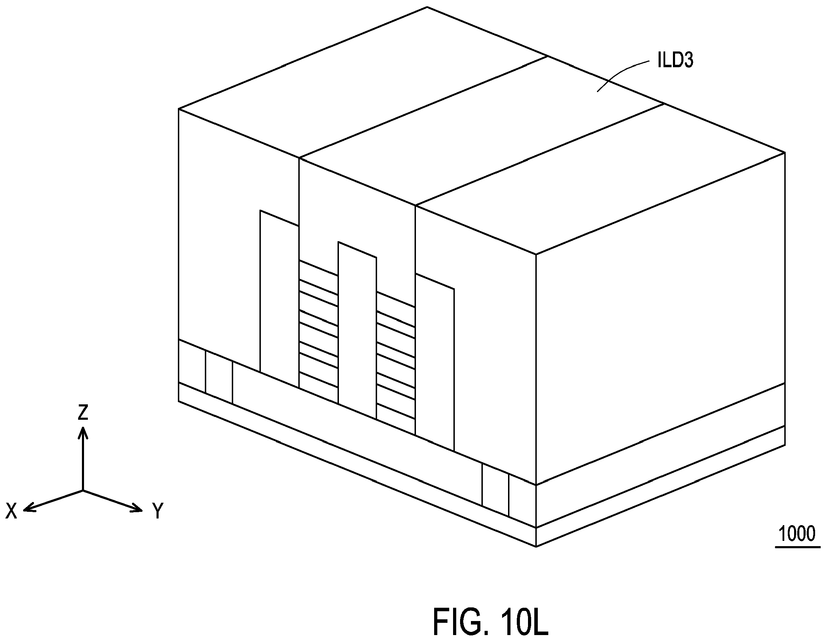

In FIG. 10L, a dielectric layer ILD3 is formed on the wafer 1000, and the dielectric layer ILD3 completely covers the surface of the wafer 1000.

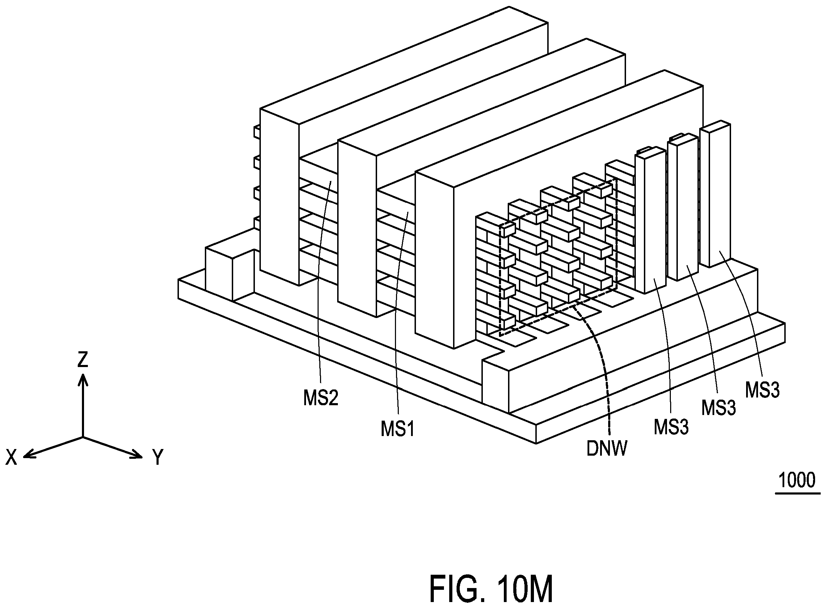

In FIG. 10M, multiple third conductive structures MS3 are formed on the wafer 1000. Here, the third conductive structures MS3 are electrically coupled to end portions of multiple channel pillars adjacent to the first conductive structure MS1. In this embodiment, the third conductive structure MS3 extends up and down and is a conductive plug structure. The third conductive structure MS3 is configured to electrically couple to the bit line.

It is worth mentioning that in FIG. 10M, the wafer 1000 has multiple dummy channel pillars DNW, which may also be referred to as dummy nanowires or dummy nanosheet. These dummy channel pillars DNW may serve as supporting structures for supporting the first conductive structure MS1 and the second conductive structure MS2.

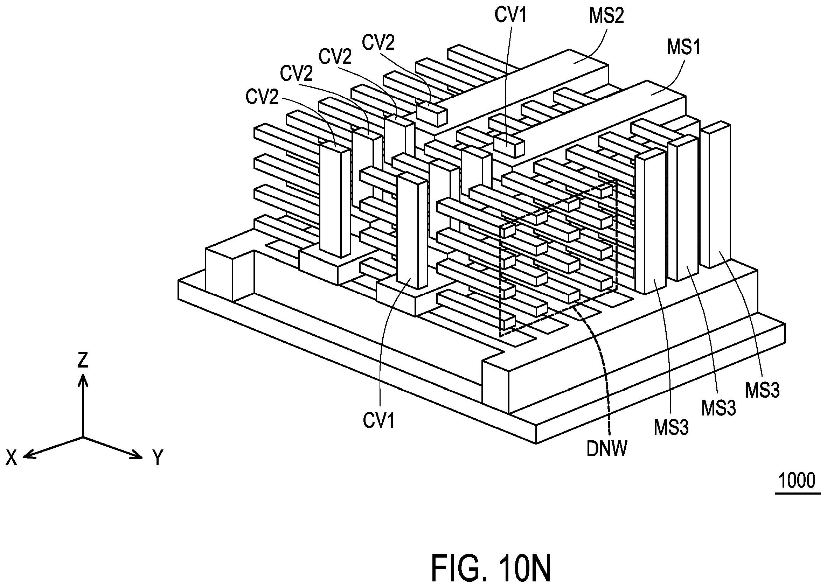

In FIG. 10N, the first conductive structure MS1 and the second conductive structure MS2 form a stepped structure. The stepped surface of the stepped first conductive structure MS1 may be respectively electrically coupled to the primary word line in the upper layer through multiple vertically arranged conductive plugs CV1, and the stepped surface of the stepped second conductive structure MS2 may be respectively electrically coupled to the auxiliary word line in the upper layer through multiple vertically arranged conductive plugs CV2.

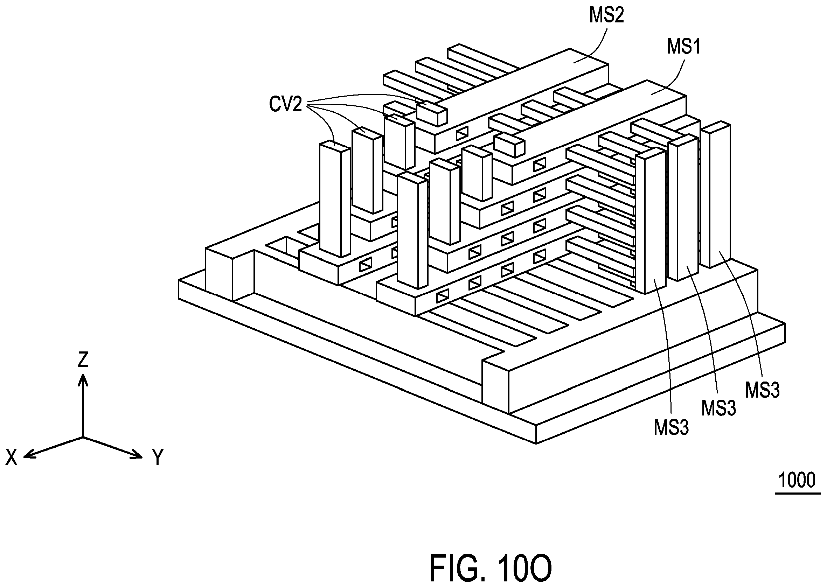

In FIG. 10O, for more clearly seen, the dummy channel pillar DNW of the stepped first conductive structure MS1 and the stepped second conductive structure MS2 are not shown. In present embodiment, the dummy channel pillar DNW is still retained in the wafer 1000.

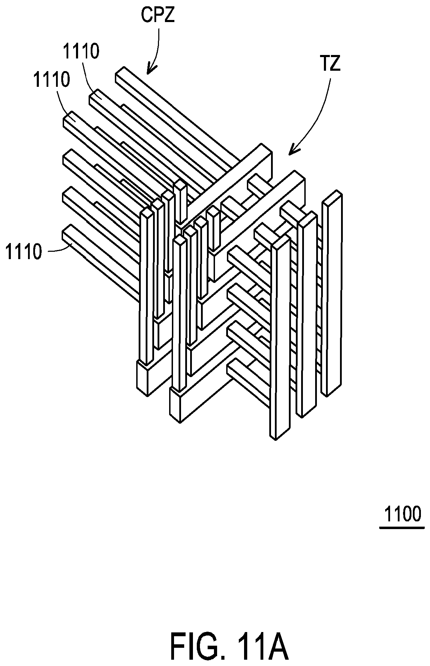

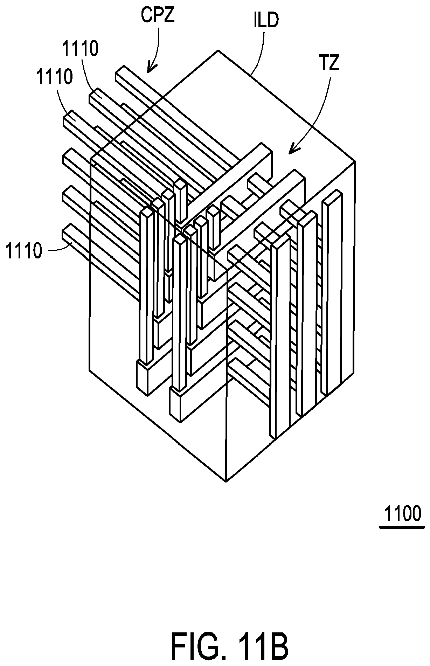

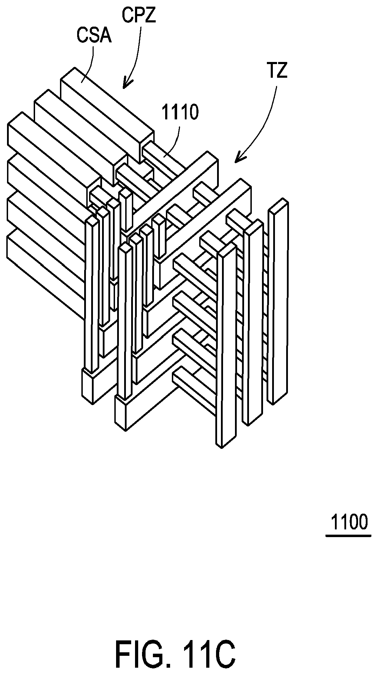

FIG. 11A to FIG. 11C are schematic diagrams of the process flow of the circuit structure of the memory cell array of the embodiment of the disclosure. The memory cell array 1100 may be divided into a transistor zone TZ and a capacitor zone CPZ. The memory cell array 1100 has multiple channel pillars 1110. In FIG. 11A, no capacitor is formed on the capacitor zone CPZ of the memory cell array 1100. In FIG. 11B, a dielectric layer ILD is formed on the transistor zone TZ of the memory cell array 1100, which masks the transistor zone TZ of the memory cell array 1100. Next, in FIG. 11C, multiple capacitors CSA are formed in the capacitance zone CPZ of the memory cell array 1100. The capacitors CSA are respectively electrically coupled to the channel pillars 1110.

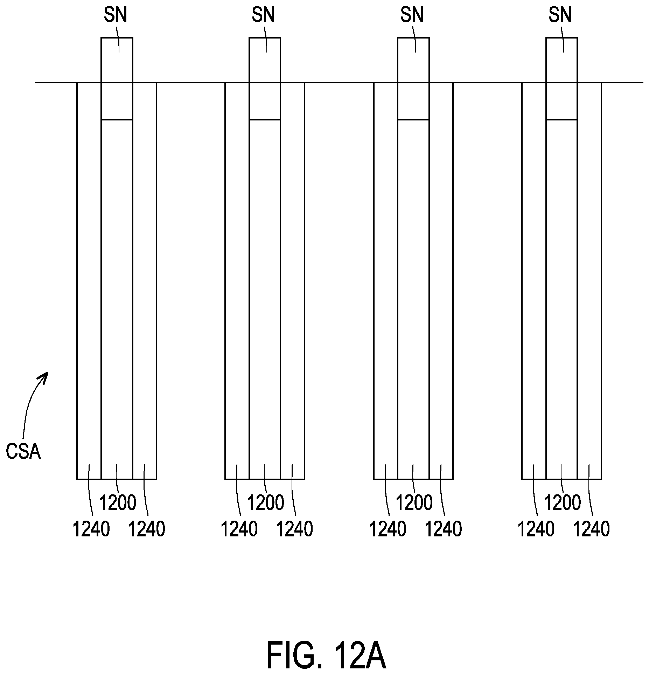

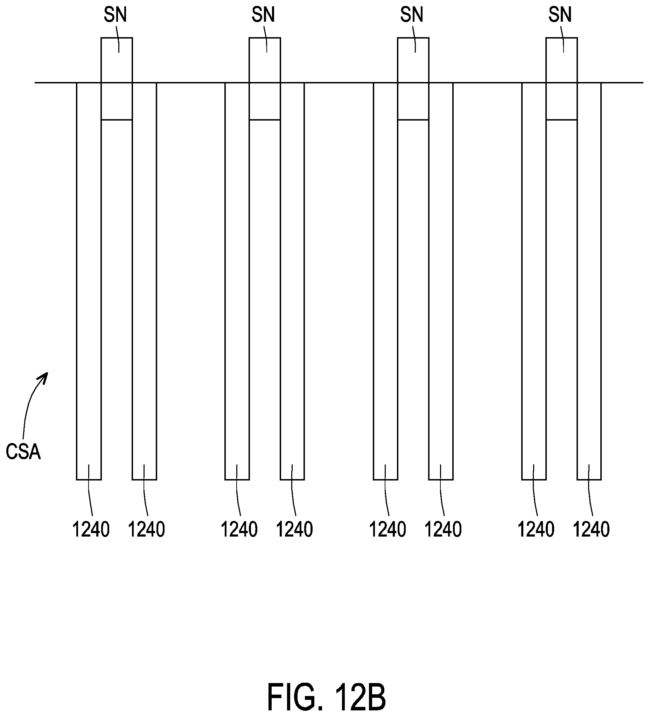

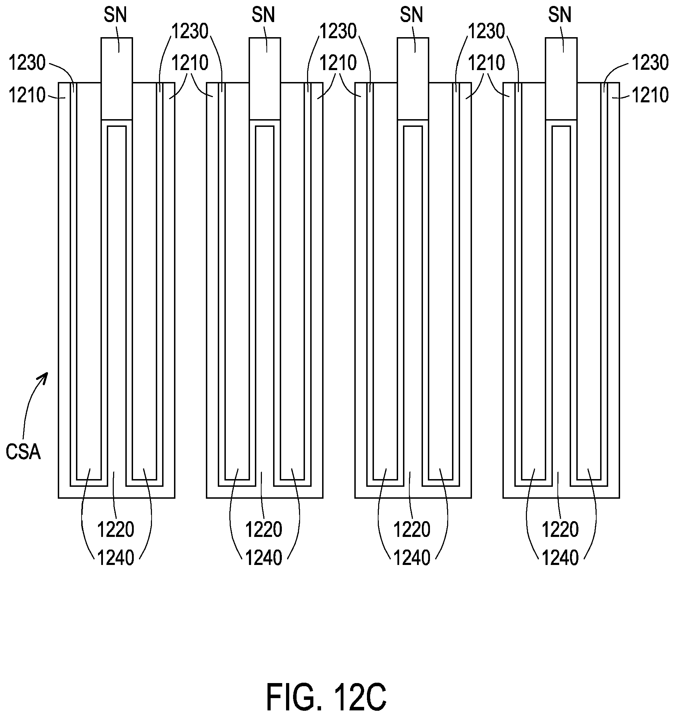

FIG. 12A to FIG. 12C show the implementation details of the formation method of the capacitor of the memory cell array of the embodiment of the disclosure. In FIG. 12A, for each capacitor CSA, internal electrodes 1240 may be formed on two sides of multiple channel pillars 1200, in which the internal electrodes 1240 may cover the channel pillars 1200. In other words, the internal electrode 1240 is formed and cover the outside surface of the channel pillar 1200 in the capacitance zone. In this embodiment, the channel pillar 1200 is electrically coupled to the transistor zone of the memory cell array through the node SN. In FIG. 12B, a portion of the region of the channel pillar 1200 that is covered by the internal conductive film 1240 may be removed. Next, in FIG. 12C, a dielectric layer 1230 may be formed on two sides of the internal conductive film 1240, and external conductive films 1210 and 1220 may be formed on the outer side the dielectric layer 1230. The external conductive film 1220 is formed between two adjacent conductive films 1240. In other words, the external conductive film 1220 is formed and surrounded by the internal conductive film 1240, and the internal conductive film 1240 is further surrounded by the external conductive film 1210. Moreover, the external conductive films 1220 and 1210 are electrically coupled to each other. Moreover, the end portions of the external conductive films 1220 and 1210 electrically coupled to each other may be electrically coupled to a common electrode plate at the side and is distant from the node SN.

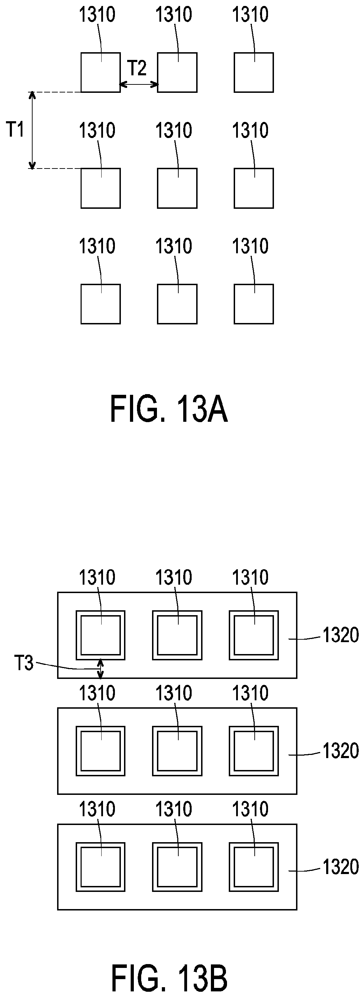

Referring to FIG. 13A and FIG. 13B, FIG. 13A is a side view of channel pillars in the memory cell array structure of an embodiment of the disclosure. FIG. 13B is a side view of channel pillars and conductive structures in the memory cell array structure of an embodiment of the disclosure. In FIG. 13A, multiple channel pillars 1310 of silicon material are arranged in an array. The distance T1 in the vertical direction between two adjacent channel pillars 1310 may be determined by the thickness of the SiGe layer between the silicon layers forming the channel pillars 1310. In the embodiment of the disclosure, in order to prevent the conductive structures 1320 respectively surrounding the channel pillars 1310 (as shown in FIG. 13B) from being in contact with each other, the thickness of the silicon germanium layer serving as a sacrificial layer in the manufacturing process may be greater than twice the sidewall thickness T3 of the conductive structure 1320.

On the other hand, among the channel pillars 1310 respectively surrounded by the conductive structures 1320, the distance T2 between two adjacent channel pillars 1310 on the horizontal line may be less than twice the thickness T3 of the conductive structure 1320.

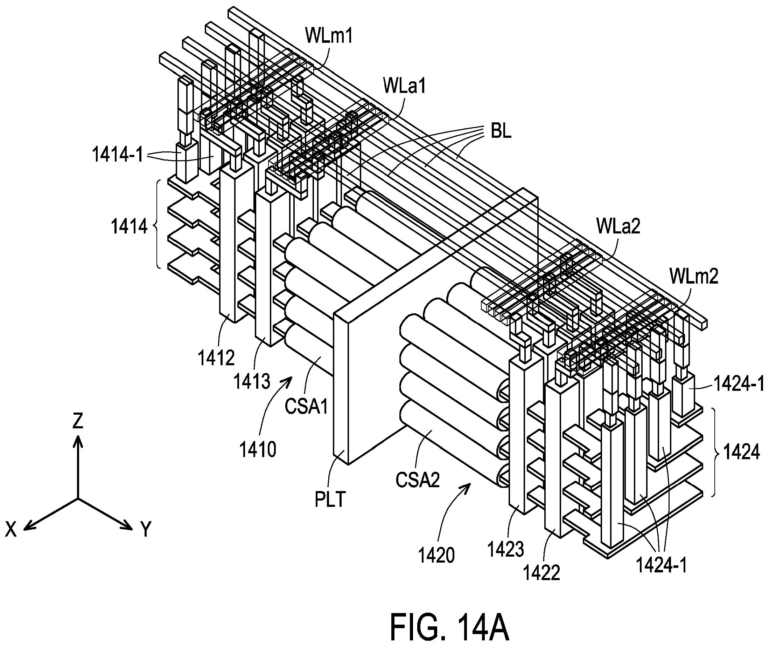

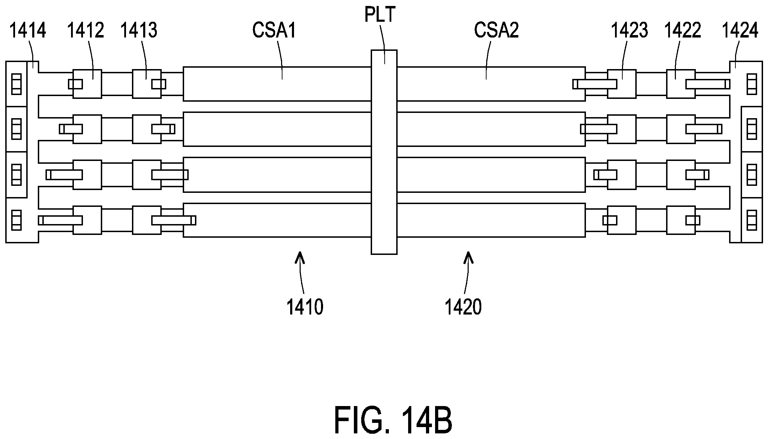

Referring to FIG. 14A and FIG. 14B, FIG. 14A is a three-dimensional diagram of a memory cell array structure of another embodiment of the disclosure. FIG. 14B is a top view of the memory cell array structure in the embodiment of FIG. 14A. There are two memory cell array structures 1410 and 1420 in FIG. 14A. The structure of any one of the memory cell array structures 1410 and 1420 is similar to the circuit structure of the memory cell array structure 500 in FIG. 5A. In this embodiment, the capacitor CSA1 in the memory cell array structure 1410 is electrically coupled to one side of the common electrode plate PLT, and the capacitor CSA2 in the memory cell array structure 1420 is electrically coupled to the other side of the common electrode plate PLT. The capacitors CSA1 and CSA2 receive the same reference voltage through the common electrode plate PLT.

In addition, in the memory cell array structure 1410, the first conductive structure 1412 extends along the Z-axis and forms the common gate of multiple primary transistors. The first conductive structure 1412 is electrically coupled to the primary word line WLm1. The second conductive structure 1413 also extends along the Z-axis direction and forms the common gate of multiple auxiliary transistors. The second conductive structure 1413 is also electrically coupled to the auxiliary word line WLa1. The primary word line WLm1 and the auxiliary word line WLa1 may extend along the X-axis direction.

In the memory cell array structure 1420, the first conductive structure 1422 extends along the Z-axis and forms the common gate of multiple primary transistors. The first conductive structure 1422 is electrically coupled to the primary word line WLm2. The second conductive structure 1423 also extends along the Z-axis direction and forms the common gate of multiple auxiliary transistors. The second conductive structure 1423 is also electrically coupled to the auxiliary word line WLa2. The primary word line WLm2 and the auxiliary word line WLa2 may extend along the X-axis direction.

It should be noted that the third conductive structure 1414 electrically coupled to the memory cell array structure 1410 extends along the X-axis direction, and is electrically coupled to the bit line BL through the conductive plug 1414-1 (extending along the Z-axis direction). The third conductive structure 1424 electrically coupled to the memory cell array structure 1420 also extends along the X-axis direction, and is electrically coupled to the same bit line BL through the conductive plug 1424-1 (extending along the Z-axis direction). The bit line BL may span across the common electrode plate PLT and be coupled between the memory cell arrays structures 1410 and 1420. The third conductive structure 1414 of the memory cell array structure 1410 and the third conductive structure 1424 of the memory array cell structure 1420 are mirror symmetrical along the common electrode plate PLT.

FIG. 14B is a top view of FIG. 14A. In FIG. 14B, for visual clarity, the bit line BL, the primary word lines WLm1 and WLm2, the auxiliary word lines WLa1 and WLa2 in FIG. 14A are not drawn.

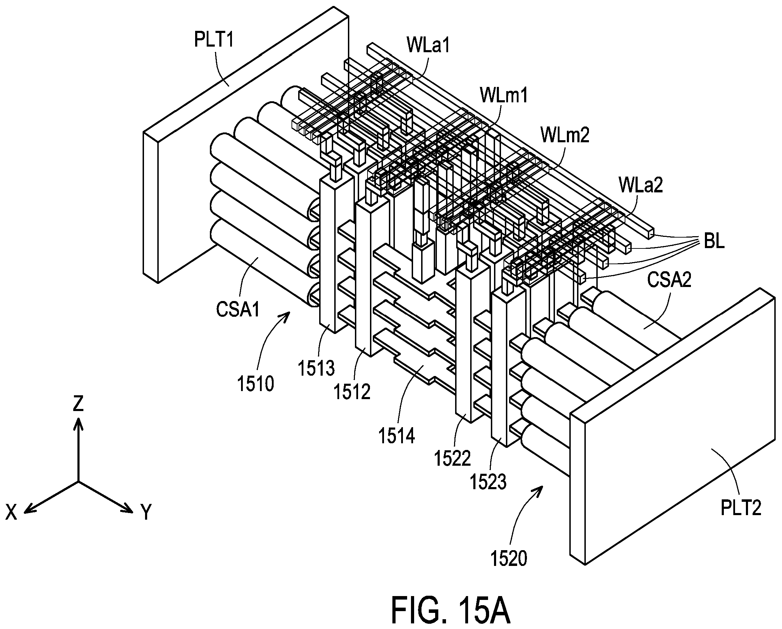

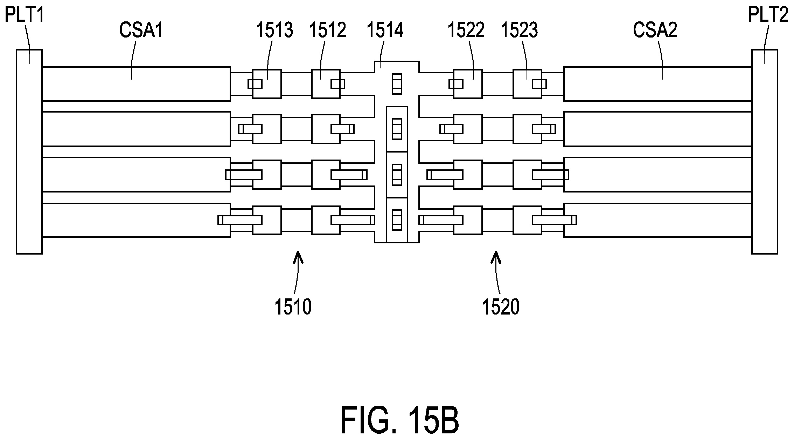

Referring to FIG. 15A and FIG. 15B, FIG. 15A is a three-dimensional diagram of a memory cell array structure of another embodiment of the disclosure. FIG. 15B is a top view of the memory cell array structure in the embodiment of FIG. 15A. There are two memory cell array structures 1510 and 1520 in FIG. 15A. The structure of any one of the memory cell array structures 1510 and 1520 is similar to the circuit structure of the memory cell array structure 500 in FIG. 5A.

Different from FIG. 14A, in this embodiment, the memory cell array structures 1510 and 1520 have a common third conductive structure 1514. The third conductive structure 1514 is electrically coupled to the source regions of the memory cell array structures 1510 and 1520 at the same time, and is electrically coupled to the common bit line BL through vertical conductive plugs. The memory cell array structures 1510 and 1520 are disposed symmetrically to the third conductive structure 1514. The first conductive structures 1512 and 1522 respectively form common gates of multiple primary transistors of the memory cell array structures 1510 and 1520, and are respectively electrically coupled to the primary word lines WLm1 and WLm2. The second conductive structures 1513 and 1523 respectively form common gates of multiple auxiliary transistors of the memory cell array structures 1510 and 1520, and are respectively electrically coupled to the auxiliary word lines WLa1 and WLa2. The capacitor CSA1 of the memory cell array structure 1510 is electrically coupled to the common electrode plate PLT1, and the capacitor CSA2 of the memory cell array structure 1520 is electrically coupled to the common electrode plate PLT2.

FIG. 15B is a top view of FIG. 15A. In FIG. 15B, for visual clarity, the bit line BL, the primary word lines WLm1 and WLm2, the auxiliary word lines WLa1 and WLa2 in FIG. 15A are not drawn. In present embodiment, not only the memory cell array structures 1510 and 1520, but also the metal routing for the primary word lines WLm1 and WLm2 and the auxiliary word lines WLa1 and WLa2 are disposed symmetrically to the third conductive structure 1514. In other embodiments, the layout of the metal routing is not limit thereto.

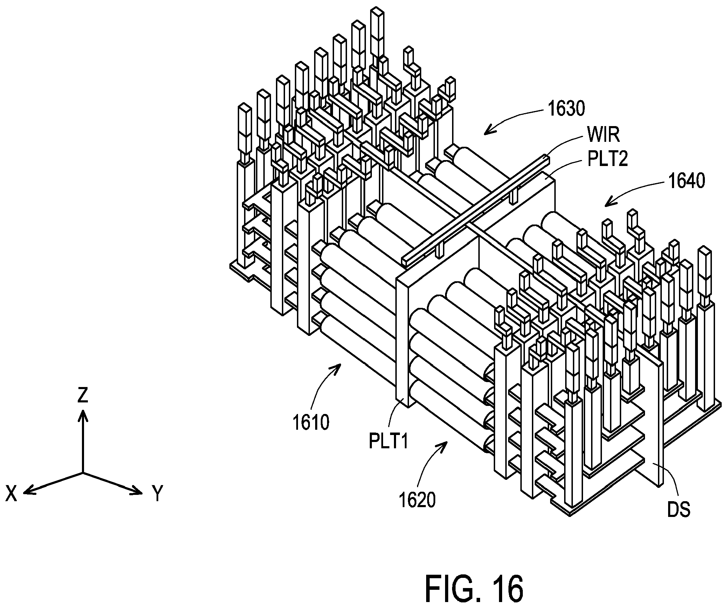

Referring to FIG. 16, FIG. 16 is a three-dimensional diagram of another implementation of a memory cell array structure of an embodiment of the disclosure. FIG. 16 integrates multiple memory cell array structures 1610 to 1640. The memory cell array structures 1610 and 1620 are constructed according to the implementation of FIG. 14A, and the memory cell array structures 1630 and 1640 may also be constructed according to the implementation of FIG. 14A. In addition, the array structures respectively constructed by the memory cell array structures 1610 and 1620 and the memory cell array structures 1630 and 1640 may be combined with each other, and may be isolated from each other through the dielectric spacer DS.

In this embodiment, the common electrode plate PLT1 and the common electrode plate PLT2 shared by the memory cell array structures 1610 and 1620 may be isolated from each other through the dielectric spacer DS. Therefore, when the common electrode plate PLT1 and the common electrode plate PLT2 receive the same reference voltage, the common electrode plate PLT1 and the common electrode plate PLT2 may be provided with a wire WIR across the dielectric spacer DS to electrically coupl the common electrode plate PLT1 and the common electrode plate PLT2 to each other. The memory cell array structure 1610 and the memory cell array structure 1630 are mirror symmetrical along the dielectric spacer DS. Likewise, the memory cell array structures 1620 and 1640 are mirror symmetrical along the dielectric spacer DS. The symmetrical staircase structure of the memory cell array structures 1610 and 1630 can be formed in the same time, and so the process complexity can be reduced.

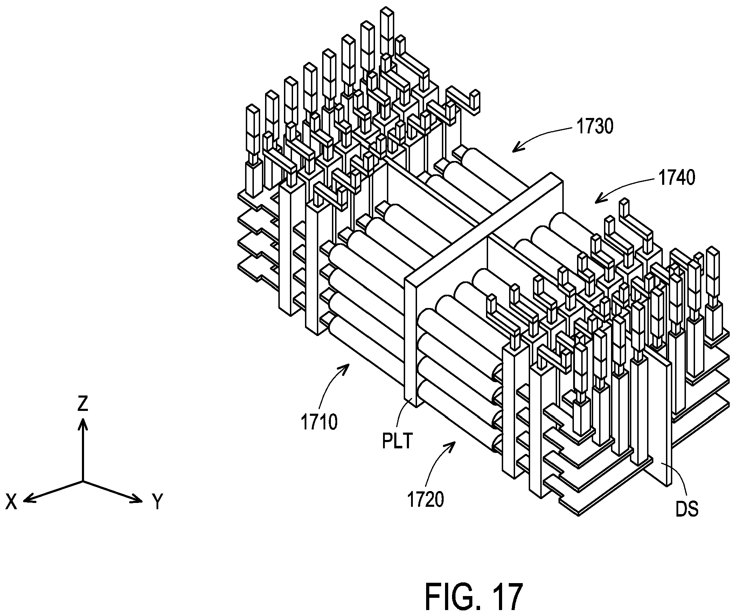

Referring to FIG. 17, FIG. 17 is a three-dimensional diagram of another implementation of a memory cell array structure of an embodiment of the disclosure. FIG. 17 integrates multiple memory cell array structures 1710 to 1740. The memory cell array structures 1710 and 1720 are constructed according to the implementation of FIG. 14A, and the memory cell array structures 1730 and 1740 are also constructed according to the implementation of FIG. 14A. In addition, the array structures respectively constructed by the memory cell array structures 1710 and 1720 and the memory cell array structures 1730 and 1740 may be combined with each other, and may be isolated from each other through the dielectric spacer DS.

Different from the embodiment in FIG. 16, in this embodiment, the forming step of the dielectric spacer DS may be earlier than the forming step of the common electrode plate PLT. Therefore, the common electrode plate PLT in this embodiment may not be partitioned into multiple portions by the dielectric spacer DS. Therefore, the memory cell array structures 1710 to 1740 may receive the same reference voltage through the shared common electrode plate PLT without the extra metal routing.

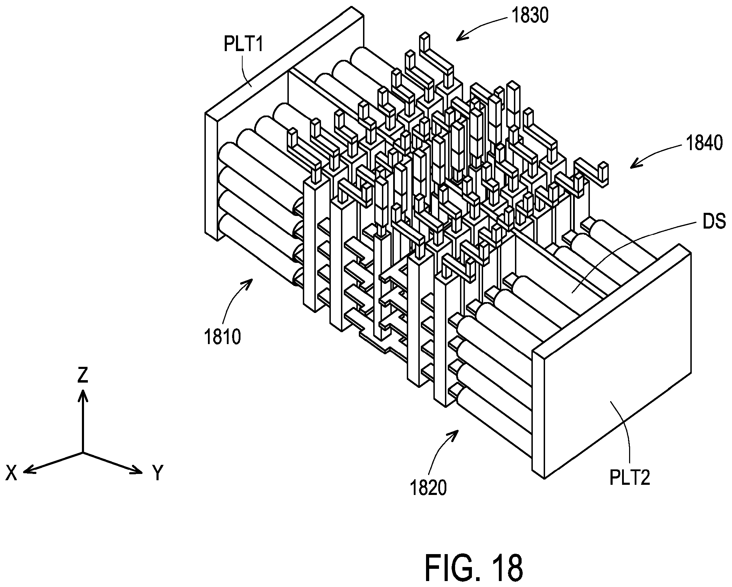

Referring to FIG. 18, FIG. 18 is a three-dimensional diagram of another implementation of a memory cell array structure of an embodiment of the disclosure. The memory cell array structure in FIG. 18 integrates multiple memory cell array structures 1810 to 1840. The memory cell array structures 1810 and 1820 are constructed according to the implementation of FIG. 15A, and the memory cell array structures 1830 and 1840 are also constructed according to the implementation of FIG. 15A. In addition, the array structures respectively constructed by the memory cell array structures 1810 and 1820 and the memory cell array structures 1830 and 1840 may be combined with each other, and may be isolated from each other through the dielectric spacer DS.

In this embodiment, the capacitors of the memory cell array structures 1810 and 1830 are commonly electrically coupled to the same common electrode plate PLT1, while the capacitors of the memory cell array structures 1820 and 1840 may be commonly electrically coupled to the same common electrode plate PLT2. The common electrode plates PLT1 and PLT2 are in different locations. In addition, the third conductive structures of the memory cell array structures 1810 and 1830 are formed in the same time, and then divided in the following forming step of dielectric spacer DS. So the process complexity is also reduced. The third conductive structures of the memory cell array structures 1810 is shared with the memory cell array structures 1820. The third conductive structures of the memory cell array structures 1830 is shared with the memory cell array structures 1840.

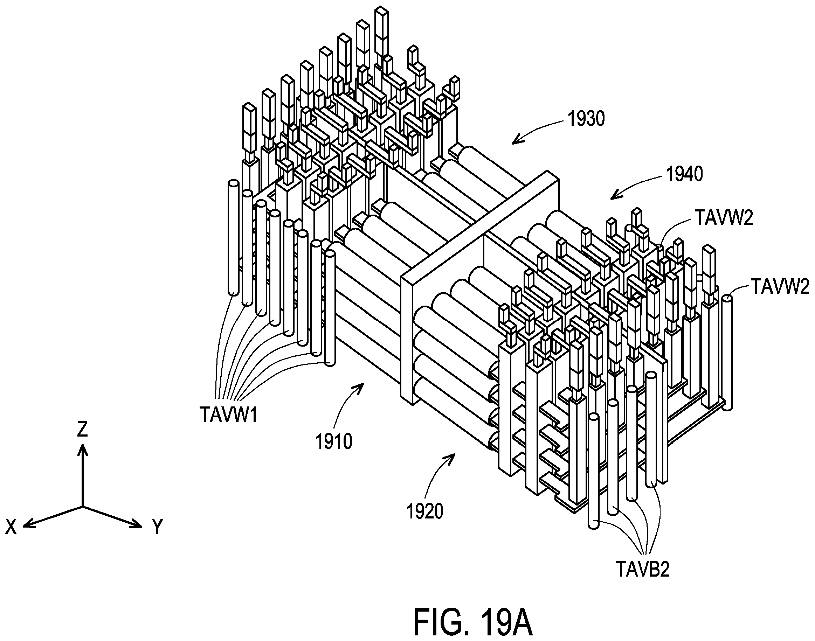

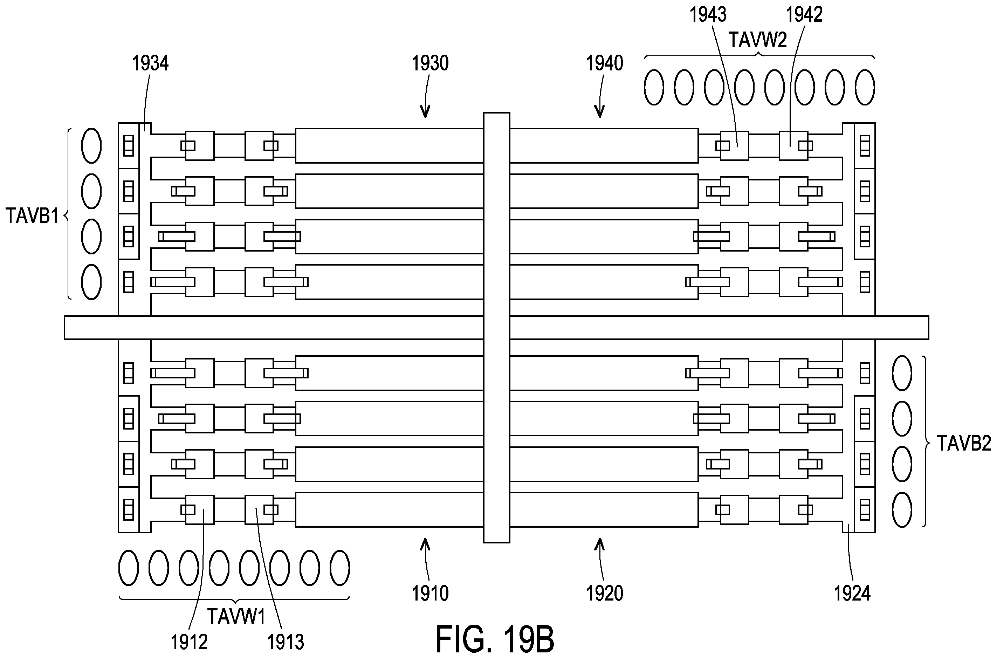

Referring to FIG. 19A and FIG. 19B, FIG. 19A is a three-dimensional diagram of another implementation of a memory cell array structure of an embodiment of the disclosure. FIG. 19B is a top view of the memory cell array structure in the embodiment of FIG. 19A. The memory cell array structure in FIG. 19A integrates multiple memory cell array structures 1910 to 1940. The memory cell array structures 1910 to 1940 are similar to the memory cell array structure shown in FIG. 17. Different from the previous embodiments, in this embodiment, multiple conductive array vias TAVW1 may be provided at the positions of the first conductive structure 1912 and the second conductive structure 1913 adjacent to the memory cell array structure 1910; multiple conductive array vias TAVW2 may be provided at the positions of the first conductive structure 1942 and the second conductive structure 1943 adjacent to the memory cell array structure 1940. Moreover, multiple conductive array vias TAVB2 may be provided at the position of the third conductive structure adjacent to the memory cell array structure 1920; and multiple conductive array vias TAVB1 may be provided at the position of the third conductive structure adjacent to the memory cell array structure 1930.

The conductive array vias TAVW1 respectively serve as media for electrically coupling the gates of the transistors in the memory cell array structure 1910 to the corresponding primary word lines and auxiliary word lines. The conductive array vias TAVW2 respectively serve as media for electrically coupling the gates of the transistors in the memory cell array structure 1940 to the corresponding primary word lines and auxiliary word lines. The conductive array vias TAVB1 respectively serve as media for electrically coupling the sources of the transistors in the memory cell array structure 1930 to the corresponding bit lines. The conductive array vias TAVB2 respectively serve as media for electrically coupling the sources of the transistors in the memory cell array structure 1920 to the corresponding bit lines.

In this embodiment, the conductive array vias TAVW1, TAVW2, TAVB1, and TAVB2 may be disposed in a blank space of the memory cell array structure without circuits nearby, and no extra space is required for layout. The conductive array vias TAVW1 and TAVW2 may be disposed adjacent to the capacitors of the corresponding memory cell array structures 1910 and 1940, which may enhance the area efficiency without the space waste near the capacitors Furthermore, the conductive array vias TAVW1 and TAVW2 may be arranged along the extending direction of the capacitor. The conductive array vias TAVB1 and TAVB2 are disposed near by the third conductive structures of the memory cell array structure 1920 and 1930, which may effectively improve the signal transmission efficiency between the memory cell array and corresponding bit lines. In other embodiments, the additional conductive array vias TAVW1/TAVW2/TAVB1/TAVB2 can be implemented in all memory cell array structure.

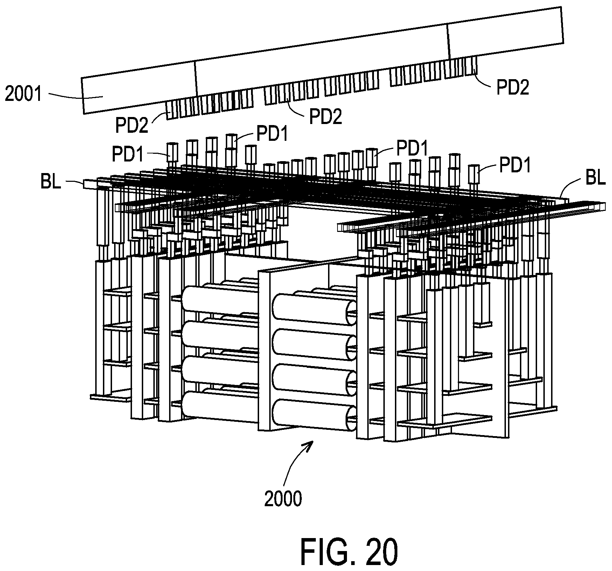

Referring to FIG. 20, FIG. 20 is a three-dimensional diagram of a memory cell array structure of another embodiment of the disclosure. In FIG. 20, the memory cell array structure 2000 may have a similar structure to the memory cell array structure shown in FIG. 17. Different from the previous embodiments, in this embodiment, multiple pads PD1 may be formed on the bit line BL of the memory cell array structure 2000. The memory cell array structure 2000 may be electrically coupled with the chip on another wafer 2001 through the pads PD1. Peripheral circuits related to the memory cell array structure 2000 may be disposed in the wafer 2001, and the wafer 2001 are electrically coupled to the pads PD1 respectively through multiple pads PD2 formed on the wafer 2001, so as to perform signal and power transmission. Likewise, corresponding pads can be formed above the primary word lines and the auxiliary word lines. In this embodiment, the connection between the pads PD1 in the memory cell array structure 2000 and the pads PD2 on the wafer 2001 can be executed through wafer bonding process.

Through the arrangement of this embodiment, the pad PD1 may be evenly disposed on many positions of the bit lines BL, and may be disposed on positions above the capacitors. In this way, there is enough space in the memory cell array structure 2000 for wiring, and a space above the capacitors can be used. In this embodiment, the pads PD1 and PD2 may be copper pads.

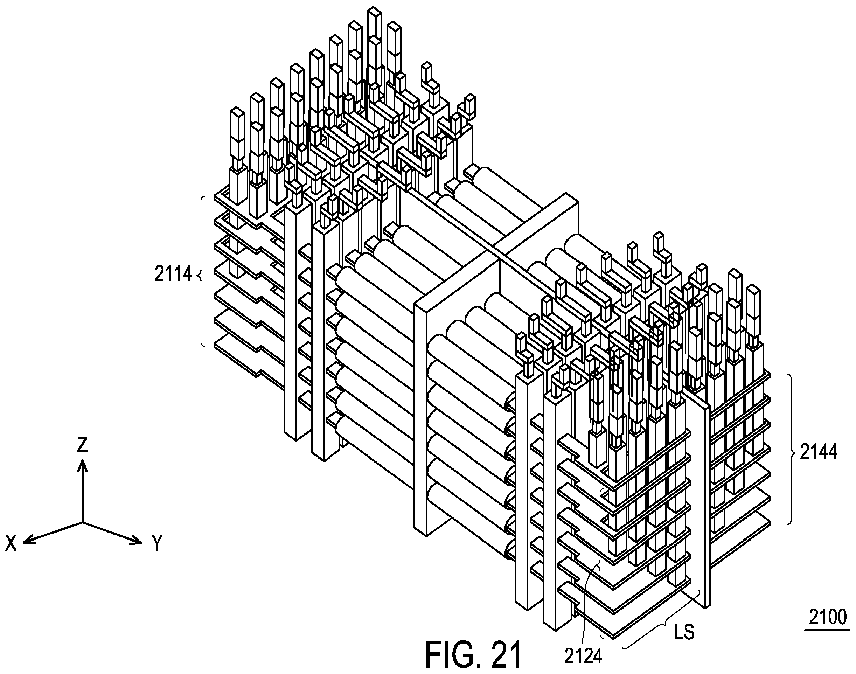

Referring to FIG. 21, FIG. 21 is a three-dimensional diagram of a memory cell array structure of another embodiment of the disclosure. In FIG. 21, the memory cell array structure 2100 may have a similar structure to the memory cell array structure shown in FIG. 17. It is worth mentioning that multiple third conductive structures 2114, 2124, and 2144 of the memory cell array structure 2100 form a stepped structure. Moreover, in this embodiment, the stepped structure of the third conductive structures 2114, 2124, and 2144 may be a minimum incremental layer cost (MiLC) stepped structure. The increment of each layer on the step may be determined according to the size of the conductive plug to be provided. In this way, the stepped structure of the third conductive structures 2114, 2124, and 2144 may have the length (for example, the length LS) of the bottom of the step with a minimum dimension, which may reduce the required volume of the circuit layout.

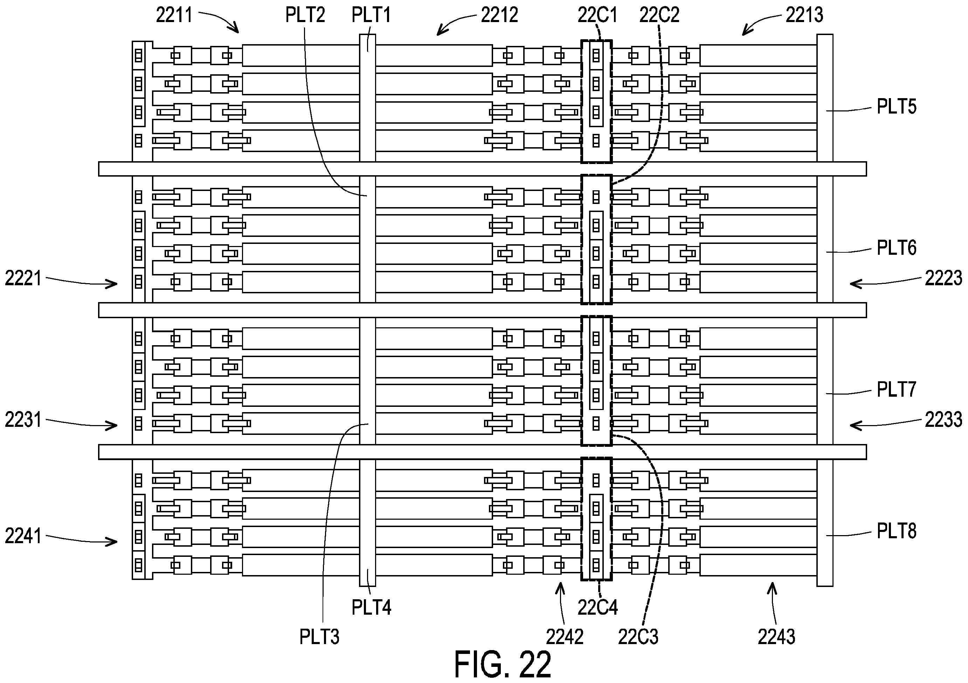

Referring to FIG. 22, FIG. 22 is a top view of a memory cell array structure of another embodiment of the disclosure. The memory cell array structure in FIG. 22 is formed of multiple memory cell array structures 2211 to 2243. The embodiment in FIG. 22 may be formed by combining the embodiments in FIG. 15A and FIG. 16. The memory cell array structure 2211 and the memory cell array structure 2212 share the same common electrode plate PLT1, and the memory cell array structure 2212 and the memory cell array structure 2213 share the same third conductive structure 22C1; the memory cell array structure 2221 and the corresponding memory cell array structure share the same common electrode plate PLT2, and the memory cell array structure 2223 and the corresponding memory cell array structure share the same third conductive structure 22C2; the memory cell array structure 2231 and the corresponding memory cell array structure share the same common electrode plate PLT3, and the memory cell array structure 2233 and the corresponding memory cell array structure share the same third conductive structure 22C3; the memory cell array structure 2241 and the corresponding memory cell array structure share the same common electrode plate PLT4, and the memory cell array structure 2243 and the corresponding memory cell array structure share the same third conductive structure 22C4. On the other hand, the memory cell array structures 2213 to 2243 are respectively electrically coupled to the common electrode plates PLT5, PLT6, PLT7, and PLT8.

The memory cell array structure in the embodiment of FIG. 22 may also be appropriately expanded according to requirements. In addition, they may be electrically coupled to each other by sharing a common electrode plate or sharing a third conductive structure, thereby effectively increasing the layout density of the memory cell array.

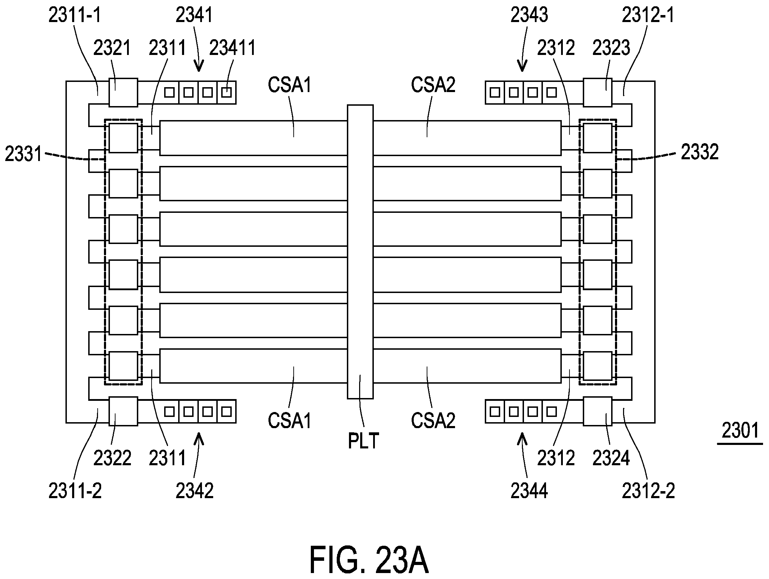

Referring to FIG. 23A to FIG. 23C, FIG. 23A to FIG. 23C are top views of implementations of multiple memory cell array structures of the embodiment of the disclosure. In FIG. 23A, the memory cell array structure 2301 includes a common electrode plate PLT, multiple channel pillars 2311 and 2312, multiple capacitors CSA1 and CSA2, first conductive structures 2321 to 2324, second conductive structures 2331 and 2332, and third conductive structures 2341 to 2344. The capacitors CSA1 and CSA2 are respectively electrically coupled to two sides of the common electrode plate PLT, and are disposed symmetrically to the common electrode plate PLT. The channel pillars 2311 and 2312 are respectively electrically coupled to the capacitors CSA1 and CSA2. The second conductive structures 2331 respectively surround the channel pillars 2311 to form gates of multiple auxiliary transistors, and the second conductive structures 2332 respectively surround the channel pillars 2312 to form gates of multiple auxiliary transistors.

It is worth mentioning that in this embodiment, the channel pillars 2311 may be commonly electrically coupled to form a first subsection 2311-1 and a second subsection 2311-2. Likewise, the channel pillars 2312 may be commonly electrically coupled to form a first subsection 2312-1 and a second subsection 2312-2. The first conductive structures 2321 to 2324 respectively surround the first subsection 2311-1, the second subsection 2311-2, the first subsection 2312-1, and the second subsection 2312-2, and respectively form the gates of multiple primary transistors.

The third conductive structures 2341 to 2344 may respectively be electrically coupled to the first subsection 2311-1, the second subsection 2311-2, the first subsection 2312-1, and the second subsection 2312-2. In this embodiment, each of the third conductive structures 2341 to 2344 may form a stepped structure. The stepped surface of the stepped structure may be electrically coupled to the conductive plug (e.g., the conductive plug 23411). The third conductive structures 2341 to 2344 may be electrically coupled to multiple bit lines through the conductive plugs. In this embodiment, the third conductive structures 2341 to 2344 are formed along the extending direction of capacitor CSA1 and CSA2, so the step structure can expand widely with the space waste. The area efficiency can be enhanced.

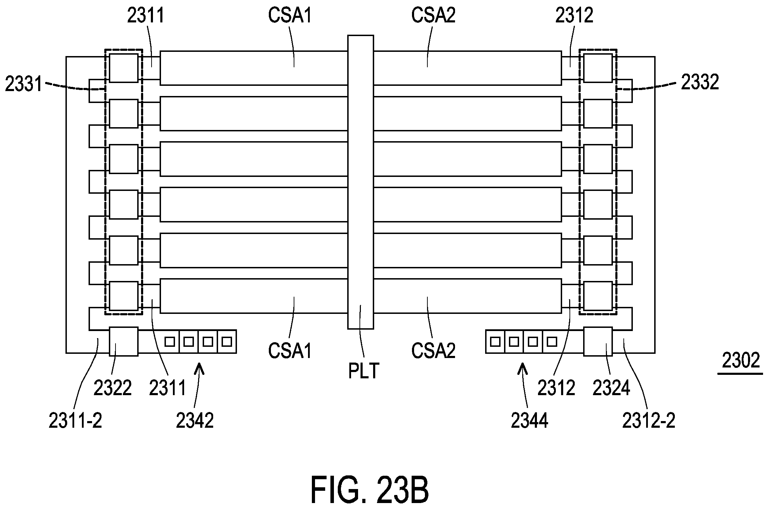

In FIG. 23B, the memory cell array structure 2302 has a similar structure to the memory cell array structure 2301. Different from FIG. 23A, the channel pillars 2311 and 2312 of the memory cell array structure 2302 only have the second subsection 2311-2 and the second subsection 2312-2. The conductive structures 2322 and 2324 respectively surround the second subsection 2311-2 and the second subsection 2312-2, and respectively form the gates of multiple primary transistors. In this embodiment, all steps of the third conductive structure can extend along the one side of the capacitor, the space of the other side of the capacitor can be used for different purposes.

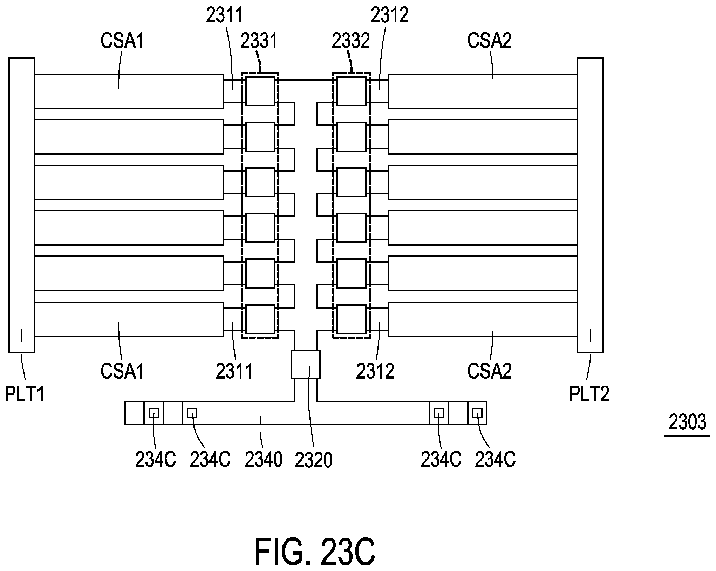

In FIG. 23C, the memory cell array structure 2303 includes a common electrode plates PLT1 and PLT2, multiple channel pillars 2311 and 2312, multiple capacitors CSA1 and CSA2, a first conductive structure 2320, second conductive structures 2331 and 2332, and a third conductive structure 2340. One end portion of the capacitors CSA1 are commonly electrically coupled to the common electrode plate PLT1, and the other end portion of the capacitors CSA1 are respectively electrically coupled to the channel pillars 2311. On the other hand, one end portion of the capacitors CSA2 are commonly electrically coupled to the common electrode plate PLT2, and the other end portion of the capacitors CSA2 are respectively electrically coupled to the channel pillars 2312. The second conductive structures 2331 respectively surround the channel pillars 2311 to form the gates of multiple auxiliary transistors. The second conductive structures 2332 respectively surround the channel pillars 2312 to form the gates of multiple auxiliary transistors. In this embodiment, the channel pillars 2311 and 2312 are electrically coupled to each other between the second conductive structure 2331 and the second conductive structure 2332 to form a common channel pillar. The first conductive structure 2320 surrounds the common channel pillar to form the gate of the primary transistor.

On the other hand, the third conductive structure 2340 is electrically coupled to the common channel pillar. A stepped structure may be formed on two sides of the third conductive structure 2340. The stepped surface on the stepped structure may be electrically coupled to multiple conductive plugs 234C, and electrically coupled to multiple bit lines through the conductive plugs 234C. The stepped surface on the step structure extends along the extending direction of the capacitor CSA1 and CSA2. In this embodiment, the stepped height of the stepped surfaces on the two sides of the third conductive structure 2340 are different with each other. However, in the other embodiments, the stepped height of the stepped surfaces on the two sides of the third conductive structure 2340 can be the same.

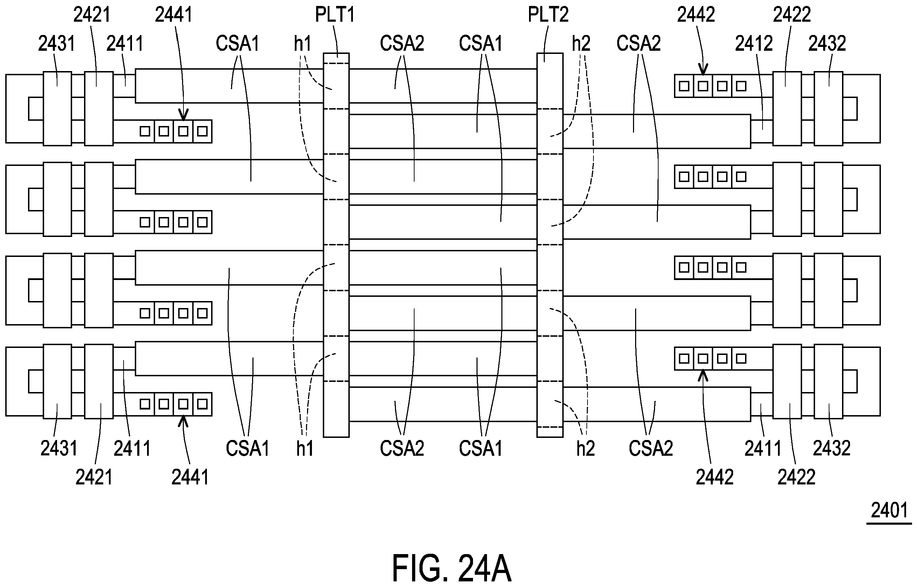

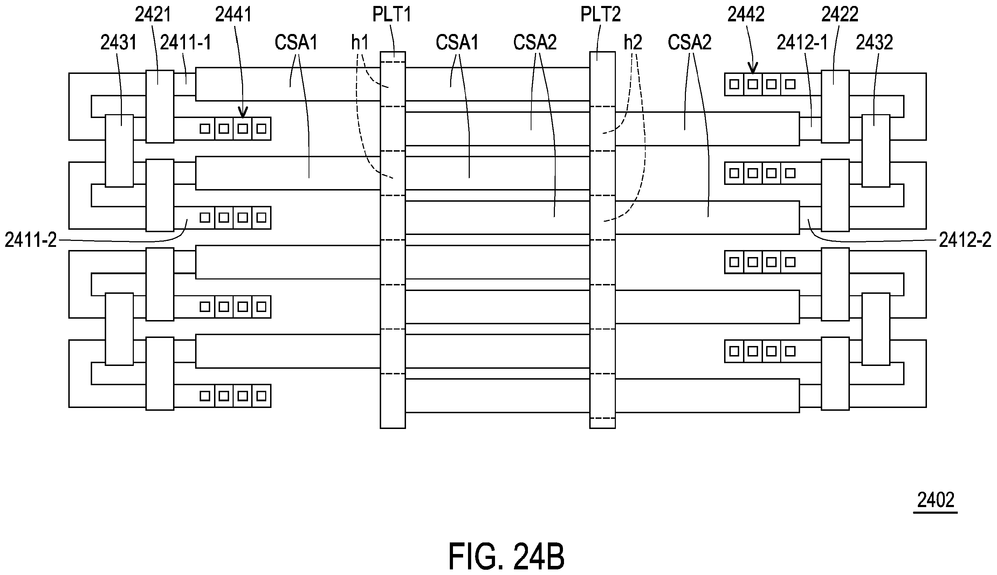

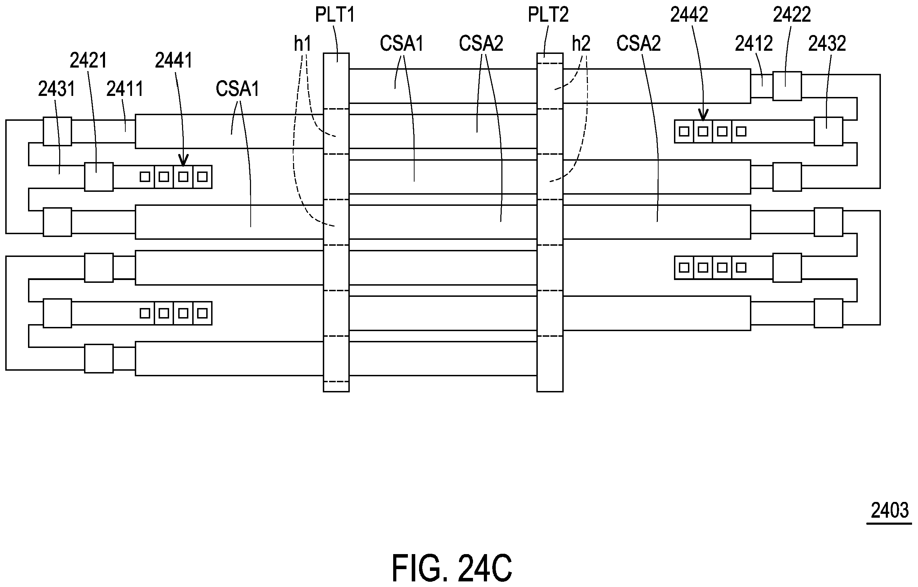

Referring to FIG. 24A to FIG. 24C, FIG. 24A to FIG. 24C are top views of implementations of multiple memory cell array structures of the embodiment of the disclosure. In FIG. 24, the memory cell array structure 2401 includes multiple channel pillar columns 2411 and 2412, multiple conductive structures 2421, 2422, 2431, 2432, 2441, and 2442, multiple capacitors CSA1 and CSA2, and common electrode plates PLT1 and PLT2. In this embodiment, the common electrode plate PLT1 has multiple openings h1, and the common electrode plate PLT2 has multiple openings h2. The capacitors CSA1 may respectively pass through the opening h1 to pass through the common electrode plate PLT1 and be electrically coupled to the common electrode plate PLT2, and the capacitors CSA2 may respectively pass through the opening h2 to pass through the common electrode plate PLT2 and be electrically coupled to the common electrode plate PLT1, to form an interdigitated arrangement.

In addition, each of the channel pillars 2411, 2412 may be a U-shaped channel pillar. The conductive structures 2421 and 2431 may surround different portions of the channel pillar 2411 to form gates of multiple transistors. The conductive structures 2422 and 2432 may surround different portions of the channel pillar 2412 to form gates of multiple transistors. The conductive structures 2441 are respectively electrically coupled to the channel pillars 2411, and the conductive structures 2442 are respectively electrically coupled to the channel pillars 2412. The conductive structure 2441 may be formed in the space between the adjacent capacitors CSA1, and the conductive structure 2442 may be formed in the space between the adjacent capacitors CSA2, so as to reduce the space required for the layout.

In this embodiment, the conductive structures 2441 and 2442 may be stepped structures. Similar to the foregoing embodiments, the stepped surface may be electrically coupled to the conductive plugs (the rectangular block portions in the drawing). The conductive structures 2441 and 2442 may be electrically coupled to the bit lines through the conductive plugs.

The memory cell array structure 2402 in FIG. 24B is similar to the aforementioned memory cell array structure 2401. The difference is that, taking adjacent channel pillars 2411-1 and 2411-2 as an example, the conductive structure 2421 surrounds two different portions of the same channel pillar 2411-1, and the conductive structure 2431 surrounds different channel pillars 2411-1 and 2411-2. Taking the adjacent channel pillars 2412-1 and 2412-2 on the other side as an example, the conductive structure 2422 surrounds two different portions of the same channel pillar 2412-1, and the conductive structure 2432 surrounds different channel pillars 2412-1 and 2412-2.

In FIG. 24C, the memory cell array structure 2403 includes multiple channel pillar columns 2411 and 2412, multiple conductive structures 2421, 2422, 2431, 2432, 2441, and 2442, multiple capacitors CSA1 and CSA2, and common electrode plates PLT1 and PLT2. Similar to the memory cell array structure 2401, the common electrode plates PLT1 and PLT2 respectively have multiple openings h1 and multiple openings h2. The capacitor CSA1 may pass through the opening h1 to be electrically coupled to the common electrode plate PLT2, and the capacitor CSA2 may pass through the opening h2 to be electrically coupled to the common electrode plate PLT1.

The channel pillars 2411 and 2412 of this embodiment may form an M shape. In FIG. 24C, the conductive structure 2431 may surround the upper and lower branches of the channel pillar 2411 to form the gate of the auxiliary transistor. The conductive structure 2421 may surround the central branch of the channel pillar 2411 to form the gate of the primary transistor. In addition, the conductive structure 2422 may surround the upper and lower branches of the channel pillar 2412 to form the gate of the auxiliary transistor. The conductive structure 2432 may surround the central branch of the channel pillar 2412 to form the gate of the primary transistor.

Similar to the foregoing embodiments, the conductive structures 2441 and 2442 may be stepped structures, and the stepped surface may be electrically coupled to the conductive plugs (the rectangular block portions in the drawing). The conductive structures 2441 and 2442 may be electrically coupled to the bit lines through the conductive plugs.

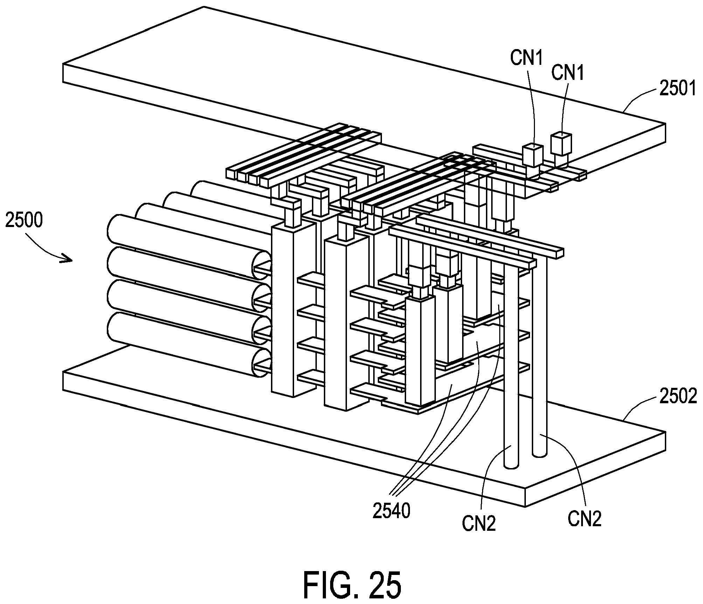

Referring to FIG. 25, FIG. 25 is a schematic diagram of a three-dimensional structure of a memory device of an embodiment of the disclosure. The memory cell array structure 2500 may be disposed between the upper plate 2501 and the lower plate 2502. The upper plate 2501 may have multiple transistors and form one or more circuits, and the lower plate 2502 may also have multiple transistors and form one or more circuits. In this embodiment, the upper plate 2501 may have multiple peripheral circuits such as a word line decoder, a page buffer, a platform controller, and a charge pump, etc. The lower plate 2502 may have multiple peripheral circuits such as a control logic circuit, a data transmission path, and an input and output circuit, etc.

The third conductive structure in the memory cell array structure 2500 may be electrically coupled to the conductive vias CN1 and CN2 through the conductive plugs, and then electrically coupled to the circuits in the upper plate 2501 and the lower plate 2502 through the conductive vias CN1 and CN2.

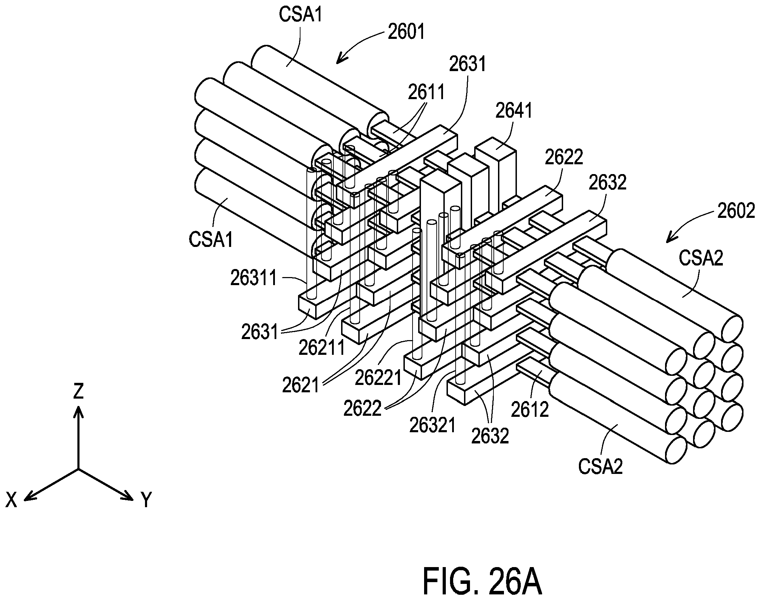

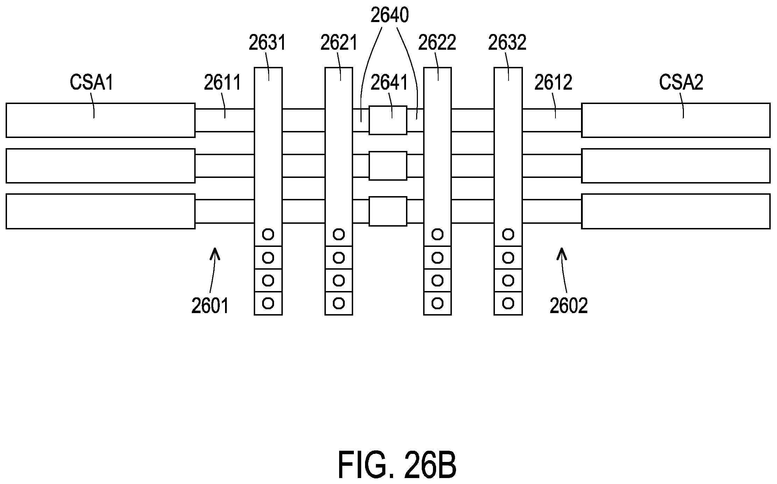

Referring to FIG. 26A and FIG. 26B, FIG. 26A is a three-dimensional diagram of a memory cell array structure of another embodiment of the disclosure. FIG. 26B is a top view of the memory cell array structure of FIG. 26A. The memory cell array structure in FIG. 26A is formed of two memory cell array structures 2601 and 2602 shown in FIG. 6A. The memory cell array structures 2601 and 2602 are electrically coupled to each other through a common third conductive structure 2640 (see FIG. 26B). The memory cell array structure 2601 has multiple capacitors CSA1, channel pillars 2611, first conductive structures 2621, and second conductive structures 2631. The memory cell array structure 2602 has multiple capacitors CSA2, channel pillars 2612, first conductive structures 2622, and second conductive structures 2632. In this embodiment, the first conductive structure 2621 forms the gates of multiple primary transistors in the memory cell array structure 2601, the second conductive structure 2631 forms the gates of multiple auxiliary transistors in the memory cell array structure 2601, the first conductive structure 2622 forms gates of multiple primary transistors in the memory cell array structure 2602, and the second conductive structure 2632 forms gates of multiple auxiliary transistors in the memory cell array structure 2602. Moreover, both the first conductive structures 2621 and 2622 and the second conductive structures 2631 and 2632 may be formed as stepped structures, or called staircase. The first conductive structures 2621 and 2622 are respectively electrically coupled to the primary word lines through the conductive plugs 26211 and 26221, and the second conductive structures 2631 and 2632 are respectively electrically coupled to the auxiliary word lines through the conductive plugs 26311 and 26321.

The third conductive structure 2640 shared by the memory cell array structures 2601 and 2602 may be electrically coupled to the bit line through the conductive plug 2641.

In this embodiment, the capacitors CSA1 and CSA2, and the channel pillars 2611 and 2612 may extend along the Y-axis direction, the first conductive structures 2621 and 2622, and the second conductive structures 2631 and 2632 may extend along the X-axis direction, and the conductive plugs 26211, 26221, 26311, 26321, and 2641 may extend along the Z-axis direction.

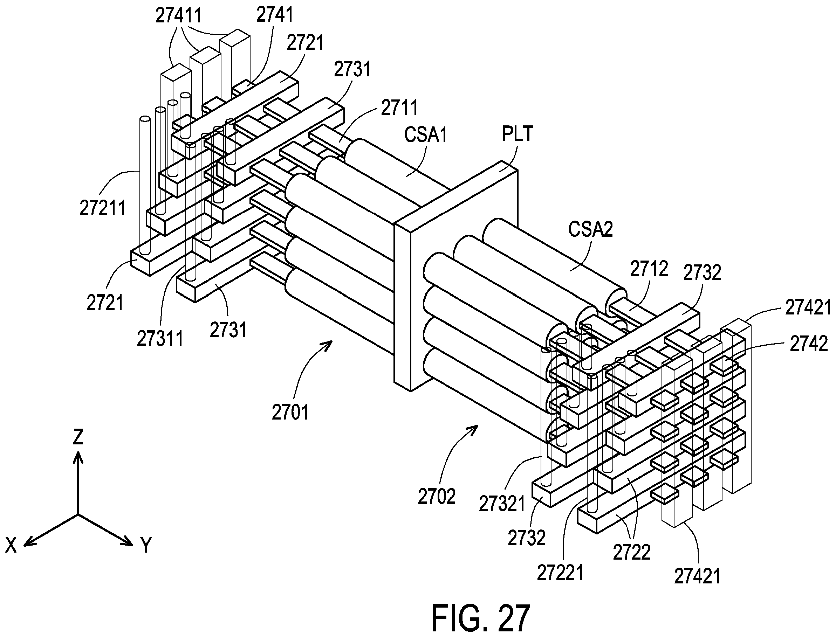

Referring to FIG. 27, FIG. 27 is a three-dimensional diagram of a memory cell array structure of another embodiment of the disclosure. The memory cell array structure in FIG. 27 may also be formed of two memory cell array structures 2701 and 2702 shown in FIG. 6A. The difference from FIG. 26A is that the memory cell array structures 2701 and 2702 have a shared common electrode plate PLT. The capacitor CSA1 in the memory cell array structure 2701 and the capacitor CSA2 in the memory cell array structure 2702 are respectively electrically coupled to two opposite sides of the common electrode plate PLT.

In the memory cell array structure 2701, the first conductive structure 2721 surrounds the channel pillar 2711 to form the gates of the primary transistors, and the second conductive structure 2731 surrounds the channel pillar 2711 to form the gates of the auxiliary transistors. Both the first conductive structure 2721 and the second conductive structure 2731 present a stepped structure. The stepped surfaces of the first conductive structure 2721 and the second conductive structure 2731 are respectively electrically coupled to the conductive plugs 27211 and 27311, and are respectively electrically coupled to the primary word line and the auxiliary word line through the conductive plugs 27211 and 27311. In the memory cell array structure 2702, the first conductive structure 2722 surrounds the channel pillar 2712 to form the gates of the primary transistors, and the second conductive structure 2732 surrounds the channel pillar 2712 to form the gates of the auxiliary transistors. Both the first conductive structure 2722 and the second conductive structure 2732 present a stepped structure. The stepped surfaces of the first conductive structure 2722 and the second conductive structure 2732 are respectively electrically coupled to the conductive plugs 27221 and 27321, and are respectively electrically coupled to the primary word line and the auxiliary word line through the conductive plugs 27221 and 27321.

In addition, the memory cell array structures 2701 and 2702 may be electrically coupled to the bit lines through normalized (non-stepped structure) conductive plugs 27411 and 27421.

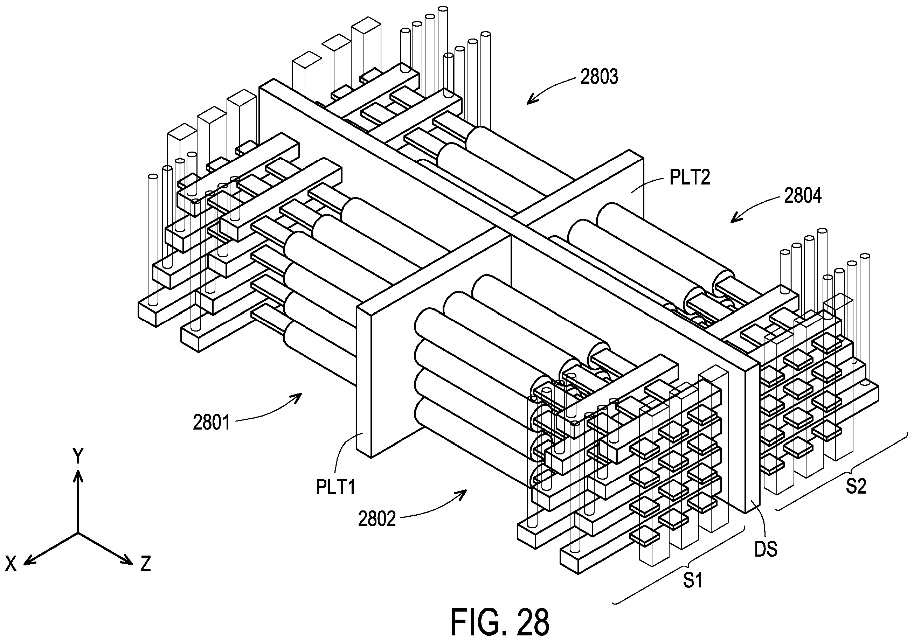

Referring to FIG. 28, FIG. 28 is a schematic diagram of a memory cell array structure of another embodiment of the disclosure. The memory cell array structure in FIG. 28 is formed of multiple memory cell array structures 2801 to 2804. The memory cell array structures 2801 and 2802 may be combined with each other according to the embodiment of FIG. 27 to form the first section structure S1, and the memory cell array structures 2803 and 2804 may also be combined with each other according to the embodiment of FIG. 27 to form the second section structure S2. In this embodiment, the memory cell array structures 2801 and 2802 share a common electrode plate PLT1, and the memory cell array structures 2803 and 2804 share a common electrode plate PLT2.

Isolation may be achieved by disposing a dielectric spacer DS between the first section structure S1 and the second section structure S2. In this embodiment, the common electrode plates PLT1 and PLT2 may independently receive the same or different reference voltages.

It is worth noting that in this embodiment, the stepped structures of the conductive structures of the memory cell array structures 2801 and 2803 are mutually symmetrical to the dielectric spacers DS. Similarly, the stepped structures of the conductive structures of the memory cell array structures 2802 and 2804 are mutually symmetrical to the dielectric spacers DS. In this way, the conductive plugs for electrically coupling to the word lines may also have a relatively symmetrical structure.

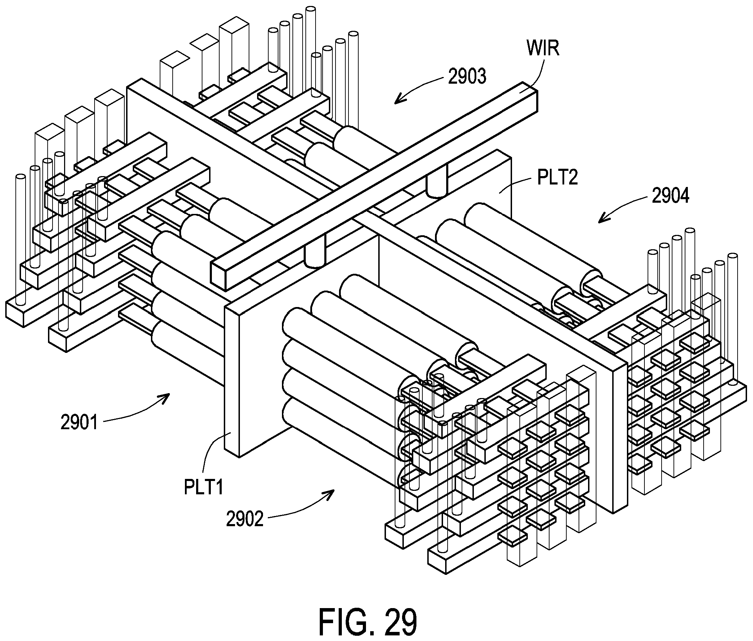

Referring to FIG. 29, FIG. 29 is a schematic diagram of a memory cell array structure of another embodiment of the disclosure. The memory cell array structure in FIG. 29 is formed of multiple memory cell array structures 2901 to 2904. The memory cell array structure in FIG. 29 is similar to the memory cell array structure in FIG. 28. The difference is that in FIG. 29, through the back end of line (BEoL) processing, a wire WIR may be formed between the common electrode plates PLT1 and PLT2 to electrically couple the common electrode plates PLT1 and PLT2. In this way, the common electrode plates PLT1 and PLT2 may receive the same reference voltage through the wire WIR, reducing the complexity of the wiring of the memory cell array structure.

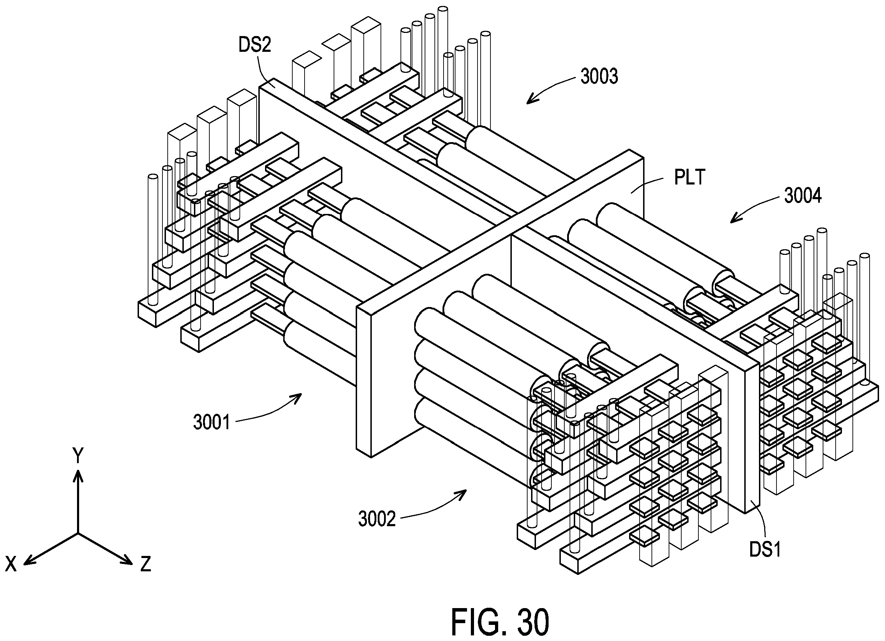

Referring to FIG. 30, FIG. 30 is a schematic diagram of a memory cell array structure of another embodiment of the disclosure. The memory cell array structure in FIG. 30 is formed of multiple memory cell array structures 3001 to 3004. The memory cell array structure in FIG. 30 is similar to the memory cell array structure in FIG. 29. The difference is that in FIG. 30, the common electrode plate PLT is formed after the dielectric spacer, and the dielectric spacer may be divided into two dielectric spacers DS1 and DS2. In this case, the memory cell array structures 3001 to 3004 may share the same common electrode plate PLT, and no additional wires are required for connection between the common electrode plates.

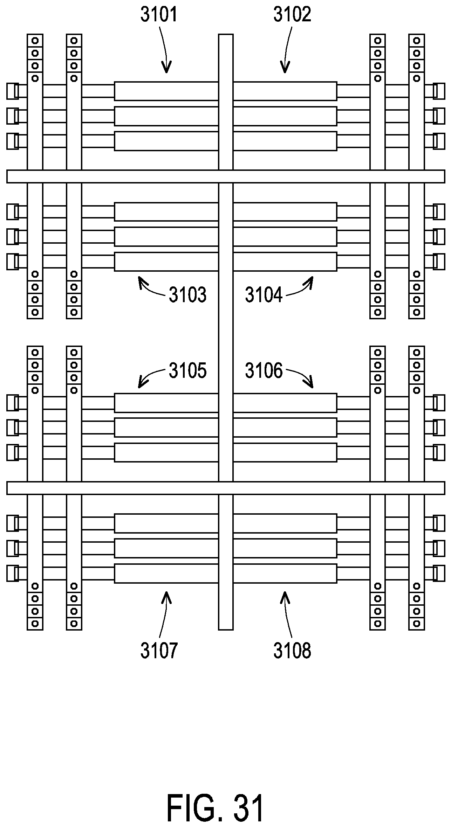

Referring to FIG. 31, FIG. 31 is a schematic diagram of a memory cell array structure of another embodiment of the disclosure. The memory cell array structure in FIG. 31 is formed of multiple memory cell array structures 3101 to 3108. The memory cell array structures 3101 to 3104 may be constructed in the manner of the embodiment shown in FIG. 29 or FIG. 30. The memory cell array structures 3105 to 3108 may be constructed by mirroring the memory cell array structures 3101 to 3104.

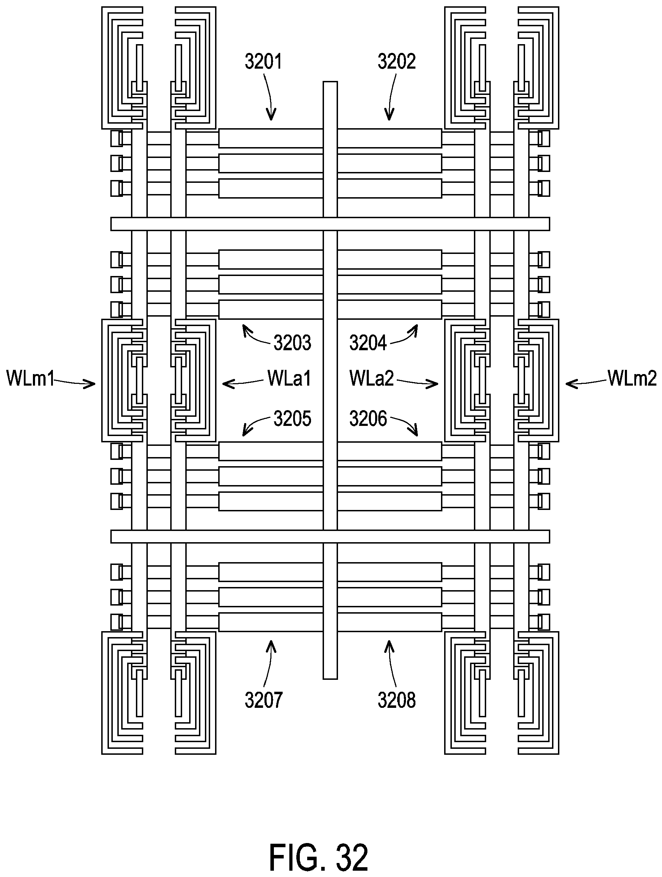

Referring to FIG. 32, FIG. 32 is a schematic diagram of a memory cell array structure of another embodiment of the disclosure. The memory cell array structure in FIG. 32 is formed of multiple memory cell array structures 3201 to 3208. The arrangement of the memory cell array structures 3201 to 3208 is similar to the embodiment in FIG. 31. The point is that, through the mirror arrangement structure, in this embodiment, the adjacently arranged memory cell array structures 3203 and 3025 may share the same primary word line WLm1 and auxiliary word line WLal, and the adjacently arranged memory cell array structures arranged adjacently memory cell array structures 3204 and 3026 may share the same primary word line WLm2 and auxiliary word line WLa2, which is beneficial to the control operation of the word line signal. In this embodiment, the routing of the BEoL metal to share the primary word line and auxiliary word line is demonstrated as U-shape wiring. And the routing for primary word line is mirror symmetric with the routing for auxiliary word line. In other embodiments, the shape of routing is not limit thereto.

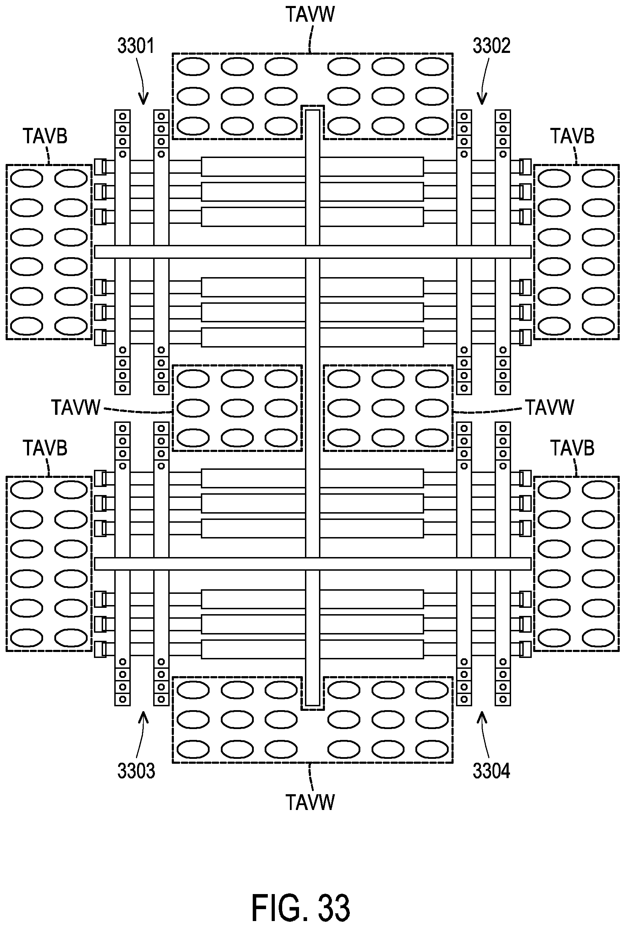

Referring to FIG. 33, FIG. 33 is a schematic diagram of a memory cell array structure of another embodiment of the disclosure. FIG. 33 is an implementation example of a metal oxide semiconductor field effect transistor under array (CMOS under array, CuA) manufacturing process. The memory cell array structure in FIG. 33 is formed of memory cell array structures 3301 to 3304. Multiple conductive array vias TAVW and TAVB may be disposed around and in the space between the memory cell array structures 3301 to 3304. The conductive array via TAVW is the medium electrically coupling the word line (including the primary word line and the auxiliary word line) and the memory cell array structures 3301 to 3304, and the conductive array via TAVB is the medium electrically coupling the bit line and the memory cell array structures 3301 to 3304. In this embodiment, the conductive array vias TAVW may be disposed adjacent to the capacitors in the memory cell array structures 3301 to 3304, thereby obtaining higher spacial efficiency. In this embodiment, both the conductive array vias TAVW and TAVB may be disposed in a free space in the wafer without increasing the layout area.

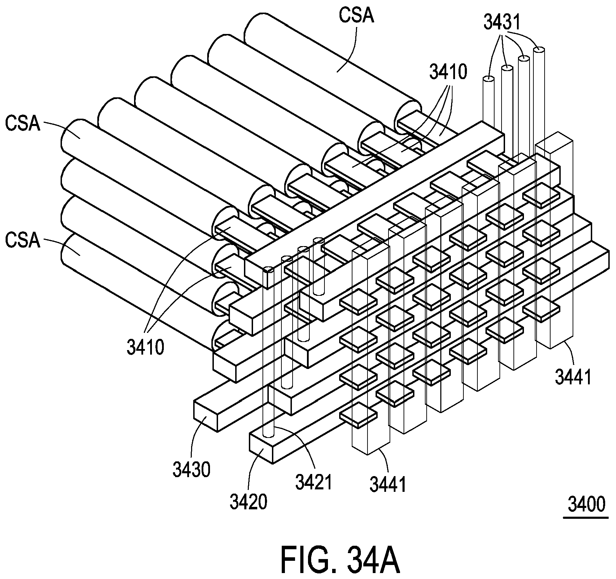

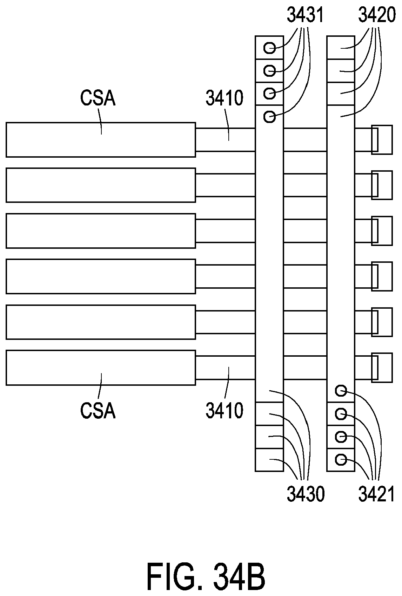

Referring to FIG. 34A and FIG. 34B, FIG. 34A is a three-dimensional diagram of a memory cell array structure of another embodiment of the disclosure. FIG. 34B is a top view of the memory cell array structure of FIG. 34A. The memory cell array structure 3400 includes multiple capacitors CSA, channel pillars 3410, a first conductive structure 3420, a second conductive structure 3430, and multiple conductive plugs 3421, 3431, and 3441. The difference from the previous embodiments is that in this embodiment, the conductive plugs 3421 electrically coupled to the first conductive structure 3420 and the conductive plugs 3431 electrically coupled to the second conductive structure 3430 may be formed on different sides. In this way, the layout complexity of the word lines of the memory cell array structure 3400 may be effectively reduced.

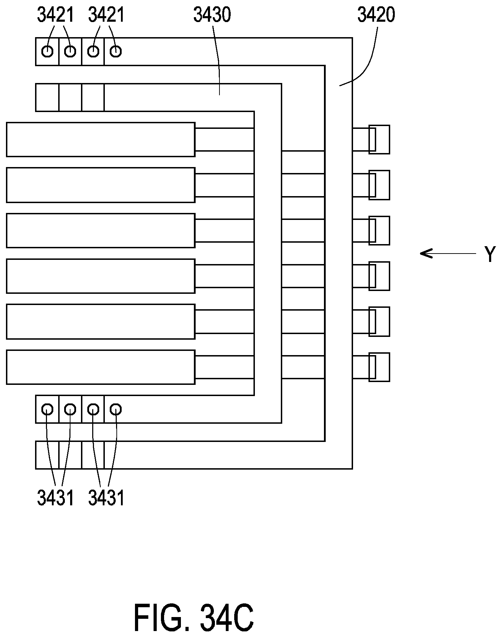

Referring to FIG. 34C, FIG. 34C is a view of another implementation of the memory cell array structure of FIG. 34A. In FIG. 34C, the first conductive structure 3420 and the second conductive structure 3430 may be further extended into a U-shape, and extend on two sides of the capacitor CSA along the extension direction of the capacitor CSA (e.g., the Y-axis direction). In this way, the conductive plugs 3431 and the conductive plugs 3421 may be formed on two symmetrical sides of the capacitor CSA, and the integration density in the Y-axis direction may be increased.

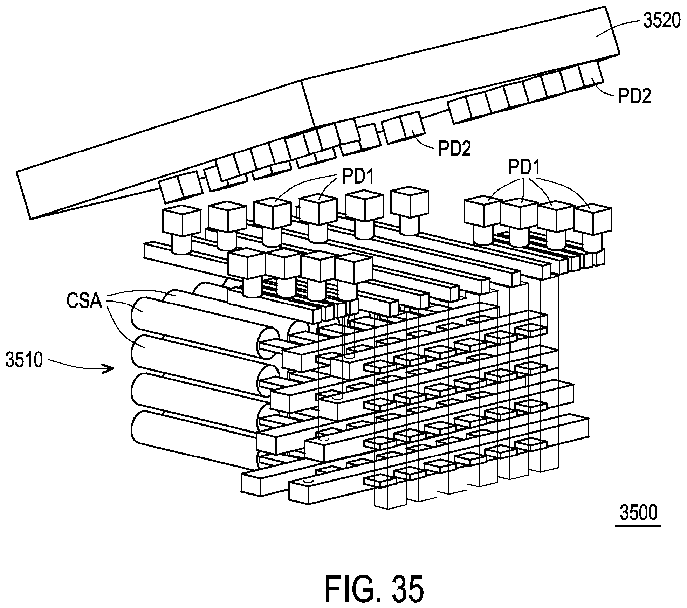

Referring to FIG. 35, FIG. 35 is a schematic diagram of a memory device of another embodiment of the disclosure. The memory device 3500 includes a wafer 3520 and a memory cell array structure 3510. Multiple pads PD1 may be formed on the word lines and bit lines of the memory cell array structure 3510. Multiple pads PD2 may be formed on the surface of the wafer 3520. The wafer 3520 and the memory cell array structure 3510 may be electrically coupled to each other through a wafer bonding process by using the pads PD2 and PD1. The wafer 3520 is configured for disposing multiple peripheral circuits of the memory cell array structures 3510.

In this embodiment, the pad PD1 may be directly formed above the capacitor CSA in the memory cell array structure 3510 to improve spacial usage efficiency

Incidentally, the pads PD1 and PD2 may be copper pads.

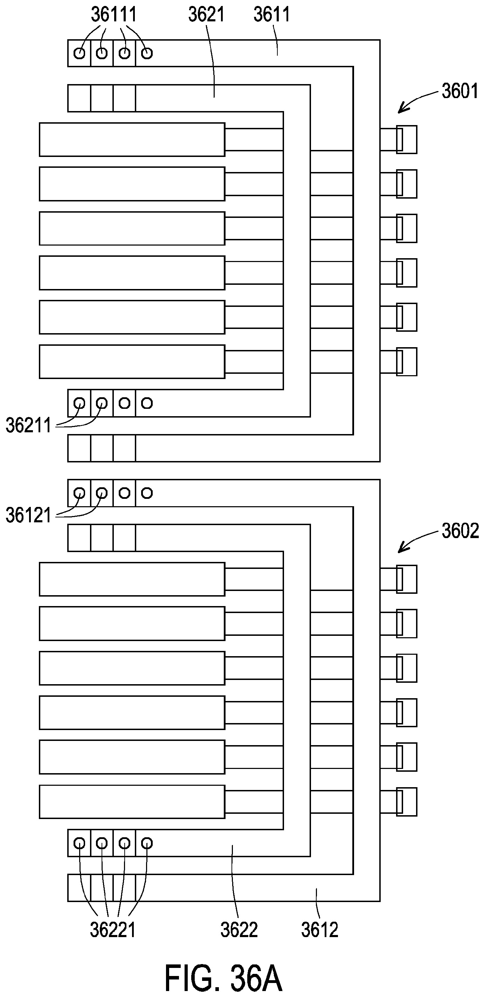

Referring to FIG. 36A to FIG. 36C, FIG. 36A to FIG. 36C are top views of a memory cell array structure of multiple embodiments of the disclosure. The memory cell array structure in FIG. 36A is formed of two memory cell array structures 3601 and 3602 arranged side by side. The structures of the memory cell array structures 3601 and 3602 are the same as the memory cell array structure 3400 shown in FIG. 34C, and the related details are not repeated herein.

It should be noted that in this embodiment, in the memory cell array structure 3601, the conductive plug 36111 electrically coupled to the first conductive structure 3611 may be formed on the first side (e.g., the upper side) of the memory cell array structure 3601, and the conductive plug 36211 electrically coupled to the second conductive structure 3621 may be formed on the second side (e.g., the lower side) of the memory cell array structure 3601. In the memory cell array structure 3602, the conductive plug 36121 electrically coupled to the first conductive structure 3612 may be formed on the first side (e.g., the upper side) of the memory cell array structure 3602, and the conductive plug 36221 electrically coupled to the second conductive structure 3622 may be formed on the second side (e.g., the lower side) of the memory cell array structure 3602. Through such an arrangement, there may be a gap between the conductive plugs 36211 and 36121 formed by the first conductive structure 3611, they may not be directly adjacent to each other.

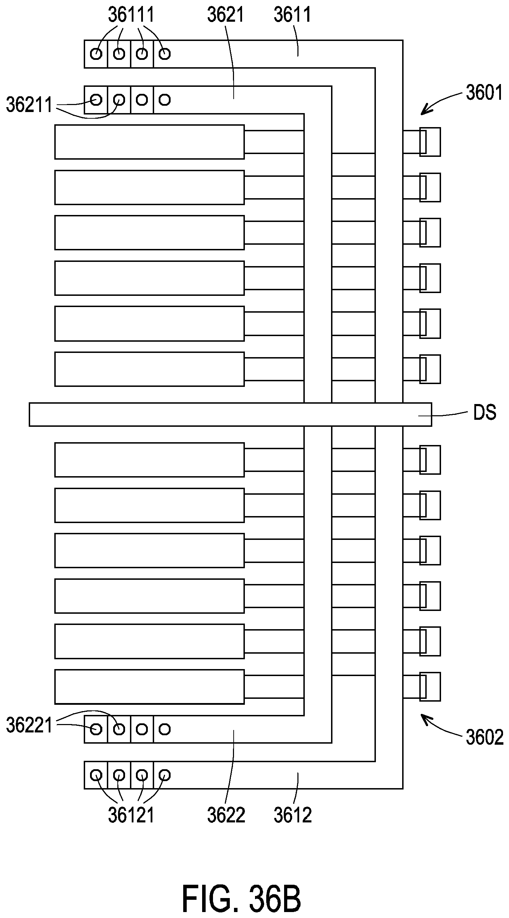

FIG. 36B is also formed of memory cell array structures 3601 and 3602 with the same structure arranged side by side. The memory cell array structures 3601 and 3602 are isolated from each other through a dielectric spacer DS. Under such an arrangement, the first conductive structure 3611 and the second conductive structure 3621 in the memory cell array structure 3601 have a stepped structure on the first side (upper side), and the first conductive structure 3612 and the second conductive structure 3622 in the memory cell array structure 3602 have a stepped structure on the second side (lower side). The conductive plugs 36111 and 36211 for electrically coupling to the word line are respectively electrically coupled to the stepped structures of the first conductive structure 3611 and the second conductive structure 3621, and the conductive plugs 36121 and 36221 for electrically coupling to the word line are respectively electrically coupled to the stepped structures of the first conductive structure 3612 and the second conductive structure 3622. In this embodiment, the step structures are formed in the same time, then the dielectric spacer DS separate the step structures and form the first conductive structures 3611, 3612 and the second conductive structure 3621, 3622. The process complexity is significantly reduced.

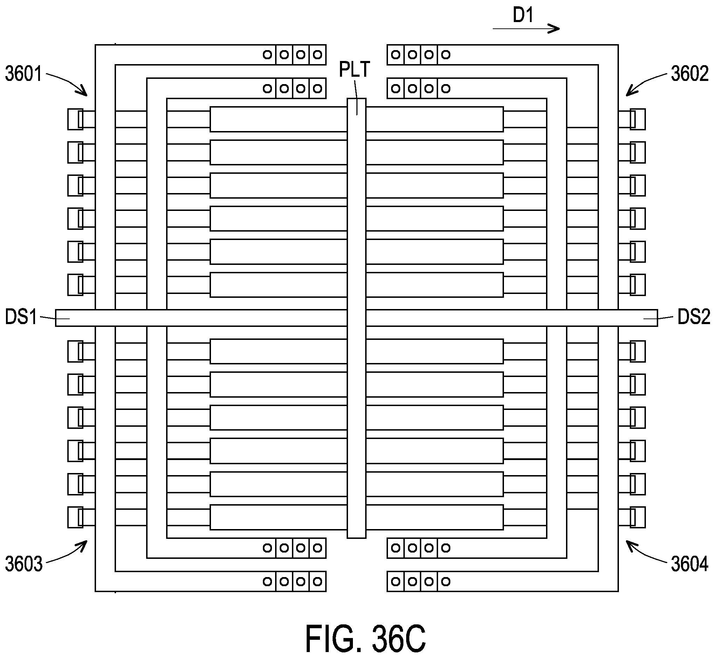

FIG. 36C is formed of four memory cell array structures 3601 to 3604 with the same structure arranged in an array. In this embodiment, the memory cell array structures 3601 and 3603 are arranged side by side and isolated from each other through the dielectric spacer DS1. The memory cell array structures 3602 and 3604 are arranged side by side and isolated from each other through the dielectric spacer DS2. In addition, the memory cell array structures 3601 and 3602 extend along the same first direction D1 and are respectively electrically coupled to two sides of the common electrode plate PLT. The memory cell array structures 3603 and 3604 extend along the same first direction D1 and are respectively electrically coupled to two sides of the common electrode plate PLT.

In this embodiment, the extension direction of the common electrode plate PLT may be orthogonal to the direction D1, and the dielectric spacers DS1 and DS2 may extend along the direction D1.

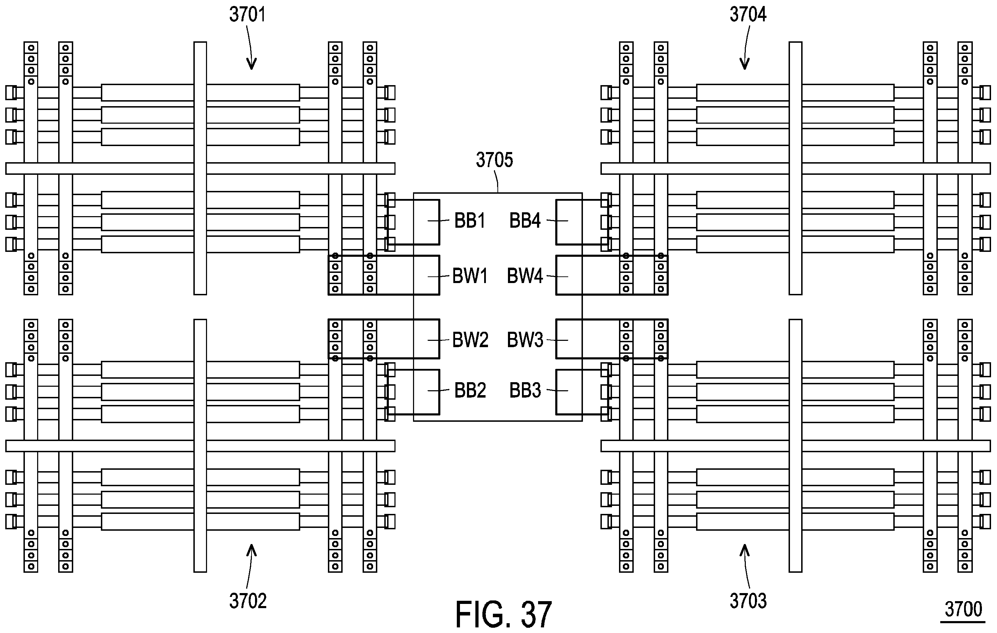

Referring to FIG. 37, FIG. 37 is a top view of a memory device of another embodiment of the disclosure. The memory device 3700 includes multiple memory cell array structures 3701 to 3704 and a peripheral circuit 3705. In this embodiment, the memory cell array structures 3701 to 3704 share the peripheral circuit 3705. The memory cell array structures 3701 to 3704 are disposed around the peripheral circuit 3705. The sensing amplifiers may be disposed in the peripheral circuit 3705, and adjacent to the bit lines of the memory cell array structures 3701 to 3704.

The peripheral circuit 3705 may have related circuits respectively corresponding to multiple sensing amplifiers of the memory cell array structures 3701 to 3704. The peripheral circuit 3705 is respectively electrically coupled to the bit lines of the memory cell array structures 3701 to 3704 through the bit line buses BB1 to BB4, and is respectively electrically coupled to the word lines of the memory cell array structures 3701 to 3704 through the word line buses WB1 to WB4. The peripheral circuit 3705 may be adjacently disposed to the stepped structure of the conductive structure of the memory cell array structures 3701 to 3704, which may effectively reduce the required the wire length of the bit line buses BB1 to BB4 and the word line buses WB1 to WB4. Moreover, by disposing the memory cell array structures 3701 to 3704 symmetrically to the peripheral circuit 3705, the consistency of the wire lengths of the bit line buses BB1 to BB4 and the word line buses WB1 to WB4 may be improved, and the transmission time difference of the transmitted bit line signal and word line signal may be normalized.

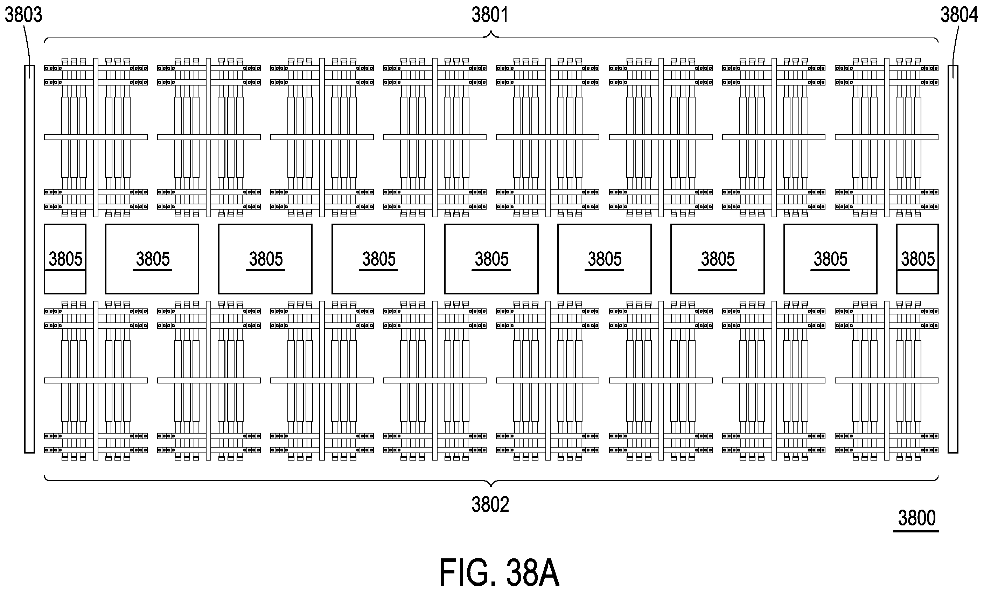

Referring to FIG. 38A, FIG. 38A is a top view of a memory device of another embodiment of the disclosure, which is a continuation of the embodiment of FIG. 37. The memory device 3800 in FIG. 38A may be an extended version of the embodiment in FIG. 37. The memory device 3800 has multiple memory cell array structures 3801 and 3802, multiple peripheral circuits 3805, and addressing circuits 3803 and 3804. The peripheral circuits 3805 may be arranged in a row and disposed in the middle of the memory device 3800. The memory cell array structure 3801 is arranged in a row and disposed on the first side (upper side) of the peripheral circuit 3805. The memory cell array structure 3802 is arranged in another row and disposed on the second side (lower side) of the peripheral circuit 3805.

The addressing circuits 3803 and 3804 are respectively disposed on the opposing third side and fourth side of the memory device 3800.

In this embodiment, a peripheral circuit 3805 may be shared by the four surrounding memory cell array structures 3801 and 3802, and the relevant details are the same as the embodiment in FIG. 37. The addressing circuits 3803 and 3804 may control the operation of all circuits on each peripheral circuit 3805. The transmission path of address information may be formed between the addressing circuits 3803 and 3804, and is configured to transmit global address information.

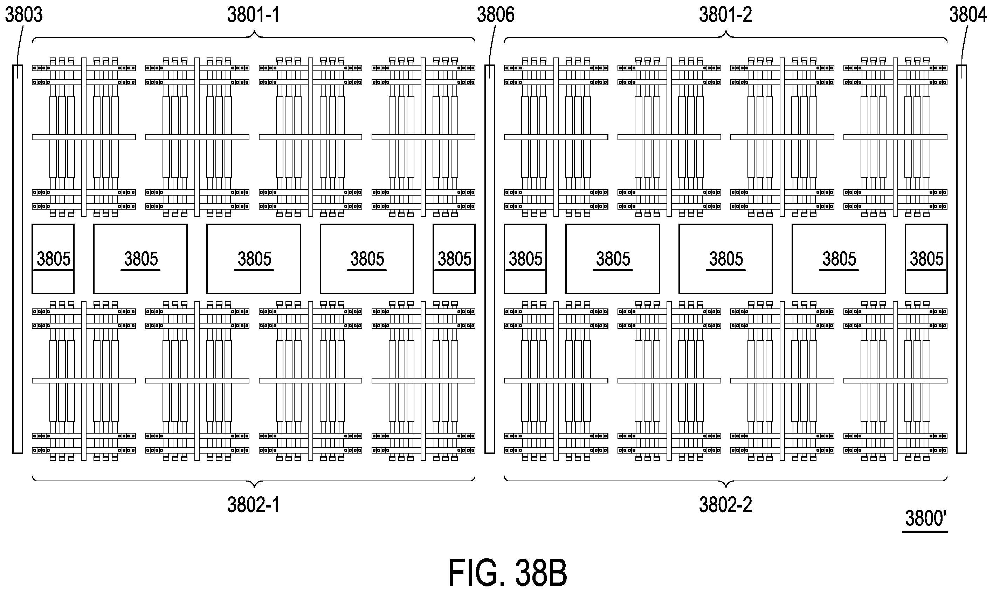

Referring to FIG. 38B, FIG. 38B is a top view of a memory device of another embodiment of the disclosure. In FIG. 38B, compared with FIG. 38A, the memory device 3800' may further have an addressing circuit 3806 disposed in the middle of the memory device 3800', and divide the memory cell array structure arranged in a row into multiple memory cell array structures 3801-1, 3801-2, 3802-1, and 3802-2. Similarly, the peripheral circuit 3805 may also be divided into two portions by the addressing circuit 3806. In this embodiment, a first address information transmission path may be generated between the addressing circuits 3803 and 3806, and a second address information transmission path may be generated between the addressing circuits 3804 and 3806. It may be clearly seen from FIG. 38B that compared with the embodiment in FIG. 38A, the length of the address information transmission path may be effectively shortened.

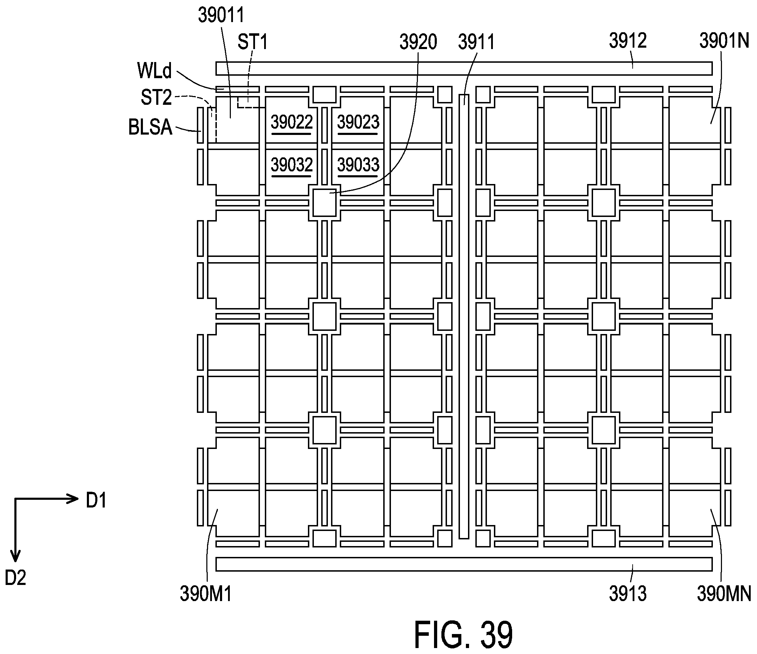

Referring to FIG. 39, FIG. 39 is a layout structure schematic diagram of a memory device of another embodiment of the disclosure. The memory device 3900 includes multiple memory cell array structures 39011 to 390MN, addressing circuits 3911 to 3913, multiple bit line sensing amplifiers BLSA, multiple word line drivers WLd, and multiple control circuits 3920. The memory cell array structures 39011 to 390MN are arranged in an array, the addressing circuits 3912 and 3913 are respectively disposed on two sides (e.g., the upper and lower sides) of the array formed by the memory cell array structures 39011 to 390MN, and the addressing circuits 3912 and 3913 extend along the direction D1. The addressing circuit 3911 is disposed at the center of the array formed by the memory cell array structures 39011 to 390MN, and extends along the direction D2. The direction D1 is orthogonal to the direction D2.

Regarding the arrangement of the bit line sensing amplifier BLSA and the word line driver WLd, the memory cell array structure 39011 is used as a reference here. The memory cell array structure 39011 has connection structures ST1 and ST2. The connection structure ST1 is configured to electrically couple to the word line corresponding to the memory cell array structure 39011, and the connection structure ST2 is configured to electrically couple to the bit line corresponding to the memory cell array structure 39011. At least one of the connection structures ST1 and ST2 may be a stepped structure. The implementation details of the connection structure of the stepped structure on the memory cell array structure 39011 have been described in detail in the foregoing embodiments, and are not repeated herein.

Corresponding to the memory cell array structure 39011, the word line driver WLd may be adjacently disposed to the connection structure ST1, and the bit line sensing amplifier BLSA may be adjacently disposed to the connection structure ST2, which may effectively reduce the complexity of wiring and reduce the length required for wiring.

For the arrangement of bit line sensing amplifiers and word line drivers for each memory cell array structure 39011 to 390MN, reference may be made the arrangement of the above-mentioned memory cell array structure 39011, the bit line sensing amplifier BLSA, and the word line driver WLd, and are not repeated herein.

Through the above arrangement, there may be a blank region between the memory cell array structures 39022, 39023, 39032, and 39033, and may be used for disposing the control circuit 3920. In this embodiment, the control circuit 3920 may be a regional control circuit, and the addressing circuits 3911 to 3913 may be global addressing circuits.

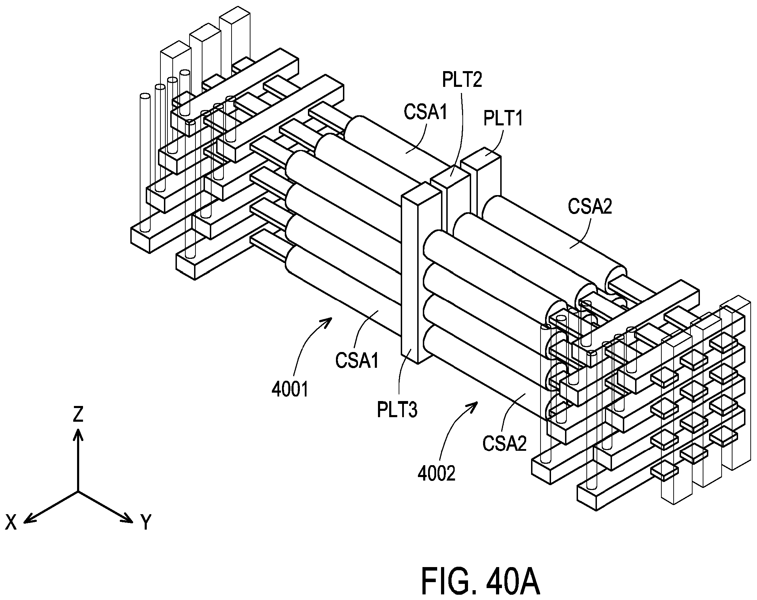

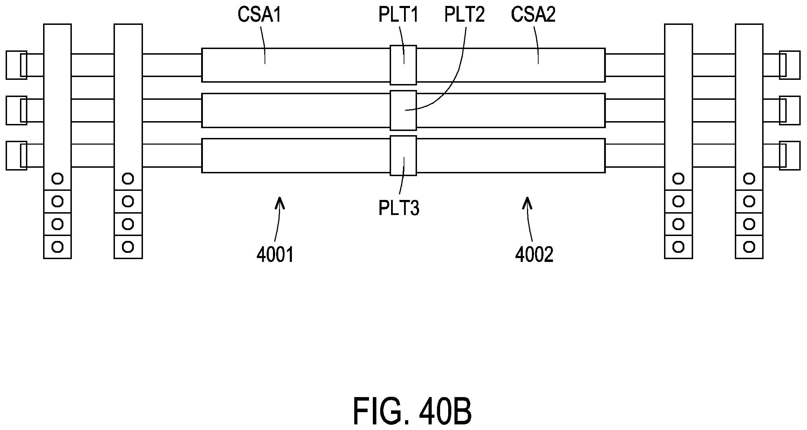

Referring to FIG. 40A and FIG. 40B, FIG. 40A is a three-dimensional diagram of a memory cell array structure of another embodiment of the disclosure. FIG. 40B is a top view of the memory cell array structure in the embodiment of FIG. 40A of the disclosure. In FIG. 40A, there are two memory cell array structures 4001 and 4002 integrated with each other. The structures of the memory cell array structures 4001 and 4002 are similar to the embodiment of FIG. 27, the difference is that in this embodiment, the memory cell array structures 4001 and 4002 are electrically coupled to multiple common electrode plates PLT1 to PLT3. Here, taking the Z-axis direction as the column direction and the X-axis direction as the row direction as an example, each of the common electrode plates PLT1 to PLT3 extends along the Z-axis direction. Each of the common electrode plates PLT1 to PLT3 may be electrically coupled to the capacitors CSA1 in the same column and the capacitors CSA2 in the same column in the memory cell array structures 4001 and 4002.

In this embodiment, the bit lines corresponding to the common electrode plates PLT1 to PLT3 have been divided into multiple portions. Under such an arrangement, the reference voltage lines (e.g., ground voltage transmission lines) of the common electrode plates PLT1 to PLT3 may be completed synchronously with the manufacturing process of the bit line, reducing the cost of the manufacturing process and effectively reducing the internal force generated by the imbalance of the channel pillars in the semiconductor structure. Besides, the multiple common electrode plates may be applied by different bias voltages, and the variability of manipulation of semiconductor structure can be increased.

In other embodiments of the disclosure, multiple ground voltage transmission lines corresponding to the common electrode plates PLT1 to PLT3 may be electrically coupled to each other.

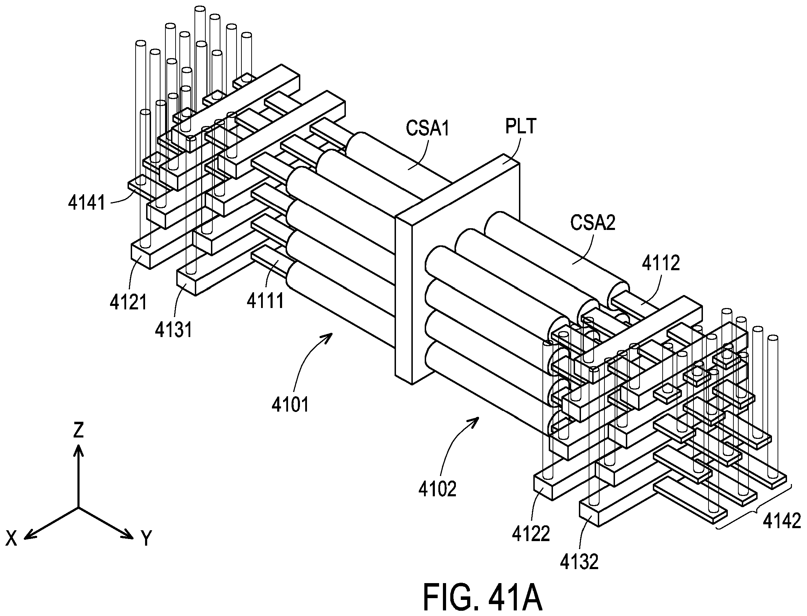

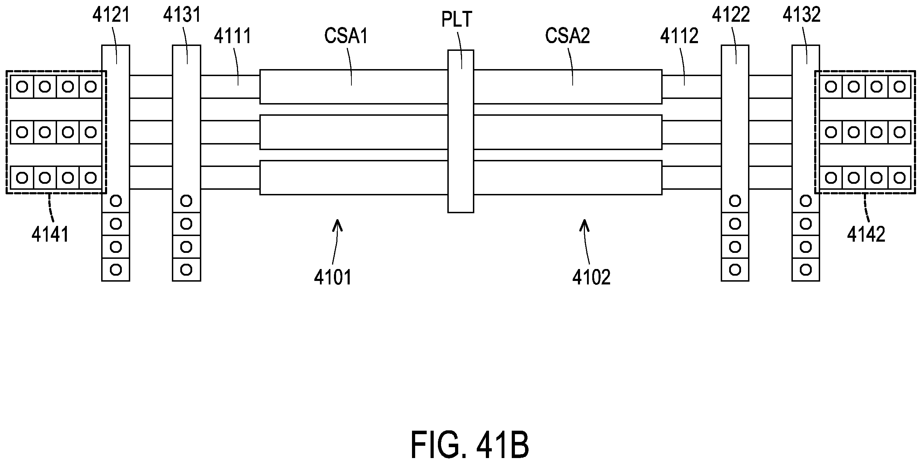

Referring to FIG. 41A and FIG. 41B, FIG. 41A is a three-dimensional diagram of a memory cell array structure of another embodiment of the disclosure. FIG. 41B is a top view of the memory cell array structure in the embodiment of FIG. 41A of the disclosure. In FIG. 41A, there are two memory cell array structures 4101 and 4102 integrated with each other. The memory cell array structure 4101 has capacitors CSA1, channel pillars 4111, a first conductive structure 4121, a second conductive structure 4131, and a third conductive structure 4141. The memory cell array structure 4102 has capacitors CSA2, channel pillars 4112, a first conductive structure 4132, a second conductive structure 4122, and a third conductive structure 4142. The capacitor CSA1 of the memory cell array structure 4101 and the capacitor CSA2 of the memory cell array structure 4102 are commonly electrically coupled to the common electrode plate PLT. The structures of the memory cell arrays 4101 and 4102 have been described in detail in the previous embodiments, and are not be repeated herein.

It is worth mentioning that in this embodiment, the first conductive structures 4121 and 4132, the second conductive structures 4131 and 4122, and the third conductive structures 4141 and 4142 may all be formed to have a stepped structure. Through this method, regardless of whether the channel pillars 4111 and 4112 are disposed at a high position or a low position, they may be directly connected to the corresponding bit lines through the conductive plugs from the stepped surfaces of the third conductive structures 4141 and 4142, which may effectively reduce the resistance-capacitance delay (RC delay) at the bit line end.

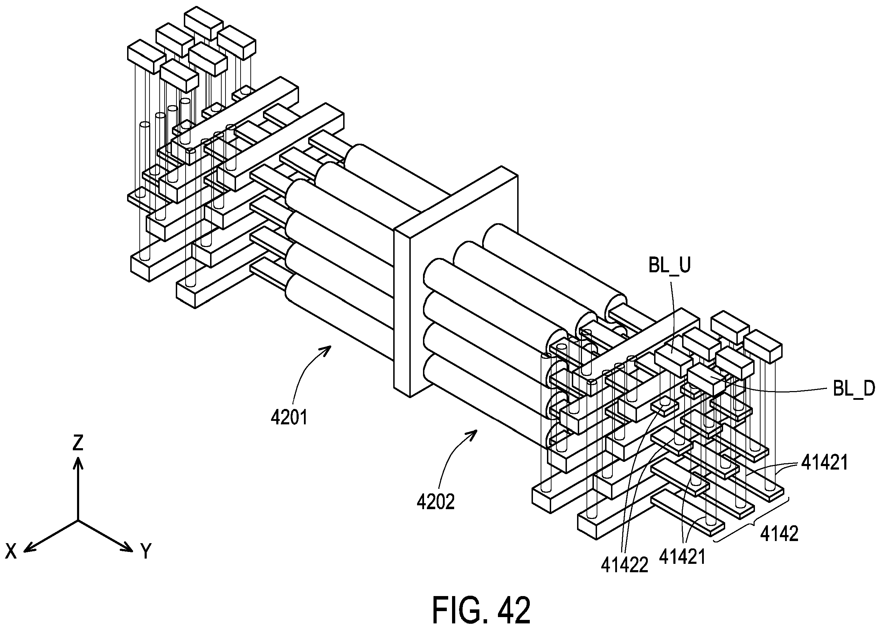

Referring to FIG. 42, FIG. 42 is a three-dimensional diagram of a memory cell array structure of another embodiment of the disclosure. In FIG. 42, there are two memory cell array structures 4201 and 4202 integrated with each other. The construction method of the memory cell array structures 4201 and 4202 is similar to the implementation in FIG. 41A, and is not repeated herein. It should be noted that in this embodiment, the memory cell array structure 4202 is taken as an example, in which the third conductive structure 4142 forms a stepped structure. The relatively lower step surface may be electrically coupled to the conductive plug 41421 and electrically coupled to the bit line BL_D through the conductive plug 41421. The relatively higher step surface may be electrically coupled to the conductive plug 41422 and electrically coupled to the bit line BL_U through the conductive plug 41422. In an embodiment of the disclosure, the bit lines BL_D and BL_U may be commonly electrically coupled to a primary bit line.

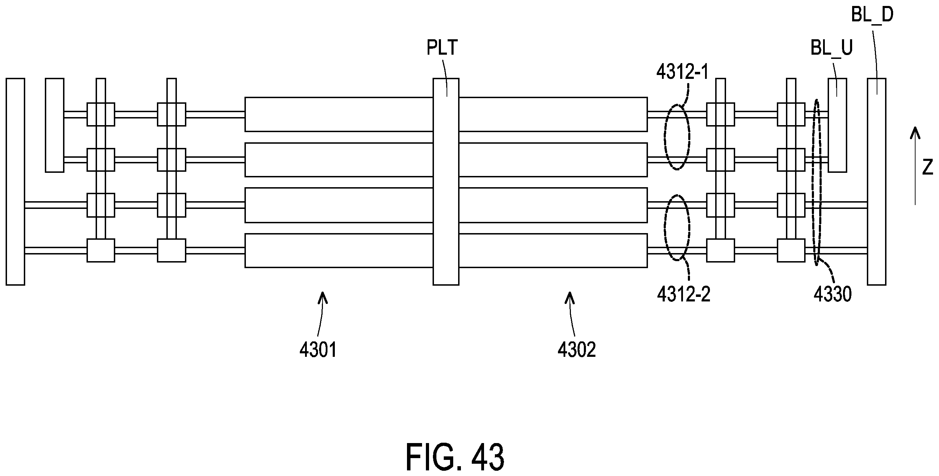

Referring to FIG. 43, FIG. 43 is a cross view of a memory cell array structure of another embodiment of the disclosure. In FIG. 43, there are two memory cell array structures 4301 and 4302 integrated with each other. Taking the memory cell array structure 4302 as an example, the stepped third conductive structure 4330 of the memory cell array structure 4302 may be directly electrically coupled to the bit lines BL_U and BL_D extending along the Z-axis direction. In this embodiment, the channel pillar 4132-1 disposed at a relatively high level is electrically coupled to the bit line BL_U, and the channel pillar 4132-2 disposed at a relatively low level is electrically coupled to the bit line BL_D. The bit lines BL_U and BL_D may be formed through an epitaxy growth process.

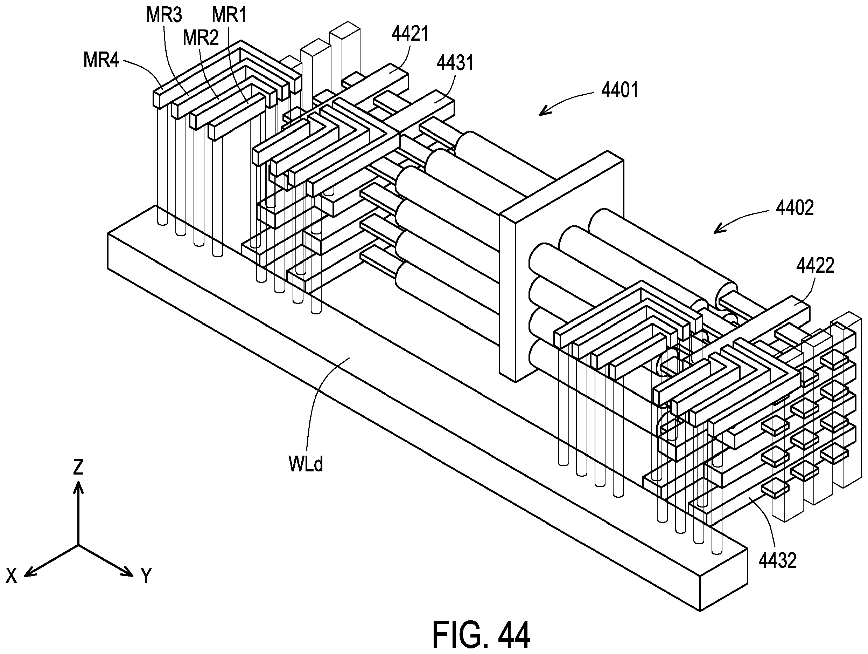

Referring to FIG. 44, FIG. 44 is a three-dimensional diagram of a memory cell array structure of another embodiment of the disclosure. In FIG. 44, there are two memory cell array structures 4401 and 4402 integrated with each other. The memory cell array structures 4401 and 4402 are electrically coupled to the word line driver WLd. In this embodiment, taking the memory cell array structure 4401 as an example, the first conductive structure 4421 with a stepped structure may be electrically coupled to the transmission wires MR1 to MR4 through the conductive plugs, and may be electrically coupled to the primary word line through the transmission wires MR1 to MR4. The differences in the high and low levels of multiple first conductive structures 4421 result in unequal lengths of the conductive plugs correspondingly electrically coupled to the high and low levels of the first conductive structures 4421. Therefore, in the embodiment of the disclosure, through arrangement, the lowest level first conductive structure 4421 is electrically coupled to the shortest transmission wire MR1; the second-lowest level first conductive structure 4421 is electrically coupled to the second-shortest transmission wire MR2; the second-highest level first conductive structure 4421 is electrically coupled to the second-longest transmission wire MR3; the highest level first conductive structure 4421 may be electrically coupled to the longest transmission wire MR4.

Through the above arrangement, the RC delay encountered in the word line signal transmission process may be uniformed.

In addition, in the memory cell array structures 4401 and 4402, the connection methods between the second conductive structures 4431 and 4422 and the first conductive structures 4421 and the auxiliary word lines and the primary word lines may also be carried out through the above-mentioned method to improve the stability of signal transmission in terms of transmission time.

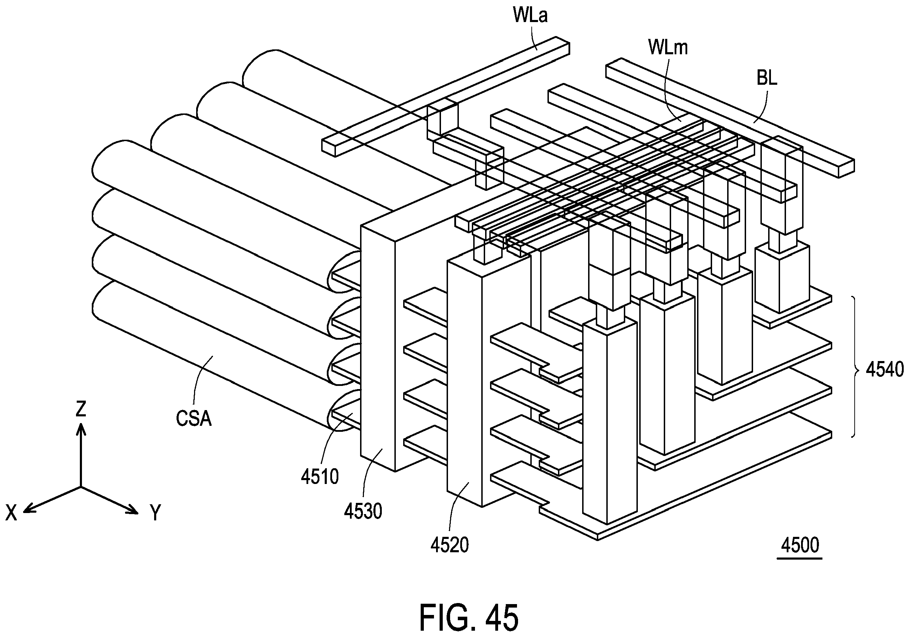

Referring to FIG. 45, FIG. 45 is a three-dimensional diagram of a memory cell array structure of another embodiment of the disclosure. The memory cell array structure 4500 includes multiple capacitors CSA, multiple channel pillars 4510, multiple first conductive structures 4520, a single second conductive structure 4530, and multiple third conductive structures 4540. The memory cell array structure 4500 of this embodiment has a similar structure to the memory cell array structure 500 in FIG. 5A. The difference is that there is only one second conductive structure 4530 in the memory cell array structure 4500. The second conductive structure 4530 surrounds all the channel pillars 4510 and is electrically coupled to a common auxiliary word line WLa. In this embodiment, the auxiliary transistors in all the memory cell circuits corresponding to all the channel pillars 4510 may be turned on or off at the same time.

In addition, the first conductive structure 4520 may be respectively electrically coupled to multiple primary word lines WLm, and the third conductive structure 4540 is respectively electrically coupled to multiple bit lines BL.

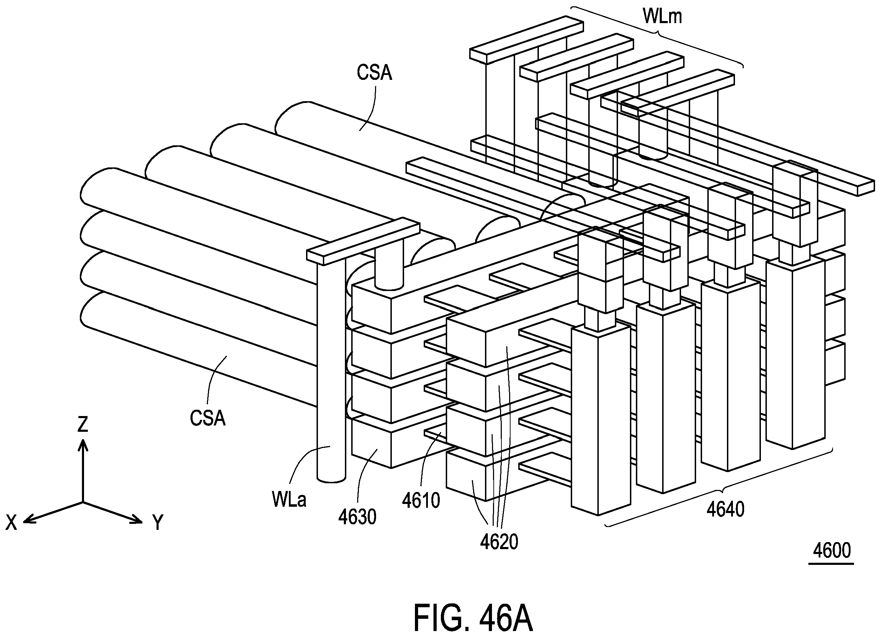

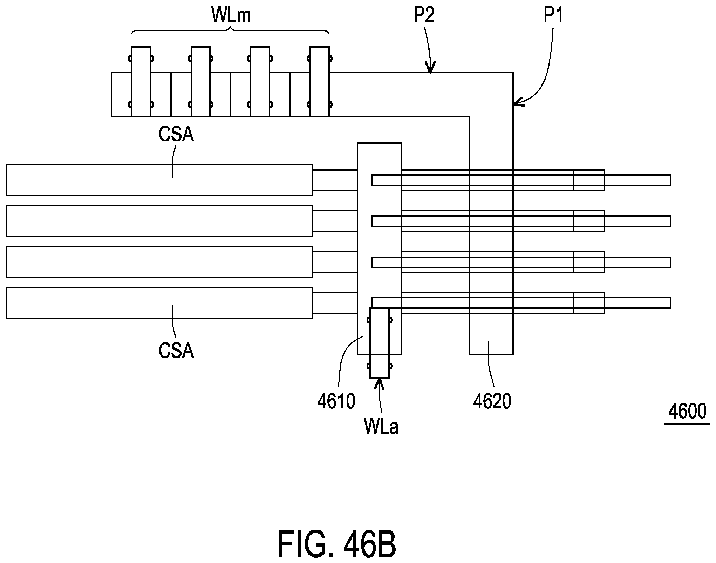

Referring to FIG. 46A and FIG. 46B, FIG. 46A is a three-dimensional diagram of a memory cell array structure of another embodiment of the disclosure. FIG. 46B is a top view of the memory cell array structure in the embodiment of FIG. 46A. The memory cell array structure 4600 includes multiple capacitors CSA, multiple channel pillars 4610, multiple first conductive structures 4620, a single second conductive structure 4630, and multiple third conductive structures 4640. The single second conductive structure 4630 surrounds all the channel pillars 4610 and is electrically coupled to a common auxiliary word line WLa.

Different from the foregoing embodiments, the first conductive structures 4620 in this embodiment may be L-shaped structures. The first portion P1 of the first conductive structure 4620 extends along the X-axis direction, and the second portion P2 of the first conductive structure 4620 extends to the side of the memory cell array structure 4600 along the Y-axis direction. The second portion P2 of the first conductive structure 4620 may be electrically coupled to multiple primary word lines WLm.

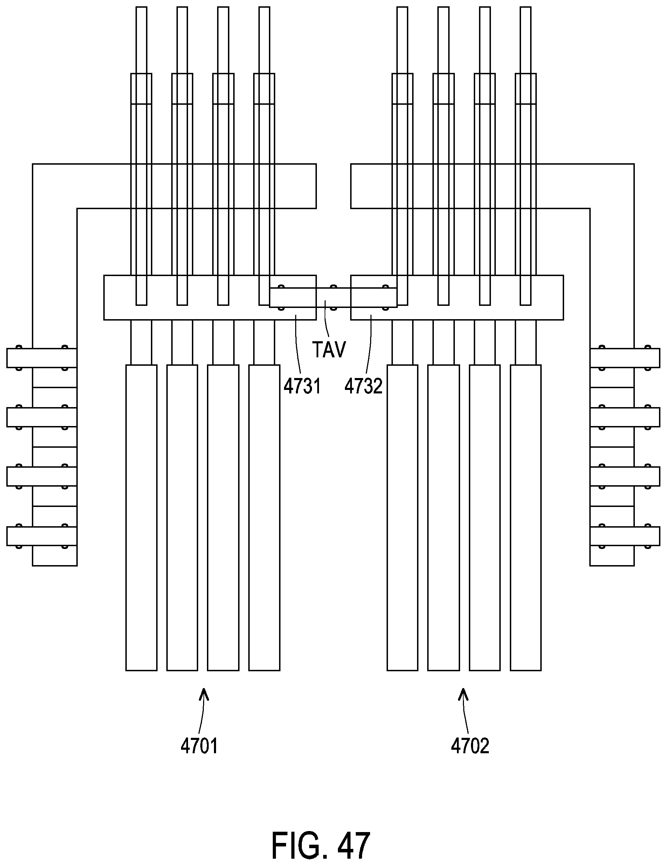

Referring to FIG. 47, FIG. 47 is a top view of a memory cell array structure of another embodiment of the disclosure. There are two memory cell array structures 4701 and 4702 in FIG. 47. Each of the memory cell array structures 4701 and 4702 has a structure similar to that of the memory cell array structure 4600. The second conductive structure 4731 on the memory cell array structure 4701 may be electrically coupled with the second conductive structure 4732 on the memory cell array structure 4702 through a BEoL metal layer, and the conductive array via TAV is electrically coupled to the BEoL metal layer then used to transmit the bias to the second conductive structure 4731 and 4732 in the same time.

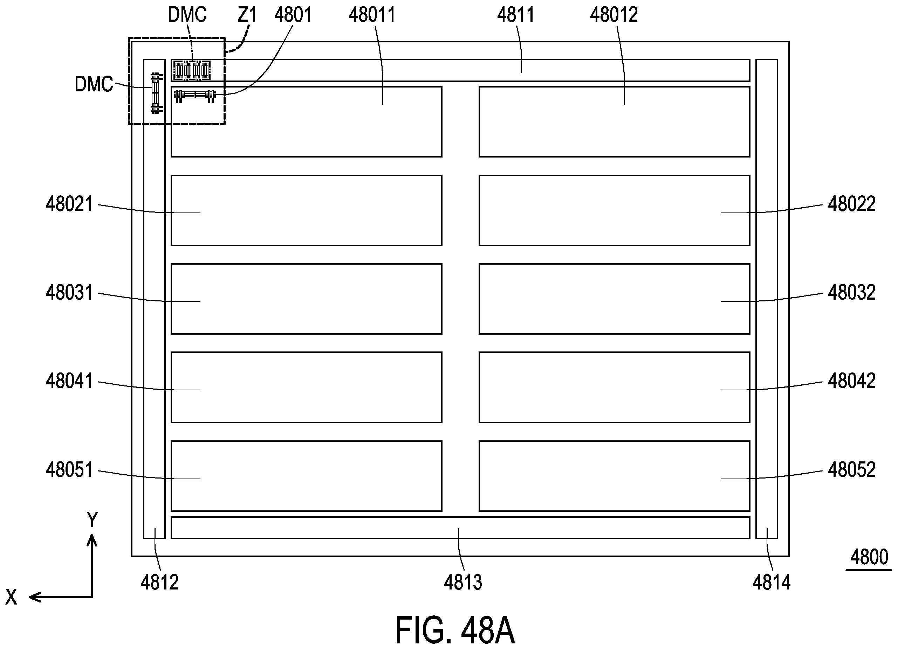

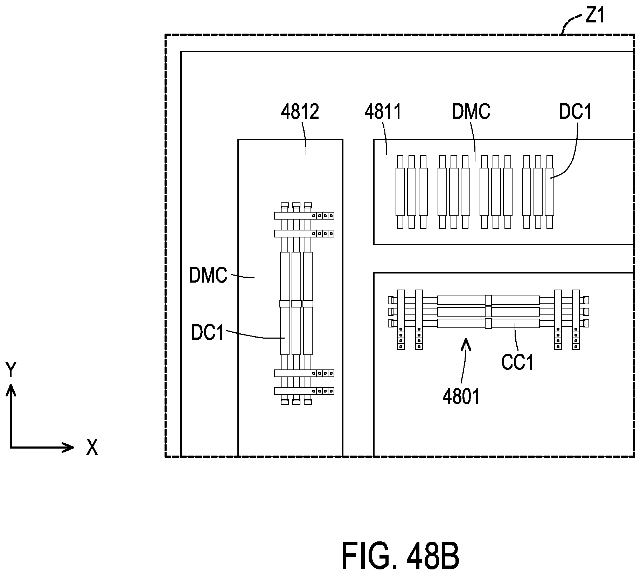

Referring to FIG. 48A and FIG. 48B, FIG. 48A is a schematic diagram of a memory chip of an embodiment of the disclosure. FIG. 48B is a partially enlarged schematic diagram of the region Z1 of the memory chip of FIG. 48A. In FIG. 48A, a memory chip 4800 has multiple memory cell blocks 48011 to 48052 arranged in an array. In each memory cell block 48011 to 48052, there are multiple three-dimensional stacked memory cell array structures 4801. The memory cell array structure 4801 in this embodiment may be any one of the aforementioned multiple embodiments, and there is no specific limitation. As shown in FIG. 48B, the capacitor CC1 on the memory cell array structure may extend along the X-axis direction. On the memory chip 4800, multiple buffer regions 4811 to 4814 are additionally disposed. There may be multiple dummy circuits DMC in any one of the buffer regions 4811 to 4814, in which the dummy circuits at least include a capacitor DC1 extending along the Y-axis direction, as shown in FIG. 48B. The buffer regions 4811 to 4814 may be disposed on the dicing lanes of the memory chip 4800. By disposing the capacitor DC1 extended along the Y-axis, can be used to balance stress generated during manufacturing process of the entire memory chip, and avoid defects in channel pillars of the memory cell block due to the unbalance stress. The dummy circuits DMC mentioned above can be manufactured simultaneously with the memory cell array structures in the memory cell blocks 48011 to 48052.

The present invention also includes an electronic terminal device, wherein the electronic terminal device includes the aforementioned memory cell circuit. The electronic terminal devices can be solid state drives (Solid-State-Drive, SSD), personal computers, laptops, tablets, digital cameras, USB (Universal Serial Bus), smart phones, personal navigation devices, game consoles, e-books, servers, or IoT (Internet of Thing) devices, etc.

To sum up, in the memory cell circuit of the disclosure, an auxiliary transistor is arranged between the capacitor and the primary transistor. By applying different bias voltages to the main and auxiliary transistors, the gate induced drain leakage (GIDL) that may occur may be effectively reduced.

## Claims

1. A memory cell circuit (100, MC1-MC4), comprising:
a first transistor (M1), having a first end electrically coupled to a bit line (BL), wherein a gate of the first transistor (M1) is electrically coupled to a primary word line (WLm);
a second transistor (M2), having a first end electrically coupled to a second end of the first transistor (M1), wherein a gate of the second transistor (M2) is electrically coupled to an auxiliary word line (WLa);
a capacitor (CS, CS1-CS4, CSA, CSA1, CSA2, DC1) having an end electrically coupled to a second end of the second transistor (M2), wherein another end of the capacitor is configured to receive a reference voltage, wherein the gate of the first transistor (M1) is configured to receive a first bias voltage, and the gate of the second transistor (M2) is configured to receive a second bias voltage, wherein the second bias voltage is greater than the first bias voltage;
a channel pillar (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200);
a first conductive structure (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), surrounding the channel pillar and forming the gate of the first transistor (M1), wherein the first conductive structure is electrically coupled to the primary word line (WLm, WLm1, WLm2); and
a second conductive structure (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), surrounding the channel pillar and forming the gate of the second transistor (M2),
wherein the second conductive structure is electrically coupled to the auxiliary word line (WLa, WLal, WLa2), wherein there is a spacing (SPC) between the first conductive structure and the second conductive structure; wherein
the capacitor is electrically coupled to an end of the channel pillar adjacent to the second conductive structure;
wherein the memory cell circuit (100, MC1-MC4) is **characterized in that**
the capacitor (CS, CS1-CS4, CSA, CSA1, CSA2, DC1) comprises:
a plurality of external conductive films (CC2, CC3, CC4, 1210, 1220), wherein one end of each of the external conductive films (CC2, CC3, CC4, 1210, 1220) is electrically coupled to a common electrode plate (PLT, PLT1-PLT8);
a plurality of internal conductive films (CC1, CC5, 1240), wherein each of the internal conductive films (CC1, CC5, 1240) is disposed between two adjacent ones of the external conductive films (CC2, CC3, CC4, 1210, 1220); and
a plurality of dielectric layers (CI1-CI4, 1230, ILD1, ILD2, ILD), formed between each of the external conductive films (CC2, CC3, CC4, 1210, 1220) and each adjacent ones of the internal conductive films (CC1, CC5, 1240).

2. The memory cell circuit (100, MC1-MC4) according to claim 1, further comprising:
a first gate oxide layer (321), formed between the first conductive structure and the channel pillar; and
a second gate oxide layer (331), formed between the second conductive structure and the channel pillar.

3. A memory cell array structure (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801), comprising:
a plurality of memory cell circuits as claimed in claim 1, and the memory cell array structure comprises:
a plurality of the channel pillars (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200), arranged in an array to form a plurality of channel pillar rows and a plurality of channel pillar columns;
a plurality of the first conductive structures (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), respectively electrically coupled to the channel pillar rows or the channel pillar columns, and each of the first conductive structures surrounding a first portion of the channel pillars in each of the channel pillar rows or each of the channel pillar columns, wherein each of the first conductive structures forms a common gate of a plurality of first transistors (M11-M41) in each of the channel pillar rows or each of the channel pillar columns;
one or a plurality of the second conductive structures (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), respectively electrically coupled to the channel pillar rows or the channel pillar columns, and each of the second conductive structures surrounding a second portion of the channel pillars in each of the channel pillar rows or each of the channel pillar columns, wherein each of the second conductive structures forms a common gate of a plurality of second transistors (M12-M42) in each of the channel pillar rows or each of the channel pillar columns, wherein there is a spacing distance (P1, P2) between the first portion and the second portion; and
a plurality of the capacitors, respectively electrically coupled to end portions of channel pillars adjacent to the second conductive structures.

4. The memory cell array structure according to claim 3, wherein the first conductive structures are respectively electrically coupled to a plurality of primary word lines (WLm, WLm1, WLm2), and the second conductive structures are respectively electrically coupled to a plurality of auxiliary word lines (WLa, WLal, WLa2).

5. The memory cell array structure according to claim 3, further comprising:
a plurality of third conductive structures (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), respectively electrically coupled to the channel pillar columns or the channel pillar rows, and respectively electrically coupled to a plurality of bit lines (BL, BL1, BL2, BL_D, BL_U).

6. The memory cell array structure according to claim 5, wherein the third conductive structures form a stepped structure.

7. The memory cell array structure according to claim 5, wherein an extension direction of each of the first conductive structures is the same as an extension direction of each of the second conductive structures, and the extension direction of each of the first conductive structures is different from an extension direction of each of the third conductive structures.

8. The memory cell array structure according to claim 3, further comprising:
a common electrode plate (PLT, PLT1-PLT8), electrically coupled to the capacitors,
wherein the common electrode plate (PLT, PLT1-PLT8) receives a reference voltage.

9. The memory cell array structure according to claim 3, wherein the first conductive structures form a first stepped structure, and the second conductive structures form a second stepped structure.

10. The memory cell array structure according to claim 3, wherein each of the capacitors comprises:
a plurality of first conductive films (CC1-CC5, 1210, 1220, 1240), wherein one end portion of each of the first conductive films (CC1-CC5, 1210, 1220, 1240) is electrically coupled to a common electrode plate (PLT, PLT1-PLT8);
a plurality of second conductive films (CC1-CC5, 1210, 1220, 1240), wherein each of the second conductive films (CC1-CC5, 1210, 1220, 1240) is disposed between two adjacent ones of the first conductive films (CC1-CC5, 1210, 1220, 1240); and
a plurality of dielectric layers (CI1-CI4, 1230, ILD1, ILD2, ILD), formed between each of the first conductive films (CC1-CC5, 1210, 1220, 1240) and each of the adjacent second conductive films (CC1-CC5, 1210, 1220, 1240).

11. The memory cell array structure according to claim 3, wherein when a quantity of the at least one second conductive structure is 1, the second conductive structure is electrically coupled to the channel pillar rows and forms a common gate of the second transistors (M12-M42) in the channel pillar rows.

12. The memory cell array structure according to claim 3, wherein on a reference plane, arrangement positions of two adjacent ones of the first conductive structures are mutually staggered, and arrangement positions of two adjacent ones of the second conductive structures are mutually staggered.

13. The memory cell array structure according to claim 3, wherein in a vertical direction, a distance (T1, T2, T3) between adjacent two of the channel pillars is greater than twice of a sidewall thickness of each of the first conductive structures, and in a horizontal direction, a distance (T1, T2, T3) between adjacent two of the channel pillars is less than twice of a thickness of each of the first conductive structures.

14. A manufacturing method of an array of memory cell circuits (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801) as claimed in claim 1, comprising:
forming a plurality of channels on a wafer (1000, 2001, 3520), wherein the wafer (1000, 2001, 3520) has a plurality of channel layers and a plurality of sacrifice layers stacked alternately;
masking a gate region (GZ) of the wafer (1000, 2001, 3520), removing the sacrifice layers in a source region (SZ) and a drain region (DZ) of the wafer (1000, 2001, 3520), to respectively form a plurality of source structures and a plurality of drain structures;
masking the source region (SZ) and the drain region (DZ) of the wafer (1000, 2001, 3520), and dividing the gate region (GZ) into a first division and a second division;
respectively forming a plurality of first conductive structures (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) and at least one second conductive structure (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) in the first division and the second division, wherein each of the first conductive structures is a first common gate of a plurality of first transistors (M11-M41), and each of the second conductive structures is a second common gate of a plurality of second transistors (M12-M42); and
forming a plurality of capacitors, wherein the capacitors are respectively electrically coupled to the drain structures;
wherein the manufacturing method is **characterized in that**
forming the capacitors comprises:
forming a plurality of internal conductive films (CC1, CC5, 1240) on surfaces of the drain structures;
forming a plurality of dielectric layers (CI1-CI4, 1230, ILD1, ILD2, ILD) on surfaces of the internal conductive films (CC1, CC5, 1240); and
forming a plurality of external conductive films (CC2, CC3, CC4, 1210, 1220) on surfaces of the dielectric layers (CI1-CI4, 1230, ILD1, ILD2, ILD).

15. The manufacturing method according to claim 14, further comprising:
forming a plurality of third conductive structures (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), wherein the third conductive structures are respectively electrically coupled to the source structures, wherein each of the third conductive structures is electrically coupled to a source structure column or a source structure row.

16. The manufacturing method according to claim 15, wherein when each of the third conductive structures is electrically coupled to the source structure row, the manufacturing method further comprises:
forming a stepped structure with the third conductive structures.

17. The manufacturing method according to claim 16, further comprising:
respectively forming a plurality of conductive plugs (621, 631, CV1, 1414-1, 1414-2, 234C, 27211, 27311, 27221, 27321, 27411, 27421, 3421, 3431, 3441, 36111, 36211, 36121, 36221, 41421, 41422) on the third conductive structures, so that the third conductive structures are respectively electrically coupled to a plurality of bit lines (BL, BL1, BL2, BL_D, BL_U) through the conductive plugs.

18. The manufacturing method according to claim 16, wherein when each of the third conductive structures is electrically coupled to the source structure column, the manufacturing method further comprises:
forming a first stepped structure with the first conductive structures; and
forming a second stepped structure with the second conductive structures.

19. The manufacturing method according to claim 18, further comprising:
respectively forming a plurality of first conductive plugs (621, 631, CV1, 1414-1, 1414-2, 234C, 27211, 27311, 27221, 27321, 27411, 27421, 3421, 3431, 3441, 36111, 36211, 36121, 36221, 41421, 41422) on the first conductive structures, so that the first conductive structures are respectively electrically coupled to a plurality of primary word lines (WLm, WLm1, WLm2) through the first conductive plugs; and
respectively forming a plurality of second conductive plugs (621, 631, CV1, 1414-1, 1414-2, 234C, 27211, 27311, 27221, 27321, 27411, 27421, 3421, 3431, 3441, 36111, 36211, 36121, 36221, 41421, 41422) on the second conductive structures, so that the second conductive structures are respectively electrically coupled to a plurality of auxiliary word lines (WLa, WLa1, WLa2) through the second conductive plugs.

20. The manufacturing method according to claim 14, wherein after forming the internal conductive films (CC1, CC5, 1240) on the surfaces of the drain structures further comprises:
removing a portion of the drain structures between the internal conductive films (CC1, CC5, 1240).

21. The manufacturing method according to claim 14, wherein a thickness of the sacrifice layer is greater than twice of a sidewall thickness of the first conductive structures, and among a plurality of channel pillars (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200) respectively surrounded by the first conductive structures, a distance (T1, T2, T3) between two adjacent channel pillars on a horizontal line is less than twice of a thickness of the first conductive structures.

## Patentansprüche

1. Speicherzellenschaltung (100, MC1-MC4), umfassend:
einen ersten Transistor (M1), dessen erstes Ende elektrisch mit einer Bitleitung (BL) gekoppelt ist, wobei ein Gate des ersten Transistors (M1) elektrisch mit einer primären Wortleitung (WLm) gekoppelt ist;
einen zweiten Transistor (M2), dessen erstes Ende elektrisch mit einem zweiten Ende des ersten Transistors (M1) gekoppelt ist, wobei ein Gate des zweiten Transistors (M2) elektrisch mit einer Hilfswortleitung (WLa) gekoppelt ist;
einen Kondensator (CS, CS1-CS4, CSA, CSA1, CSA2, DC1), dessen eines Ende elektrisch mit einem zweiten Ende des zweiten Transistors (M2) gekoppelt ist, wobei ein anderes Ende des Kondensators so konfiguriert ist, es eine Referenzspannung empfängt, dass wobei das Gate des ersten Transistors (M1) so konfiguriert ist, dass es eine erste Vorspannung empfängt, und das Gate des zweiten Transistors (M2) so konfiguriert ist, dass es eine zweite Vorspannung empfängt, wobei die zweite Vorspannung größer ist als die erste Vorspannung;
eine Kanalsäule (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200);
eine erste leitfähige Struktur (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), die die Kanalsäule umgibt und das Gate des ersten Transistors (M1) bildet, wobei die erste leitfähige Struktur elektrisch mit der primären Wortleitung (WLm, WLm1, WLm2) gekoppelt ist; und
eine zweite leitfähige Struktur (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), die die Kanalsäule umgibt und das Gate des zweiten Transistors (M2) bildet, wobei die zweite leitfähige Struktur elektrisch mit der Hilfswortleitung (WLa, WLa1, WLa2) gekoppelt ist, wobei zwischen der ersten leitfähigen Struktur und der zweiten leitfähigen Struktur ein Abstand (SPC) besteht; wobei
der Kondensator elektrisch mit einem Ende der Kanalsäule gekoppelt ist, das an die zweite leitfähige Struktur angrenzt;
wobei die Speicherzellenschaltung (100, MC1-MC4) **dadurch gekennzeichnet ist, dass**
der Kondensator (CS, CS1-CS4, CSA, CSA1, CSA2, DC1) umfasst:
eine Vielzahl von externen leitfähigen Filmen (CC2, CC3, CC4, 1210, 1220), wobei ein Ende jedes der externen leitfähigen Filme (CC2, CC3, CC4, 1210, 1220) elektrisch mit einer gemeinsamen Elektrodenplatte (PLT, PLT1-PLT8) gekoppelt ist;
eine Vielzahl von internen leitfähigen Filmen (CC1, CC5, 1240), wobei jeder der internen leitfähigen Filme (CC1, CC5, 1240) zwischen zwei benachbarten der externen leitfähigen Filme (CC2, CC3, CC4, 1210, 1220) angeordnet ist; und
eine Vielzahl von dielektrischen Schichten (CI1-CI4, 1230, ILD1, ILD2, ILD), die zwischen jedem der externen leitfähigen Filme (CC2, CC3, CC4, 1210, 1220) und jedem benachbarten der internen leitfähigen Filme (CC1, CC5, 1240) gebildet sind.

2. Speicherzellenschaltung (100, MC1-MC4) gemäß Anspruch 1, ferner umfassend:
eine erste Gateoxidschicht (321), die zwischen der ersten leitfähigen Struktur und der Kanalsäule gebildet ist; und
eine zweite Gateoxidschicht (331), die zwischen der zweiten leitfähigen Struktur und der Kanalsäule gebildet ist.

3. Speicherzellenanordnungsstruktur (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801), umfassend:
eine Vielzahl von Speicherzellenschaltungen gemäß Anspruch 1, und die Speicherzellenanordnungsstruktur umfasst:
eine Vielzahl der Kanalsäulen (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200), die in einer Anordnung angeordnet sind, um eine Vielzahl von Kanalsäulenreihen und eine Vielzahl von Kanalsäulenspalten zu bilden;
eine Vielzahl der ersten leitfähigen Strukturen (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), die jeweils elektrisch mit den Kanalsäulenreihen oder den Kanalsäulenspalten gekoppelt sind, und wobei jede der ersten leitfähigen Strukturen einen ersten Abschnitt der Kanalsäulen in jeder der Kanalsäulenreihen oder jeder der Kanalsäulenspalten umgibt, wobei jede der ersten leitfähigen Strukturen ein gemeinsames Gate einer Vielzahl von ersten Transistoren (M11-M41) in jeder der Kanalsäulenreihen oder jeder der Kanalsäulenspalten bildet;
eine oder eine Vielzahl der zweiten leitfähigen Strukturen (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), die jeweils elektrisch mit den Kanalsäulenreihen oder den Kanalsäulenspalten gekoppelt sind, und wobei jede der zweiten leitfähigen Strukturen einen zweiten Abschnitt der Kanalsäulen in jeder der Kanalsäulenreihen oder jeder der Kanalsäulenspalten umgibt, wobei jede der zweiten leitfähigen Strukturen ein gemeinsames Gate einer Vielzahl von zweiten Transistoren bildet (M12-M42) in jeder der Kanalsäulenreihen oder jeder der Kanalsäulenspalten bildet, wobei zwischen dem ersten Abschnitt und dem zweiten Abschnitt ein Abstand (P1, P2) besteht; und
eine Vielzahl von Kondensatoren, die jeweils elektrisch mit Endabschnitten von Kanalsäulen gekoppelt sind, die an die zweiten leitfähigen Strukturen angrenzen.

4. Speicherzellenanordnungsstruktur gemäß Anspruch 3, wobei die ersten leitfähigen Strukturen jeweils elektrisch mit einer Vielzahl von primären Wortleitungen (WLm, WLm1, WLm2) gekoppelt sind und die zweiten leitfähigen Strukturen jeweils elektrisch mit einer Vielzahl von Hilfswortleitungen (WLa, WLa1, WLa2) gekoppelt sind.

5. Speicherzellenanordnungsstruktur gemäß Anspruch 3, ferner umfassend:
eine Vielzahl von dritten leitfähigen Strukturen (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), die jeweils elektrisch mit den Kanalsäulenspalten oder den Kanalsäulenreihen gekoppelt sind und jeweils elektrisch mit einer Vielzahl von Bitleitungen (BL, BL1, BL2, BL_D, BL_U) gekoppelt sind.

6. Speicherzellenanordnungsstruktur gemäß Anspruch 5, wobei die dritten leitfähigen Strukturen eine stufenförmige Struktur bilden.

7. Speicherzellenanordnungsstruktur gemäß Anspruch 5, wobei eine Erstreckungsrichtung jeder der ersten leitfähigen Strukturen mit einer Erstreckungsrichtung jeder der zweiten leitfähigen Strukturen übereinstimmt und die Erstreckungsrichtung jeder der ersten leitfähigen Strukturen sich von einer Erstreckungsrichtung jeder der dritten leitfähigen Strukturen unterscheidet.

8. Speicherzellenanordnungsstruktur gemäß Anspruch 3, ferner umfassend:
eine gemeinsame Elektrodenplatte (PLT, PLT1-PLT8), die elektrisch mit den Kondensatoren gekoppelt ist,
wobei die gemeinsame Elektrodenplatte (PLT, PLT1-PLT8) eine Referenzspannung empfängt.

9. Speicherzellenanordnungsstruktur gemäß Anspruch 3, wobei die ersten leitfähigen Strukturen eine erste stufenförmige Struktur bilden und die zweiten leitfähigen Strukturen eine zweite stufenförmige Struktur bilden.

10. Speicherzellenanordnungsstruktur gemäß Anspruch 3, wobei jeder der Kondensatoren umfasst:
eine Vielzahl von ersten leitfähigen Filmen (CC1-CC5, 1210, 1220, 1240), wobei ein Endabschnitt jedes der ersten leitfähigen Filme (CC1-CC5, 1210, 1220, 1240) elektrisch mit einer gemeinsamen Elektrodenplatte (PLT, PLT1-PLT8) gekoppelt ist;
eine Vielzahl von zweiten leitfähigen Filmen (CC1-CC5, 1210, 1220, 1240), wobei jeder der zweiten leitfähigen Filme (CC1-CC5, 1210, 1220, 1240) zwischen zwei benachbarten der ersten leitfähigen Filme (CC1-CC5, 1210, 1220, 1240) angeordnet ist; und
eine Vielzahl von dielektrischen Schichten (CI1-CI4, 1230, ILD1, ILD2, ILD), die zwischen jedem der ersten leitfähigen Filme (CC1-CC5, 1210, 1220, 1240) und jedem der benachbarten zweiten leitfähigen Filme (CC1-CC5, 1210, 1220, 1240) gebildet sind.

11. Speicherzellenanordnungsstruktur gemäß Anspruch 3, wobei, wenn eine Anzahl der mindestens einen zweiten leitfähigen Struktur 1 beträgt, die zweite leitfähige Struktur elektrisch mit den Kanalsäulenreihen gekoppelt ist und ein gemeinsames Gate der zweiten Transistoren (M12-M42) in den Kanalsäulenreihen gebildet wird.

12. Speicherzellenanordnungsstruktur gemäß Anspruch 3, wobei auf einer Referenzebene die Anordnungspositionen von zwei benachbarten der ersten leitfähigen Strukturen zueinander versetzt sind und die Anordnungspositionen von zwei benachbarten der zweiten leitfähigen Strukturen zueinander versetzt sind.

13. Speicherzellenanordnungsstruktur gemäß Anspruch 3, wobei in einer vertikalen Richtung ein Abstand (T1, T2, T3) zwischen zwei benachbarten der Kanalsäulen größer ist als das Doppelte einer Seitenwanddicke jeder der ersten leitfähigen Strukturen, und in horizontaler Richtung ein Abstand (T1, T2, T3) zwischen zwei benachbarten der Kanalsäulen kleiner ist als das Doppelte einer Dicke jeder der ersten leitfähigen Strukturen.

14. Herstellungsverfahren einer Anordnung von Speicherzellenschaltungen (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801) gemäß Anspruch 1, umfassend:
Bilden einer Vielzahl von Kanälen auf einem Wafer (1000, 2001, 3520), wobei der Wafer (1000, 2001, 3520) eine Vielzahl von Kanalschichten und eine Vielzahl von Opferschichten aufweist, die abwechselnd gestapelt sind;
Maskieren einer Gate-Region (GZ) des Wafers (1000, 2001, 3520), Entfernen der Opferschichten in einer Source-Region (SZ) und einer Drain-Region (DZ) des Wafers (1000, 2001, 3520), um jeweils eine Vielzahl von Source-Strukturen und eine Vielzahl von Drain-Strukturen zu bilden;
Maskieren der Source-Region (SZ) und der Drain-Region (DZ) des Wafers (1000, 2001, 3520) und Unterteilen der Gate-Region (GZ) in eine erste und eine zweite Unterteilung;
jeweils Bilden einer Vielzahl von ersten leitfähigen Strukturen (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) und mindestens einer zweiten leitfähigen Struktur (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) in der ersten und der zweiten Unterteilung, wobei jede der ersten leitfähigen Strukturen ein erstes gemeinsames Gate einer Vielzahl von ersten Transistoren (M11-M41) ist und jede der zweiten leitfähigen Strukturen ein zweites gemeinsames Gate einer Vielzahl von zweiten Transistoren (M12-M42) ist; und
Bilden einer Vielzahl von Kondensatoren, wobei die Kondensatoren jeweils elektrisch mit den Drain-Strukturen gekoppelt sind;
wobei das Herstellungsverfahren **dadurch gekennzeichnet ist, dass**
das Bilden der Kondensatoren umfasst:
Bilden einer Vielzahl von internen leitfähigen Filmen (CC1, CC5, 1240) auf Oberflächen der Drain-Strukturen;
Bilden einer Vielzahl von dielektrischen Schichten (CI1-CI4, 1230, ILD1, ILD2, ILD) auf Oberflächen der internen leitfähigen Filme (CC1, CC5, 1240); und
Bilden einer Vielzahl von externen leitfähigen Filmen (CC2, CC3, CC4, 1210, 1220) auf Oberflächen der dielektrischen Schichten (CI1-CI4, 1230, ILD1, ILD2, ILD).

15. Herstellungsverfahren gemäß Anspruch 14, ferner umfassend:
Bilden einer Vielzahl von dritten leitfähigen Strukturen (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), wobei die dritten leitfähigen Strukturen jeweils elektrisch mit den Source-Strukturen gekoppelt sind, wobei jede der dritten leitfähigen Strukturen elektrisch mit einer Source-Struktur-Spalte oder einer Source-Struktur-Zeile gekoppelt ist.

16. Herstellungsverfahren gemäß Anspruch 15, wobei, wenn jede der dritten leitfähigen Strukturen elektrisch mit der Source-Struktur-Reihe gekoppelt ist, das Herstellungsverfahren ferner umfasst:
Bilden einer stufenförmigen Struktur mit den dritten leitfähigen Strukturen.

17. Herstellungsverfahren gemäß Anspruch 16, ferner umfassend:
jeweils Bilden einer Vielzahl von leitfähigen Steckern (621, 631, CV1, 1414-1, 1414-2, 234C, 27211, 27311, 27221, 27321, 27411, 27421, 3421, 3431, 3441, 36111, 36211, 36121, 36221, 41421, 41422) auf den dritten leitfähigen Strukturen, so dass die dritten leitfähigen Strukturen jeweils über die leitfähigen Stecker elektrisch mit einer Vielzahl von Bitleitungen (BL, BL1, BL2, BL_D, BL_U) gekoppelt sind.

18. Herstellungsverfahren gemäß Anspruch 16, wobei, wenn jede der dritten leitfähigen Strukturen elektrisch mit der Source-Struktur-Säule gekoppelt ist, das Verfahren ferner umfasst:
Bilden einer ersten stufenförmigen Struktur mit den ersten leitfähigen Strukturen;
und
Bilden einer zweiten stufenförmigen Struktur mit den zweiten leitfähigen Strukturen.

19. Herstellungsverfahren gemäß Anspruch 18, ferner umfassend:
jeweils Bilden einer Vielzahl von ersten leitfähigen Steckern (621, 631, CV1, 1414-1, 1414-2, 234C, 27211, 27311, 27221, 27321, 27411, 27421, 3421, 3431, 3441, 36111, 36211, 36121, 36221, 41421, 41422) auf den ersten leitfähigen Strukturen, so dass die ersten leitfähigen Strukturen jeweils über die ersten leitfähigen Stecker elektrisch mit einer Vielzahl von primären Wortleitungen (WLm, WLm1, WLm2) gekoppelt sind; und
jeweils Bilden einer Vielzahl von zweiten leitfähigen Steckern (621, 631, CV1, 1414-1, 1414-2, 234C, 27211, 27311, 27221, 27321, 27411, 27421, 3421, 3431, 3441, 36111, 36211, 36121, 36221, 41421, 41422) auf den zweiten leitfähigen Strukturen, so dass die zweiten leitfähigen Strukturen jeweils über die zweiten leitfähigen Stecker elektrisch mit einer Vielzahl von Hilfswortleitungen (WLa, WLa1, WLa2) gekoppelt sind.

20. Herstellungsverfahren gemäß Anspruch 14, wobei es nach dem Bilden der internen leitfähigen Filme (CC1, CC5, 1240) auf den Oberflächen der Drain-Strukturen ferner umfasst:
Entfernen eines Abschnitts der Drain-Strukturen zwischen den internen leitfähigen Filmen (CC1, CC5, 1240).

21. Herstellungsverfahren gemäß Anspruch 14, wobei eine Dicke der Opferschicht größer ist als das Doppelte einer Seitenwanddicke der ersten leitfähigen Strukturen, und wobei unter einer Vielzahl von Kanalsäulen (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200), die jeweils von den ersten leitfähigen Strukturen umgeben sind, ein Abstand (T1, T2, T3) zwischen zwei benachbarten Kanalsäulen auf einer horizontalen Linie kleiner ist als das Doppelte der Dicke der ersten leitfähigen Strukturen.

## Revendications

1. Un circuit (100, MC1-MC4) de cellule de mémoire, comprenant :
un premier transistor (M1), ayant une première extrémité reliée électriquement à une ligne de bits (BL), la grille du premier transistor (M1) étant reliée électriquement à une ligne de mots principale (WLm) ;
un deuxième transistor (M2), ayant une première extrémité reliée électriquement à une deuxième extrémité du premier transistor (M1), la grille du deuxième transistor (M2) étant reliée électriquement à une ligne de mots auxiliaire (WLa) ;
un condensateur (CS, CS1-CS4, CSA, CSA1, CSA2, DC1) ayant une extrémité reliée électriquement à une deuxième extrémité du deuxième transistor (M2), une autre extrémité du condensateur étant configurée de manière à recevoir une tension de référence, la grille du premier transistor (M1) étant configurée de manière à recevoir une première tension de polarisation, et la grille du deuxième transistor (M2) étant configurée de manière à recevoir une deuxième tension de polarisation, la deuxième tension de polarisation étant supérieure à la première tension de polarisation ;
un pilier de canal (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200) ;
une première structure conductrice (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), entourant le pilier de canal et formant la grille du premier transistor (M1), la première structure conductrice étant reliée électriquement à la ligne de mots principale (WLm, WLm1, WLm2) ; et
une deuxième structure conductrice (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), entourant le pilier de canal et formant la grille du deuxième transistor (M2), la deuxième structure conductrice étant reliée électriquement à la ligne de mots auxiliaire (WLa, WLa1, WLa2), un espacement (SPC) existant entre la première structure conductrice et la deuxième structure conductrice ;
le condensateur est relié électriquement à une extrémité du pilier de canal adjacente à la deuxième structure conductrice ;
le circuit (100, MC1-MC4) de cellule de mémoire est **caractérisé en ce que**
le condensateur (CS, CS1-CS4, CSA, CSA1, CSA2, DC1) comprend :
une pluralité de films conducteurs externes (CC2, CC3, CC4, 1210, 1220), une extrémité de chacun des films conducteurs externes (CC2, CC3, CC4, 1210, 1220) étant reliée électriquement à une plaque électrode commune (PLT, PLT1-PLT8) ;
une pluralité de films conducteurs internes (CC1, CC5, 1240), chacun des films conducteurs internes (CC1, CC5, 1240) étant placé entre deux films conducteurs externes adjacents (CC2, CC3, CC4, 1210, 1220) desdits films conducteurs externes ; et
une pluralité de couches diélectriques (CI1-CI4, 1230, ILD1, ILD2, ILD3), formées entre chacun des films conducteurs externes (CC2, CC3, CC4, 1210, 1220) et chaque films conducteurs internes adjacents (CC1, CC5, 1240) desdits films conducteurs internes.

2. Le circuit (100, MC1-MC4) de cellule de mémoire selon la revendication 1, comprenant en outre :
une première couche d'oxyde de grille (321), formée entre la première structure conductrice et le pilier de canal ; et
une deuxième couche d'oxyde de grille (331), formée entre la deuxième structure conductrice et le pilier de canal.

3. Une structure de réseau de cellules de mémoire (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801), comprenant :
une pluralité de circuits de cellules de mémoire selon la revendication 1, et la structure de réseau de cellules de mémoire comprend :
une pluralité de piliers de canal (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200), agencés en une matrice afin de former une pluralité de rangées de piliers de canal et une pluralité de colonnes de piliers de canal ;
une pluralité de premières structures conductrices (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), reliées électriquement, de manière respective, aux rangées de piliers de canal ou aux colonnes de piliers de canal, et chacune des premières structures conductrices entourant une première partie des piliers de canal dans chacune des rangées de piliers de canal ou chacune des colonnes de piliers de canal, chacune des premières structures conductrices formant une grille commune d'une pluralité de premiers transistors (M11-M41) dans chacune des rangées de piliers de canal ou chacune des colonnes de piliers de canal ;
une ou plusieurs des deuxièmes structures conductrices (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), reliées électriquement, de manière respective, aux rangées de piliers de canal ou aux colonnes de piliers de canal, et chacune des deuxièmes structures conductrices entourant une deuxième partie des piliers de canal dans chacune des rangées de piliers de canal ou chacune des colonnes de piliers de canal, chacune des deuxièmes structures conductrices formant une grille commune d'une pluralité de deuxièmes transistors (M12-M42) dans chacune des rangées de piliers de canal ou chacune des colonnes de piliers de canal, une distance d'espacement (P1, P2) existant entre la première partie et la deuxième partie ; et
une pluralité de condensateurs, reliés électriquement, de manière respective, aux parties d'extrémité des piliers de canal adjacentes aux deuxièmes structures conductrices.

4. La structure de réseau de cellules de mémoire selon la revendication 3, dans laquelle les premières structures conductrices sont reliées électriquement, de manière respective, à une pluralité de lignes de mots principales (WLm, WLm1, WLm2), et les deuxièmes structures conductrices sont reliées électriquement, de manière respective, à une pluralité de lignes de mots auxiliaires (WLa, WLa1, WLa2).

5. La structure de réseau de cellules de mémoire selon la revendication 3, comprenant en outre :
une pluralité de troisièmes structures conductrices (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), reliée électriquement, de manière respective, aux colonnes de piliers de canal ou aux rangées de piliers de canal, et reliée électriquement, de manière respective, à une pluralité de lignes de bits (BL, BL1, BL2, BL_D, BL_U).

6. La structure de réseau de cellules de mémoire selon la revendication 5, dans laquelle les troisièmes structures conductrices forment une structure en gradins.

7. La structure de réseau de cellules de mémoire selon la revendication 5, dans laquelle une direction d'extension de chacune des premières structures conductrices est la même qu'une direction d'extension de chacune des deuxièmes structures conductrices, et la direction d'extension de chacune des premières structures conductrices est différente d'une direction d'extension de chacune des troisièmes structures conductrices.

8. La structure de réseau de cellules de mémoire selon la revendication 3, comprenant en outre :
une plaque électrode commune (PLT, PLT1-PLT8), reliée électriquement aux condensateurs,
la plaque électrode commune (PLT, PLT1-PLT8) recevant une tension de référence.

9. La structure de réseau de cellules de mémoire selon la revendication 3, dans laquelle les premières structures conductrices forment une première structure en gradins, et les deuxièmes structures conductrices forment une deuxième structure en gradins.

10. La structure de réseau de cellules de mémoire selon la revendication 3, dans laquelle chacun des condensateurs comprend :
une pluralité de premiers films conducteurs (CC1-CC5, 1210, 1220, 1240), une extrémité de chacun des premiers films conducteurs (CC1-CC5, 1210, 1220, 1240) étant reliée électriquement à une plaque électrode commune (PLT, PLT1-PLT8) ;
une pluralité de deuxièmes films conducteurs (CC1-CC5, 1210, 1220, 1240), chacun des deuxièmes films conducteurs (CC1-CC5, 1210, 1220, 1240) étant agencé entre deux films conducteurs adjacents (CC1-CC5, 1210, 1220, 1240) des premiers films conducteurs ; et
une pluralité de couches diélectriques (CI1-CI4, 1230, ILD1, ILD2, ILD), formées entre chacun des premiers films conducteurs (CC1-CCS5, 1210, 1220, 1240) et chacune des deuxièmes couches conductrices adjacentes (CC1-CC5, 1210, 1220, 1240).

11. La structure de réseau de cellules de mémoire selon la revendication 3, dans laquelle, lorsque la quantité de ladite au moins une deuxième structure conductrice est égale à 1, la deuxième structure conductrice est reliée électriquement aux rangées de piliers de canal et forme une grille commune des deuxièmes transistors (M12-M42) dans les rangées de piliers de canal.

12. La structure de réseau de cellules de mémoire selon la revendication 3, dans laquelle, sur un plan de référence, les positions d'agencement de deux structures conductrices adjacentes des premières structures conductrices sont mutuellement décalées, et les positions d'agencement de deux structures conductrices adjacentes des deuxièmes structures conductrices sont mutuellement décalées.

13. La structure de réseau de cellules de mémoire selon la revendication 3, dans laquelle, dans une direction verticale, une distance (T1, T2, T3) entre deux piliers de canal adjacents est supérieure au double de l'épaisseur de paroi latérale de chacune des premières structures conductrices, et dans une direction horizontale, une distance (T1, T2, T3) entre deux piliers de canal adjacents est inférieure au double de l'épaisseur de chacune des premières structures conductrices.

14. Un procédé de fabrication d'un réseau de circuits de cellules de mémoire (1410, 1420, 1510, 1520, 1610-1640, 1710-1740, 1810-1840, 1910-1940, 2000, 2211-2243, 2301, 2302, 2401, 2402, 2403, 2500, 2601, 2602, 2701, 2702, 2801, 2802, 2803, 2804, 2901-2904, 3001-3004, 3101-3108, 3201-3208, 3301-3302, 3400, 3510, 3601-3604, 3701-3704, 3801, 3802, 3801-1, 3801-2, 3802-1, 3802-2, 39011-390MN, 4001, 4002, 4101, 4102, 4201, 4202, 4301, 4302, 4401, 4402, 4500, 4600, 4701, 4702, 4801) selon la revendication 1, comprenant :
le fait de former une pluralité de canaux sur une plaquette de semi-conducteur, "*wafer*" en anglais, (1000, 2001, 3520), la plaquette (1000, 2001, 3520) présentant une pluralité de couches de canal et une pluralité de couches sacrificielles empilées de manière alternée ;
le fait de masquer une zone de grille (GZ) de la plaquette (1000, 2001, 3520), d'enlever les couches sacrificielles dans une zone de source (SZ) et une zone de drain (DZ) de la plaquette (1000, 2001, 3520), pour former respectivement une pluralité de structures de source et une pluralité de structures de drain ;
le fait de masquer la zone de source (SZ) et la zone de drain (DZ) de la plaquette (1000, 2001, 3520), et de diviser la zone de grille (GZ) en une première division et une deuxième division ;
le fait de former respectivement une pluralité de premières structures conductrices (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) et au moins une deuxième structure conductrice (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732) dans la première division et la deuxième division, chacune des premières structures conductrices étant une première grille commune d'une pluralité de premiers transistors (M11-M41), et chacune des deuxièmes structures conductrices étant une deuxième grille commune d'une pluralité de deuxièmes transistors (M12-M42) ; et
le fait de former une pluralité de condensateurs, les condensateurs étant reliés électriquement, de manière respective, aux structures de drain ;
le procédé de fabrication étant **caractérisé en ce que** la formation des condensateurs comprend :
le fait de former une pluralité de films conducteurs internes (CC1, CC5, 1240) sur des surfaces des structures de drain ;
le fait de former une pluralité de couches diélectriques (CI1-CI4, 1230, ILD1, ILD2, ILD) sur des surfaces des films conducteurs internes (CC1, CC5, 1240) ; et
le fait de former une pluralité de films conducteurs externes (CC2, CC3, CC4, 1210, 1220) sur des surfaces des couches diélectriques (CI1-CI4, 1230, ILD1, ILD2, ILD).

15. Le procédé de fabrication selon la revendication 14, comprenant en outre :
le fait de former une pluralité de troisièmes structures conductrices (320, 330, 520, 530, 540, 620, 630, 640, 720, 730, 740, 820, 830, 840, 1320, 1412, 1413, 1414, 1422, 1423, 1424, 1512, 1522, 1514, 1513, 1523, MS1, MS2, MS3, 420-1-440-3, 2114, 2124, 22C1-22C3, 2320-2324, 2331, 2332, 2340-2344, 2421, 2422, 2431, 2432, 2441, 2442, 2621, 2631, 2622, 2632, 2640, 2721, 2722, 2731, 2732, 3420, 3430, 3611, 3621, 3612, 3622, 4121, 4131, 4141, 4122, 4132, 4142, 4330, 4421, 4431, 4432, 4422, 4520, 4530, 4540, 4620, 4630, 4640, 4731, 4732), les troisièmes structures conductrices étant reliées électriquement, de manière respective, aux structures de source, chacune des troisièmes structures conductrices étant reliée électriquement à une colonne de structures de source ou à une rangée de structures de source.

16. Le procédé de fabrication selon la revendication 15, dans lequel, lorsque chacune des troisièmes structures conductrices est reliée électriquement à la rangée de structures de source, le procédé de fabrication comprend en outre :
le fait de former une structure en gradins avec les troisièmes structures conductrices.

17. Le procédé de fabrication selon la revendication 16, comprenant en outre :
le fait de former une pluralité de fiches conductrices respectives (621, 631, CV1, 1414-1, 1414-2, 234C, 27211, 27311, 27221, 27321, 27411, 27421, 3421, 3431, 3441, 36111, 36211, 36121, 36221, 41421, 41422) sur les troisièmes structures conductrices, de sorte que les troisièmes structures conductrices soient reliées électriquement, de manière respective, à une pluralité de lignes de bits (BL, BL1, BL2, BL_D, BL_U) par l'intermédiaire des fiches conductrices.

18. Le procédé de fabrication selon la revendication 16, dans lequel, lorsque chacune des troisièmes structures conductrices est reliée électriquement à la colonne de structures de source, le procédé de fabrication comprend en outre :
le fait de former une première structure en gradins avec les premières structures conductrices ; et
le fait de former une deuxième structure en gradins avec les deuxièmes structures conductrices.

19. Le procédé de fabrication selon la revendication 18, comprenant en outre :
le fait de former, de manière respective, une pluralité de premières fiches conductrices (621, 631, CV1, 1414-1, 1414-2, 234C, 27211, 27311, 27221, 27321, 27411, 27421, 3421, 3431, 3441, 36111, 36211, 36121, 36221, 41421, 41422) sur les premières structures conductrices, de sorte que les premières structures conductrices soient reliées électriquement, de manière respective, à une pluralité de lignes de mots principales (WLm, WLm1, WLm_2) par l'intermédiaire des premières fiches conductrices ; et
le fait de former respectivement une pluralité de deuxièmes fiches conductrices (621, 631, CV1, 1414-1, 1414-2, 234C, 27211, 27311, 27221, 27321, 27411, 27421, 3421, 3431, 3441, 36111, 36211, 36121, 36221, 41421, 41422) sur les deuxièmes structures conductrices, de sorte que les deuxièmes structures conductrices soient reliées électriquement, de manière respective, à une pluralité de lignes de mots auxiliaires (WLa, WLa1, WLa2) par l'intermédiaire des deuxièmes fiches conductrices.

20. Le procédé de fabrication selon la revendication 14, qui, après la formation des films conducteurs internes (CC1, CC5, 1240) sur les surfaces des structures de drain, comprend en outre :
le fait de retirer une partie des structures de drain entre les films conducteurs internes (CC1, CC5, 1240).

21. Le procédé de fabrication selon la revendication 14, dans lequel l'épaisseur de la couche sacrificielle est supérieure au double de l'épaisseur de paroi latérale des premières structures conductrices, et, parmi une pluralité de piliers de canal (310, 410, 510, 610, 710, 810, 2311, 2312, 2411, 2412, 2411-1, 2411-2, 2412-1, 2412-2, 2611, 2612, 4111, 4132-1, 4132-2, 4510, 4610, CHP, DNW, 1110, 1200) entourés, de manière respective, par les premières structures conductrices, une distance (T1, T2, T3) entre deux piliers de canal adjacents sur une ligne horizontale est inférieure au double de l'épaisseur des premières structures conductrices.
